(19) Europäisches Patentamt / European Patent Office / Office européen des brevets

(11) **EP 4 092 914 B1**

(12) **EUROPÄISCHE PATENTSCHRIFT**

(45) Veröffentlichungstag und Bekanntmachung des Hinweises auf die Patenterteilung:
**13.11.2024   Patentblatt 2024/46**

(21) Anmeldenummer: **22174213.3**

(22) Anmeldetag: **19.05.2022**

(51) Internationale Patentklassifikation (IPC):
**H04B 1/18** (2006.01)     **H04B 1/04** (2006.01)
**H01Q 1/52** (2006.01)     **H01P 5/18** (2006.01)
**H03H 7/38** (2006.01)

(52) Gemeinsame Patentklassifikation (CPC):
**H04B 1/0458; H01Q 1/521; H04B 1/18;**
H01P 5/185; H03H 7/383

(54) **STRAHLUNGSGEKOPPELTE ANTENNEN MIT NETZWERK**

RADIATION-COUPLED ANTENNAS WITH NETWORK

ANTENNES COUPLÉES AU RAYONNEMENT EN RÉSEAU

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **19.05.2021   DE 102021002631**
**17.02.2022   DE 102022000604**

(43) Veröffentlichungstag der Anmeldung:
**23.11.2022   Patentblatt 2022/47**

(73) Patentinhaber: **Fuba Automotive Electronics GmbH**
**31162 Bad Salzdetfurth (DE)**

(72) Erfinder:
• **LINDENMEIER, Stefan**
**82131 Gauting (DE)**
• **LINDENMEIER, Heinz**
**82152 Planegg (DE)**

(74) Vertreter: **Manitz Finsterwald**
**Patent- und Rechtsanwaltspartnerschaft mbB**
**Martin-Greif-Strasse 1**
**80336 München (DE)**

(56) Entgegenhaltungen:
**US-A1- 2009 219 213     US-A1- 2020 343 918**

• **OBORZHYTSKYY VALERIY ET AL: "A Simple Circuit for Decoupling of Two Dual-Frequency Antennas with Small Frequency Ratio", 2019 IEEE 15TH INTERNATIONAL CONFERENCE ON THE EXPERIENCE OF DESIGNING AND APPLICATION OF CAD SYSTEMS (CADSM), IEEE, 26 February 2019 (2019-02-26), pages 45 - 48, XP033584007, DOI: 10.1109/CADSM.2019.8779335**

**Beschreibung**

Die Erfindung betrifft ein Antennensystem 1 mit zwei gleichen gegenseitig strahlungsgekoppelten zueinander symmetrisch angeordneten Antennen 1a, 1b mit jeweils einem Antennen-Anschlusstor 2a, 2b und ein an die Antennen-Anschlusstore 2a, 2b eingangsseitig angeschlossenes und aus Blindelementen gebildetes Netzwerk 3 mit jeweils einem einer Antenne 1a, 1b gesondert zugeordnetem Antennenpfad 15a, 15b zu einem Netzwerk- Anschlusstor 4a, 4b.

Insbesondere für den Einsatz von Antennen auf Fahrzeugen sind der Flächenbedarf auf der Fahrzeugoberfläche, die Bauhöhe, ihre aerodynamische Form und ihr Windwiderstandswert von Bedeutung. Die besondere Bedeutung kommt jedoch aufgrund der im Fahrzeugbau üblichen großen Stückzahlen der Wirtschaftlichkeit der Herstellung einer derartigen Antenne zu.

Die Vielzahl moderner Mobilfunknetze, wie sie zum Beispiel nach dem Mobilfunkstandard LTE Long Term Evolution gestaltet oder noch in Entwicklung sind, erfordert häufig mehrere einander gleiche Antennen, welche aufgrund der fahrzeugtechnisch begründeten geringen Raumverfügbarkeit in kleinem Abstand voneinander angeordnet werden müssen. Für den LTE- Mobilfunk Standard sind zum Beispiel ein Frequenzbereich zwischen 698 und 960 MHz vorgesehen. Zur Gestaltung von einem Paar gleicher LTE- Gruppenantennen können diese - wie in der EP 3 734 755 A1 gezeigt - sehr vorteilhaft zum Beispiel mit einem Netzwerk auf einer Leiterplatte mechanisch und elektrisch verbunden sein und jeweils über auf dieser gesondert gestalteten Antennenpfaden mit den Anschlüssen von getrennten Sende-Empfangseinrichtungen verbunden sein.

Bei sehr dicht gedrängt und in einem Abstand von einem Bruchteil der elektrischen Wellenlänge $\lambda 0$ im freien Raum zum Beispiel vertikal und parallel zueinander angeordneten Antennen stellt sich hierbei aufgrund der elektromagnetischen Verkopplung der beiden Antennen das Problem der Störung in einer auf Empfang eingestellten Sende-Empfangseinrichtung durch das starke Sendesignal der anderen Sende-Empfangseinrichtung. Insbesondere wird bei digitaler Signalübertragung hierdurch die Bitfehlerrate beim Empfang empfindlich angehoben.

Selbstverständlich ist die Anwendung der in der vorliegenden Schrift vorgestellten Antennen und Antennenanordnungen in keiner Weise auf das hier beispielhaft genannte LTE-System beschränkt. Darüber hinaus sind diese Antennen und Netzwerkanordnungen besonders vorteilhaft in allen Kommunikationssystemen anzuwenden, in welchen Antennensysteme in den beschriebenen Frequenzbereichen zur Anwendung kommen, zum Beispiel in den Kommunikationssystemen wie 5G, WLAN und Fahrzeug-zu-Fahrzeug-Kommunikation (Car2Car) z.B. nach dem Standard IEEE802.11p etc. Für diese Anwendungen werden Antennen benötigt, welche sich neben der elektrischen Funktion aufgrund ihrer Kompaktheit und ihren stilistischen Eigenschaften für Fahrzeuge eignen, wobei der Wirtschaftlichkeit der Herstellung eine besondere Bedeutung zukommt. Ein Antennensystem nach dem Oberbegriff des Anspruchs 1 ist aus der US 2009/219213 A1 oder aus OBORZHYTSKYY VALERIY ET AL: "A Simple Circuit for Decoupling of Two Dual-Frequency Antennas with Small Frequency Ratio", 2019 IEEE 15TH INTERNATIONAL CONFERENCE ON THE EXPERIENCE OF DESIGNING AND APPLICATION OF CAD SYSTEMS (CADSM), IEEE, 26. Februar 2019 (2019-02-26), Seiten 45-48, XP033584007, DOI: 10.1109/CADSM.2019.8779335 bekannt. In der US 2020/343918 A1 ist ein Antennensystem für ein Mobiltelefon offenbart.

Aufgabe der Erfindung ist es, bei strahlungsgekoppelten Antennen mit Netzwerk nach dem Oberbegriff ein Netzwerk zu schaffen, durch welches die zwischen den Antennen bestehende elektromagnetische Strahlungsverkopplung als die zwischen den beiden Ausgängen des Netzwerks auftretende verbleibende Verkopplung wesentlich verringert ist und die Antennenanlage mit Netzwerk für Mobilfunkdienste in kompakter Bauweise in einem einfachen und wirtschaftlich wenig aufwändigen Herstellungsprozess gestaltet ist.

Die Lösung dieser Aufgabe erfolgt durch die Merkmale des Anspruchs 1. Vorteilhafte Ausführungsformen der Erfindung sind in den Unteransprüchen und der Beschreibung beschrieben.

Offenbart ist ein Antennensystem 1 mit zwei gleichen gegenseitig strahlungsgekoppelten zueinander symmetrisch angeordneten Antennen 1a, 1b mit jeweils einem Antennen-Anschlusstor 2a, 2b und ein an die Antennen-Anschlusstore 2a, 2b eingangsseitig angeschlossenes und aus Blindelementen gebildetes Netzwerk 3 mit jeweils einem, einander gleichem, einer Antenne 1a, 1b gesondert zugeordnetem Antennenpfad 15a, 15b zu einem Netzwerk-Anschlusstor 4a, 4b umfassend die folgenden Merkmale

- jedes Antennen-Anschlusstor 2a, 2b besteht jeweils aus einem gegen Masse spannungsführenden Anschlusspunkt 22a, 22b und einem Masse-Anschlusspunkt 6, welcher mit einer für alle Anschlusstore 2a, 2b, 4a, 4b gemeinsamen Masse 6 verbunden ist.

- jeder spannungsführende Anschlusspunkt 22a, 22b eines Antennen-Anschlusstors 2a, 2b ist jeweils mit dem spannungsführenden Anschlusspunkt 39a, 39b des entsprechenden Netzwerk-Anschlusstors 4a, 4b eines Antennenpfades 5a, 5b durch einen linearen elektrischen Leiter 8a, 8b verbunden.

- Zumindest längs der beiden linearen elektrischen Leiter 8a, 8b ist eine in einem Masse-Abstand 12 flächig gestaltete Massefläche 5 vorhanden.

- Die beiden linearen, einander gleichen elektrischen Leiter 8a, 8b sind zumindest über eine gemeinsame Länge l 10 sowohl in einem Leiterabstand 11 parallel zueinander als auch in einem Masse-Abstand 12 parallel zur Massefläche 9 geführt, sodass durch die beiden linearen elektrischen Leiter 8a, 8b jeweils sowohl eine auf die Masse 6 bezogene symmetrische elektrische Leitung 13 als auch zwischen den beiden linearen elektrischen Leitern 8a, 8b eine aufeinander bezogene antisymmetrische elektrische Leitung 14 und somit eine gekoppelte elektrische Leitung 15 gebildet ist

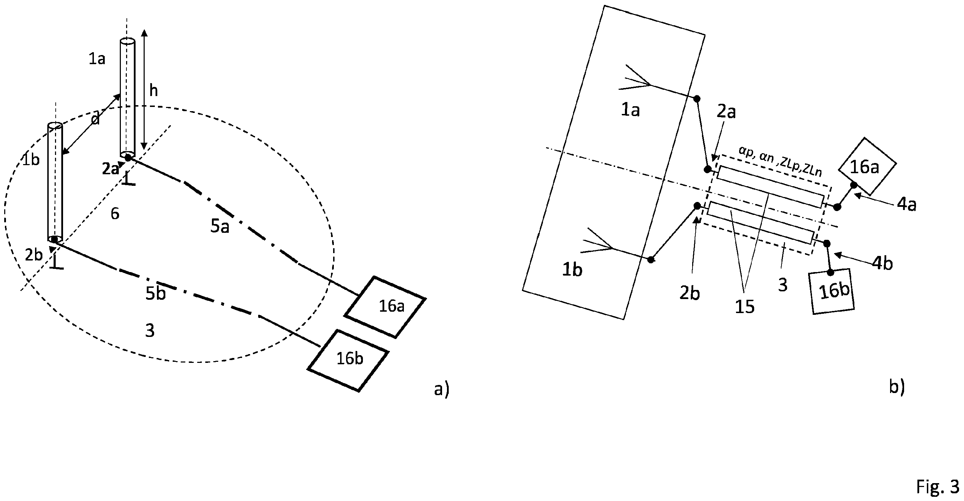

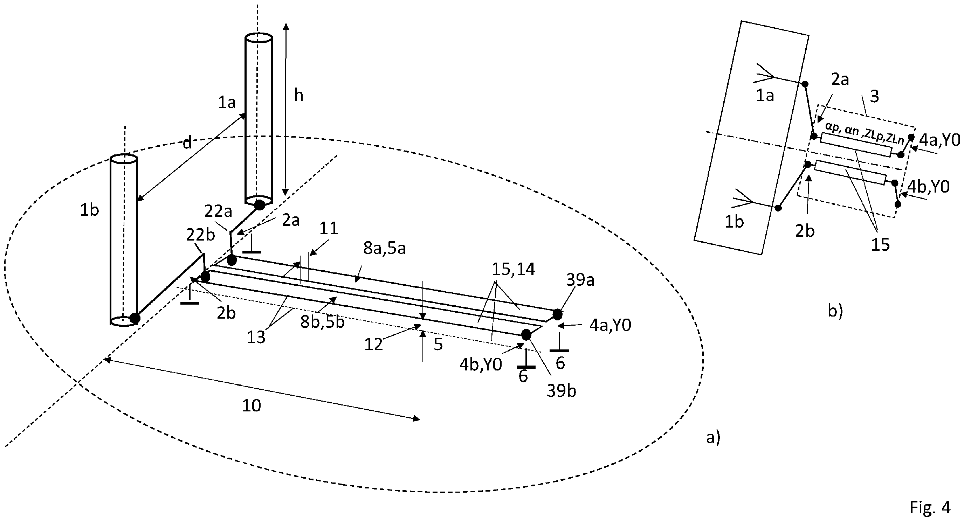

- Der bei gleichsinniger Erregung der gekoppelten elektrischen Leitung 15 vorliegende Wellenwiderstand ZLp und der elektrische Winkel $\alpha$p sowie der bei gegensinniger Erregung der gekoppelten elektrischen Leitung 15 vorliegende Wellenwiderstand ZLn und der elektrische Winkel $\alpha$n sind in der Weise gestaltet, dass bei mindestens einer Frequenz f1 die zwischen den Netzwerk-Anschlusstoren 4a, 4b bestehende Verkopplung S4a4b durch den Einsatz des Netzwerks 3 wesentlich kleiner ist als die zwischen den entsprechenden Antennen-Anschlusstoren 2a, 2b bestehende Verkopplung S2a2b (vgl. Fig.3b, Fig.4).

Von dem Antennensystem 1 kann zur Gestaltung des Zusammenwirkens mit der verkoppelten elektrischen Leitung die Admittanz YAp =GAp + jBAp an einem der Antennen-Anschlusstore 2a, 2b , welche sich bei dessen Erregung mit einem Messsignal und bei gleichzeitiger Erregung des anderen Antennen - Anschlusstors 2a, 2b mit dem gleichen gleichsinnig polarisierten Messsignal einstellt erfasst sein.

Ebenso kann die Admittanz YAn =GAn + jBAn an einem der Anschlusstore, die sich bei dessen Erregung mit einem Messsignal und bei gleichzeitiger Erregung des anderen Antennen - Anschlusstors 2a, 2b mit dem gleichen jedoch gegensinnig polarisierten Messsignal einstellt, erfasst sein.

Zur Gestaltung des Zusammenwirkens mit dem Antennensystem 1 können die elektrischen Eigenschaften der an ihrem einen Ende von den Antennen-Anschlusstoren 2a, 2b losgelösten verkoppelten elektrischen Leitung 15 der geometrischen Länge l 10 anhand folgender am anderen Ende der elektrischen Leitung 15 vorliegenden Blindleitwerte

zum einen bei Kurzschluss beider Leiter mit Masse 6 an dem einen Ende erfasst und eingestellt sein - und diese sind

- Blindleitwert Bkp an einem der Netzwerk-Anschlusstore 4a, 4b bei dessen Erregung mit einem Messsignal und bei gleichzeitiger Erregung des anderen Entkoppelnetzwerk- Anschlusstors 4a, 4b mit dem gleichen gleichsinnig polarisierten Messsignal

- Blindleitwert Bkn an einem der Netzwerk-Anschlusstore 4a, 4b bei dessen Erregung mit einem Messsignal und bei gleichzeitiger Erregung des anderen Entkoppelnetzwerk- Anschlusstors 4a, 4b mit dem gleichen jedoch gegensinnig polarisierten Messsignal

und zum anderen können die elektrischen Eigenschaften anhand folgender Blindleitwerte, welche bei Leerlauf beider Leiter an dem einen Ende der elektrischen Leitung 15 auftreten, erfasst und eingestellt sein- und diese sind

- Blindleitwert Blp an einem der Netzwerk-Anschlusstore 4a, 4b bei dem gleichen gleichsinnig polarisierten Messsignal

- Blindleitwert Bln an einem der Netzwerk-Anschlusstore 4a, 4b bei dessen Erregung mit einem Messsignal und bei gleichzeitiger Erregung des anderen Entkoppelnetzwerk- Anschlusstors 4a, 4b mit dem gleichen jedoch gegensinnig polarisierten Messsignal

daraus können die reelle Leitungswellenadmittanz YLp der symmetrischen elektrischen Leitung 13 und deren elektrischer Winkel $\alpha$p sowie die reelle Leitungswellenadmittanz YLn der antisymmetrischen elektrischen Leitung 14 und deren elektrischer Winkel $\alpha$p und $\alpha$n anhand folgender Beziehungen gesondert ermittelt und eingestellt sein.

$$YLp = \sqrt{-Bkp * Blp} \text{ und } YLn = \sqrt{-Bkn * Bln}$$

$$\alpha p = arc\, tan(\sqrt{-Blp/Bkp})\, ; \alpha n = arc\, tan(\sqrt{-Bln/Bkn})$$

$$(1)$$

An beiden Netzwerk-Anschlusstoren 4a, 4b kann bei der mindestens einen Frequenz f1 Impedanzanpassung an den in der Technik genormten reellen Widerstand Z0 = 1/Y0 und Entkopplung dadurch bestehen, dass die Struktur

und die Länge l10 der verkoppelten elektrischen Leitung 15 in der Weise gestaltet sind, dass sowohl die auf Y0 bezogene Leitungswellenadmittanz yLp = YLp/YO der symmetrischen elektrischen Leitung 13 und deren elektrischer Winkel αp als auch die entsprechende auf Y0 bezogene Leitungswellenadmittanz yLn = YLn/YO der antisymmetrischen elektrischen Leitung 14 und deren elektrischer Winkel αn gemäß den nachfolgenden Beziehungen gebildet sind, welche durch die auf Y0 bezogenen Admittanzen YAp/YO und YAn/YO des Antennensystem 1 an den Antennen-Anschlusstoren 2a, 2b vorgegeben sind, wobei gilt:

$$YAp/Y0 = yAp = gAp + j*bAp \quad und \quad YAn/Y0 = yAn = gAn + j*bAn$$

$$YLp/Y0 = yLp = \sqrt{\frac{|yAp|^2 - gAp}{gAp-1}}; \quad \alpha p = arc\,tan(\frac{1-gAp}{bAp} \bullet yLp)$$

$$(2)$$

$$YLn/Y0 = yLn = \sqrt{\frac{|yAn|^2 - gAn}{gAn-1}}; \quad \alpha n = arc\,tan(\frac{1-gAn}{bAn} \bullet yLn) ,$$

mit $j^2$ = -1

Zudem weist das Antennensystem 1 an den Antennen-Anschlusstoren 2a, 2b bei der mindestens einen Frequenz f1 reelle Admittanzen GAp und GAn auf, sodass YAp = GAp und YAn = GAn gegeben ist und die Entkopplung der beiden Entkoppelnetzwerk- Anschlusstore 4a, 4b und die Admittanzanpassung $S_{4a4a}$=0, $S_{4b4b}$ =0 der beiden Entkoppelnetzwerk- Anschlusstore 4a, 4b an den Bezugsleitwert Y0 dadurch hergestellt sind, dass sowohl der elektrische Winkel αp = $2\pi * l$ / λp der symmetrischen Leitung 13 als auch der elektrische Winkel αn = $2\pi * l$ / λn der antisymmetrischen Leitung 14 jeweils αp = αn = 90° betragen und der Leitungswellenleitwert der symmetrischen Leitung 13 $YLp = \sqrt{GAp * Y0}$ und der Leitungswellenleitwert der antisymmetrischen Leitung 14 $YLn = \sqrt{GAn * Y0}$ gewählt sind, wobei λp und λn die Wellenlängen der symmetrischen und der antisymmetrischen Wellen beschreiben und gleich groß eingestellt sind.

Es kann sein, dass bei der mindestens einen Frequenz f1 an jeweils einem der beiden Entkoppelnetzwerk-Anschlusstore 4a, 4b sowohl bei gleichsinniger als auch bei gegensinniger Erregung am jeweils anderen Entkoppelnetzwerk-Anschlusstor 4a, 4b die gleiche auf Y0 bezogene vorgegebene Admittanz $\frac{YNp}{Y0} = \frac{YNn}{Y0} = \frac{YN}{Y0} = yN = gN + j \bullet bN$ dadurch gegeben ist, dass für die symmetrischen Leitung 13 die auf Y0 bezogene Leitungswellenadmittanz $\frac{YLp}{Y0}$ entsprechend

$$YLp/Y0 = yLp = \sqrt{\frac{gN \bullet |yAp|^2 - gAp \bullet |yN|^2}{gAp - gN}}$$

und der elektrische Winkel in Grad entsprechend $\quad\quad\quad\quad (3)$

$$\alpha p = 180/\pi \bullet arc\,tan(\frac{gN - gAp}{gN \bullet bAp + bN \bullet gAp} \bullet yLp)$$

gewählt ist
und es kann sein, dass für die antisymmetrischen Leitung 14 die auf Y0 bezogene Leitungswellenadmittanz entsprechend

$$YLn/Y0 = yLn = \sqrt{\frac{gN \bullet |yAn|^2 - gAn \bullet |yN|^2}{gAn - gN}}$$

und der elektrische Winkel entsprechend $\hspace{4cm}$ (4)

$$an = 180/\pi \bullet arc\,tan(\frac{gN - gAn}{gN \bullet bAn + bN \bullet gAn} \bullet yLn)$$

gewählt sind, wodurch Entkopplung der beiden Netzwerk-Anschlusstore 4a, 4b am Ende der verkoppelten Leitung 15 erreicht ist.

Es kann sein, dass zur Erreichung der Impedanzanpassung an die genormte Admittanz Y0 an den Entkoppelnetzwerk-Anschlusstoren 4a, 4b für die mindestens eine Frequenz f1 zwischen jedem der beiden voneinander entkoppelten Enden der verkoppelten elektrischen Leitung - den Leitungs-Anschlusstoren 4a', 4b' - und dem entsprechenden Entkoppelnetzwerk-Anschlusstor 4a, 4b ein einander gleiches Ausgangs-Anpassnetzwerk 25a,25b zur Transformation der jeweils an den Leitungs- Anschlusstoren 4a', 4b' der verkoppelten elektrischen Leitung 15 vorliegenden Admittanz in die genormte Admittanz Y0 eingefügt ist.

Es kann sein, dass zwischen jedem der beiden Antennen-Anschlusstore 4a, 4b und dem Anschluss an den entsprechenden Leiter 8a, 8b der verkoppelten elektrischen Leitung 15 ein einander gleiches Antennen-Anpassnetzwerk 24a, 24b geschaltet ist, durch welches die an den Anschlusstoren 4a, 4b vorliegenden Antennen-Admittanzen YAp bzw. YAn bei der mindestens einen Frequenz f1 jeweils in eine reelle Admittanz GAp bzw. GAn transformiert ist und die verkoppelte elektrische Leitung 15 in der Weise gestaltet ist, dass die Leitungswellenadmittanz der symmetrischen

elektrischen Leitung 13 $\quad YLp = \sqrt{GAp \bullet Y0} \quad$ und ihr elektrischer Winkel $\quad ap = \frac{l}{\lambda p} * 360 = 90° \quad$ betragen und

die Leitungswellenadmittanz der antisymmetrischen elektrischen Leitung 14 $\quad YLn = \sqrt{GAn \bullet Y0} \quad$ und ihr elektrischer Winkel $\quad an = \frac{l}{\lambda n} * 360 = 90° \quad$ betragen.

Es kann sein, dass zur Erreichung der reellen Admittanzen GAp und GAn jedes Antennen-Anpassnetzwerk 24 aus einem parallel zum Antennen-Anschlusstor 2a, 2b geschalteten Parallelzweipol mit Blindleitwert Bp aus mindestens einem Blindelement und einem in Serie geschalteten Serienzweipol mit Blindwiderstand Xs aus mindestens einem Blindelement gebildet ist, wobei Bp/Y0 bzw. Xs/Z0 bei der mindestens einen Frequenz f1 zur Erfüllung der Forderung YAp = GAp bzw. YAn = GAn folgende Werte besitzen

$$bp = Bp/Y0 = \frac{|zAn|^2 - |zAp|^2}{2*(xAp*|zAn|^2 - xAn*|zAp|^2)} * \left[ 1 \pm \sqrt{1 - \frac{4\cdot(xAp*|zAn|^2 - xAn*|zAp|^2)*(xAn - xAp)}{(|zAp|^2 - |zAn|^2)^2}} \right]$$
$$(5)$$

wobei gilt:

$$zAp = rAp + j \bullet xAp = \frac{ZAp}{Z0} = \frac{Y0}{YAp} \quad und \quad zAn = rAn + j \bullet xAn = \frac{ZAn}{Z0} = \frac{Y0}{YAn}$$

Es kann sein, dass in jedem Antennen-Anpassnetzwerk 24a, 24b in der ersten der alternativen Kombinationen der Parallelzweipol mit Blindleitwert Bp als ein kapazitives Bauelement mit Kapazität Cp und der Serienzweipol mit Blindwiderstand Xs als ein induktives Bauelement mit Induktivität Ls ausgeführt sind und es kann sein, dass in der zweiten der alternativen Kombinationen der Parallelzweipol mit Blindleitwert Bp als ein induktives Bauelement mit Induktivität Lp und der Serienzweipol mit Blindwiderstand Xs als kapazitives Bauelement mit Kapazität Cs mit Induktivität Ls ausgeführt sind.

Es kann sein, dass zur Erweiterung des Frequenzbereichs um die mindestens eine Frequenz f1 als Mittenfrequenz in welchem sowohl eine Verbesserung der Entkopplung zwischen den Netzwerk-Anschlusstoren 4a, 4b als auch eine verbesserte Impedanzanpassung an den Normwiderstand Z0 erreicht ist, der Parallelzweipol als Parallelresonanzkreis und der Serienzweipol als Serienresonanzkreis ausgeführt sind.

Es kann sein, dass das Antennen-Anpassnetzwerk 24 in der Weise gestaltet ist, dass der frequenzabhängige Verlauf der in die reellen Admittanzen GAp bzw. GAn transformierten Antennenadmittanz ZAp = 1/YAp bzw. ZAn = 1/YAn in der komplexen Impedanzebene mit wachsender Frequenz jeweils den reellen Widerstandswert RAp =1/GAp bzw. RAn =1/GAn mit kleiner Abweichung zumindest teilweise umschlingt und der Widerstandswert RAp bzw. RAn durch die Transformation mit der gekoppelten elektrischen Leitung 15 in den Bezugswiderstand Z0 an den Entkoppelnetzwerk-Anschlusstoren 4a, 4b sowohl die Entkopplung als auch die Impedanzanpassung über einen größeren Frequenzbereich um die Frequenz f1 verbessert ist.

Es kann sein, dass zur Vergrößerung des Frequenzbereichs um die mindestens eine Frequenz f1 mit verbesserter Entkopplung zwischen den Entkoppelnetzwerk-Anschlusstoren 4a, 4b ausgehend von einer Realisierung der einander gleichen Antennen-Anschlussnetzwerke 24a, 24b nach einer oben angegebenen Dimensionierung des Parallelzweipols mit Blindleitwert Bp und des Serienzweipols mit Blindwiderstand Xs diese ergänzt sind zu jeweils einem parallel geschalteten Parallelresonanzkreis 7a und einem in Serie geschalteten Serienresonanzkreis 7b .

Es kann sein, dass zur Vergrößerung des Frequenzbereichs um die mindestens eine Frequenz f1 mit verbesserter Entkopplung und verbesserter Impedanzanpassung in einem Frequenzbereich um die Frequenz f1 an den Entkoppelnetzwerk-Anschlusstoren 4a, 4b das Ausgangs-Anpassnetzwerk 24a, 25b jeweils mindestens einen Parallelresonanzkreis 7a und einen Serienresonanzkreis 7b enthält, welche in der Weise gestaltet sind, dass sowohl die Impedanz ZNp als auch die Impedanz ZNn an den Entkoppelnetzwerk-Anschlusstoren 4a, 4b in ihrem Verlauf in der komplexen Impedanzebene mit wachsender Frequenz die genormte Impedanz Z0 in kleinem Abstand umschlingen.

Es kann sein, dass die elektrischen Eigenschaften der verkoppelten elektrischen Leitung 15 individuell durch strukturelle Gestaltung der über die Leiterlänge l 10 der einzelnen elektrischen Leiter 8a, 8b gegen Masse wirksame verteilte Kapazität Cm' = dCm/dl und der verteilten Kapazität Cb' = dCb/dl der einzelnen Leiter zueinander sowie die verteilten Induktivitäten Lp' = dLp/dl für gleichsinnigen Stromfluss in den beiden Leitern und die verteilten Induktivitäten Ln' = dLn/dl für gegensinnigen Stromfluss in den beiden Leitern in der Weise eingestellt sind, dass für die Frequenz f1 die geforderten Werte für den Leitungswellenleitwert

$$YLp = \frac{1}{ZLp} = \sqrt{Cm`/Lp`} \qquad (6)$$

und für den elektrischen Winkel pro Längeneinheit als Phasenkonstante

$$\frac{d\alpha p}{dl} = \beta p = 2\pi * f1 * \sqrt{Lp` * Cm`} \qquad (7)$$

der symmetrischen elektrischen Leitung 13 und die geforderten Werte für den Leitungswellenwiderstand

$$YLn = \frac{1}{ZLn} = \sqrt{(Cm` + 2 * Cb`)/Ln`} \qquad (8)$$

und für den elektrischen Winkel pro Längeneinheit für die Phasenkonstante

$$\frac{d\alpha n}{dl} = \beta n = 2\pi * f1 * \sqrt{(Cm` + 2 * Cb`) * Ln`} \qquad (9)$$

der antisymmetrischen elektrischen Leitung 14 erreicht sind.

Zur Gestaltung einer verkoppelten elektrischen Leitung 15 mit den erfindungsgemäß geforderten Werten für YLp, YLn und den geforderten elektrischen Winkeln $\alpha$p und $\alpha$n kann es vorteilhaft sein, zunächst die Struktur der Leitung zu ermitteln, welche für YLp, YLn die geforderten Werte Liefert und die von der Leitungslänge I 10 unabhängigen Werte für die Phasenkonstanten βp und βn in der Weise liefert, dass deren Verhältnis βp /βn = αp /αn erfüllt ist und die geometrische Leitungslänge I10 gemäß I = αp / βp = αn/βn gewählt ist.

Es kann sein, dass die verkoppelte elektrische Leitung 15 als Mikrostreifenleitung mit Leiterstreifen 17 auf einem permittiven Substrat 27 ausgeführt ist und die Leiterbreite 26 unter Berücksichtigung der Permittivitätszahl des Substrats 27 zur Erreichung der gewünschten Kapazitätsbelegung Cm' und der Induktivitätsbelegung Lp' zur Gestaltung der Leitungswellenadmittanz YLp und der Phasenkonstanten βp entsprechend gewählt sind und

es kann sein, dass der Leiterabstand 11 zur Gestaltung der Kapazitätsbelegung Cb' und - unter Wirkung der Belegung der Koppelinduktivität M' - die Induktivitätsbelegung Ln' in der Weise gewählt sind, dass die geforderte Leitwellenadmittanz YLn und die Phasenkonstante βn eingestellt sind.

Es kann sein, dass jede der einander gleichen Antennen 1a, 1b als eine mit einem ihrer Fußpunkt-Anschlüsse 2a',2b' mit Masse 6 verbundene Monopol-Antenne 1a, 1b gebildet ist, welche zur Überbrückung des Antennenabstands d mit dem zugehörigen Antennen-Anschlusstor 2a, 2b über ein jeweils gleiches kurzes elektrisches masse-unsymmetrisches Leitungsstück 35 verbunden ist.

Es kann sein, dass jede der einander gleichen Antennen 1a, 1b jeweils als eine symmetrisch zur Masse 6 gestaltete Dipol-Antenne 1a', 1b' gebildet ist, deren masse-symmetrisches Anschlusstor 2a', 2b' jeweils mit dem zugeordneten Antennen-Anschlusstor 2a, 2b über eine jeweils gleiche Umsymmetrierungsanordnung 34 mit kurzer masse-symmetrischer Eingangs- und masse-unsymmetrischer Ausgansleitung zur Überbrückung des Antennenabstands d und zur Umsymmetrierung des masse-symmetrischen Dipol- Anschlusstors 2a',2b' hin zum masse-unsymmetrischen Antennen-Anschlusstor 2a, 2b verbunden ist.

Die beiden linearen elektromagnetisch verkoppelten Leiter 8a und 8b des Entkoppelnetzwerks 3 mit ihren aufeinanderfolgenden infinitesimalen Leitungsstücken der Länge dl, bestehend aus den infinitesimalen Blindelementen dLp = dLn, dCm, dCb der symmetrischen verkoppelten Leitung 15 können ersetzt sein durch aufeinanderfolgende, entsprechend den Leitungsstücken jedoch aus diskreten Blindelementen bestehenden Schaltungsstufen S1, S2,.. endlicher Anzahl N. Anstelle der infinitesimalen Blindelemente dLp, dLn, dCm und dCb können diesen entsprechende diskrete Bauelemente mit der Serien-Induktivität ΔLp = ΔLs 36, der Brücken-Kapazität ΔCb 38 und der Masse-Kapazität ΔCm 37 eingesetzt und die Entkopplung der Entkoppelnetzwerk- Anschlusstore 4a, 4b bei einer hinreichend niedrigeren Frequenz f1 als der Grenzfrequenz ftp eingestellt sein.

Die Blindelement 36, 37, 38 können jeweils durch eine zweipolige Serien-Blindelementschaltung 43, 44, 45 in der Weise ersetzt sein, dass bei der Entkopplungsfrequenz f1 jeweils gilt:

Die Anstelle der Induktivität ΔLp, ΔLs 36 eingesetzte Serien-Blindelementschaltung 43,43' ist induktiv und besitzt den gleichen Blindwiderstandswert wie die Induktivität ΔLp, ΔLs 36.

Die Anstelle der Brücken-Kapazität ΔCb 38 eingesetzte Brücken-Blindelementschaltung 45,45' ist kapazitiv und besitzt den gleichen Blindwiderstandswert wie die Brücken-Kapazität ΔCb 38

Die Anstelle der Masse-Kapazität ΔCm 37 eingesetzte Masse-Blindelementschaltung 44, 44' ist kapazitiv und besitzt den gleichen Blindwiderstandswert wie die Masse-Kapazität ΔCm 37.

Im Entkoppelnetzwerk 3 können mindestens zwei Stufen S1, S2.. gebildet sein, durch deren erste Stufe S1 im Zusammenwirken von der induktiven Serien-Blindelementschaltung 43 mit der zweipoligen Brücken-Blindelementschaltung 45 die Entkopplung am Entkoppelnetzwerk- Anschlusstor 4a, 4b für die Frequenz f1 auch dadurch gegeben sein kann, dass in der Serien-Blindelementschaltung 43'der zweiten Stufe S2 ein für diese Frequenz f1 durchlässiger serieller Serienresonanzkreis 46 und in der Brücken-Blindelementschaltung 45' ein für diese Frequenz f1 sperrender serieller Parallel-Resonanzkreis vorhanden ist. Die Entkopplung am Entkoppelnetzwerk-Anschlusstor 4a, 4b kann bei einer weiteren Frequenz f2 durch erfindungsgemäße Abstimmung der Serien-Blindelementschaltung 43' und der Brücken-Blindelementschaltung 45' gegeben sein.

Das als Tiefpassstruktur gestaltete Entkoppelnetzwerk 3 kann jedoch dual hierzu als Hochpassstruktur realisiert sein, wofür die

Induktivität ΔLp = ΔLs 36 durch die Serienkapazität ΔCs 42,
die Brücken-Kapazität ΔCb 38 durch Brücken-Induktivität ΔLb 41

und die Masse-Kapazität ΔCm 37 durch die Masse-Induktivität ΔLm 40 ersetzt sind. Die Größen der Serienkapazität ΔCs 42, der Masse-Kapazität ΔCm 37 und der Masse-Induktivität ΔLm 40 können gemäß den unter Anwendung der Dualitätsbildungsregeln durch duale Transformation der Tiefpassstruktur-Elemente gewonnenen Hochpassstruktur-Elementen gewählt und die Entkopplung der Entkoppelnetzwerk- Anschlusstore 4a, 4b bei einer hinreichend höheren Frequenz f1 als der Grenzfrequenz fhp eingestellt sein.

Die Erfindung wird im Folgenden an Hand von Ausführungsbeispielen näher erläutert. Die zugehörigen Figuren zeigen im Einzelnen:

Fig. 1:

a) Beispiel eines Antennensystems 1 mit zwei gleichen im Abstand von d angeordneten gegenseitig strahlungsgekoppelten zueinander symmetrisch angeordneten Antennen 1a, 1b mit nach dem Stand der Technik mit jeweils einem Antennen-Anschlusstor 2a, 2b. Jede Antenne ist gesondert mit einer Sende-Empfangseinrichtung 16a, 16b verbunden.

b) Vierpol- bzw. Zweitor-Ersatzschaltung des Antennensystems 1 mit den komplexen Antennenimpedanzen $ZA = RA+j*XA$ und der komplexen Koppelimpedanz $Z12A = R12A+j*X12A$ zur Erfassung der Strahlungsverkopplung zwischen den Antennen-Anschlusstoren 2a, 2b.

c) Verlauf des Realteils R12A und des Imaginärteils X12A der Koppelimpedanz Z12A in Abhängigkeit des auf die Freiraumwellenlänge $\lambda 0$ bezogenen Antennenabstands $d/\lambda 0$ am Beispiel von zwei stabförmigen parallel zueinander orientierten Antennen nach a) mit der relativen Höhe $h/\lambda = 0,25$.

Fig. 2:

a) Verlauf des Realteils R12A und des Imaginärteils X12A der Koppelimpedanz Z12A am Beispiel des Antennensystems unter a) in Abhängigkeit von der Frequenz bei einem relativen Antennenabstand bei 750MHz von $d/\lambda = 0,2$

b) Streuparameter des Übertragungsfaktors S2a2b zwischen den Antennenanschlusstoren 2a und 2b und des Reflexionsfaktors S2a2a bzw. S2b2b am Antennenanschlusstor 2a bzw. 2b jeweils bei Abschluss des anderen Tores mit Z0.

Fig. 3:

a) Antennensystem 1 mit zwei gleichen strahlungsgekoppelten Antennen 1a, 1b nach dem Stand der Technik mit jemals einem einer Antenne gesondert zugeordneten Antennenpfad 15a, 15b zu einer Sende-Empfangseinrichtung 16a, 16b.

b) Prinzipbild eines Antennensystems 1 in der Draufsicht mit Entkoppelnetzwerk 3 mit verkoppelter Leitung 15 zur Entkopplung der Netzwerk-Anschlusstore 4a, 4b nach der Erfindung und die daran angeschlossenen Sende-Empfangseinrichtungen 16a, 16b.

Fig. 4:

a) Antennensystem 1 mit zwei gleichen strahlungsgekoppelten Antennen 1a, 1b mit zwei linearen elektrischen Leitern 8a, 8b gebildeter verkoppelter Leitung 15 als Entkoppelnetzwerk 3 nach der Erfindung mit den Entkoppelnetzwerk-Anschlusstoren 4a, 4b . Die beiden linearen elektrischen Leiter 8a, 8b sind über die gemeinsame Läng l 10 sowohl in einem Leiterabstand 11 parallel zueinander als auch in einem Masse-Abstand 12 parallel zur Massefläche 9 geführt. Durch die beiden linearen elektrischen Leiter 8a, 8b ist sowohl eine auf die Masse 6 bezogene symmetrische elektrische Leitung 13 als auch zwischen den beiden linearen elektrischen Leitern 8a, 8b eine aufeinander bezogene antisymmetrische elektrische Leitung 14 gebildet ist. Der Wellenwiderstand und die elektrischen Winkel $\alpha p$ bzw. $\alpha n$ sowohl der symmetrischen als auch der antisymmetrischen elektrischen Leitung 13, 14 in der verkoppelten elektrischen Leitung 15 sind in der Weise gestaltet, dass bei mindestens einer Frequenz f1 die zwischen den Entkoppelnetzwerk-Anschlusstoren 4a, 4b bestehende Verkopplung $S_{4a4b}$ durch den Einsatz des Netzwerks 3 wesentlich kleiner ist als die zwischen den entsprechenden Antennen-Anschlusstoren 2a, 2b bestehende Verkopplung $S_{2a2b}$.

b) Draufsicht des Antennensystem1 mit Entkoppelnetzwerk 3 wie in a)

Fig. 5:

a) bis b) Erläuterung zur Erfassung der Eigenschaften des Antennensystems 1 anhand von dessen symmetrischem Impedanz - Ersatzschaltbilds (ZA) in Bezug auf die Antennen-Anschlusstore 2a, 2b durch Feststellung folgender Impedanzen

a) Erfassung der Impedanz $ZAp=RAp + jXAp = 1/YAp$ z.B. am Antennen-Anschlusstore 2b, welche sich bei dessen Erregung mit einem Messsignal U und bei gleichzeitiger Erregung des anderen Entkoppelnetzwerk-Anschlusstors 2a mit dem gleichen gleichsinnig polarisierten Messsignal U einstellt

b) Erfassung der Impedanz $ZAn=RAn + jXAn=1/YAn$ am Antennen-Anschlusstor 2b, welche sich bei dessen Erregung mit einem Messsignal U und bei gleichzeitiger Erregung des anderen Entkoppelnetzwerk-Anschlusstors 2a mit dem gleichen jedoch gegensinnig polarisierten Messsignal -U einstellt

c) bis d) Erläuterung zur Erfassung der Eigenschaften des Antennensystems 1 anhand von dessen Admittanz-Ersatzschaltbilds (YA) in Bezug auf die Antennen-Anschlusstore 2a, 2b durch Feststellung folgender Admittanzen

c) Erfassung der Admittanz YAp=GAp + jBAp = 1/ZAp am Antennen-Anschlusstor 2b, welche sich bei dessen Erregung mit einem Messsignal U und bei gleichzeitiger Erregung des anderen Entkoppelnetzwerk-Anschlusstors 2a mit dem gleichen gleichsinnig polarisierten Messsignal U einstellt

d) Erfassung der Admittanz YAn=GAn + jBAn=1/ZAn am Antennen-Anschlusstor 2b, welche sich bei dessen Erregung mit einem Messsignal U und bei gleichzeitiger Erregung des anderen Entkoppelnetzwerk-Anschlusstors 2a mit dem gleichen jedoch gegensinnig polarisierten Messsignal -U einstellt.

Mit dem Zusammenhang YAp = 1/ZAp und YAn = 1/ZAn

In vollkommener Analogie hierzu werden die Eigenschaften des Antennensystems 1 mit Netzwerk 3 nach der Erfindung anhand von dessen symmetrischem Impedanz - Ersatzschaltbilds (ZN) in Bezug auf die zueinander symmetrischen Entkoppelnetzwerk-Anschlusstore 4a, 4b durch Feststellung der Impedanzen

$$ZNp=RNp + jXNp = 1/YNp \text{ und } ZNn=RNn + jXNn = 1/YNn$$

erfasst und anhand von dessen symmetrischem Admittanz-Ersatzschaltbilds (YN) durch Feststellung der Admittanzen

$$YNp=GNp + jBNp = 1/ZNp \text{ und } YNn=GNn + jBNn = 1/ZNn$$

erfasst.

Figuren e) und f).

Erfassung der elektrischen Eigenschaften - ausgedrückt durch die als verlustfrei vorausgesetzten reellen Wellenwidestände ZLp =1/YLp und ZLn = 1/YLn und der elektrischen Winkel $\alpha$p und $\alpha$n der symmetrischen und der antisymmetrischen elektrischen Leitungen 13, 14 der an ihrem einen Ende von den Antennen-Anschlusstoren 2a, 2b losgelösten verkoppelten elektrischen Leitung 15 anhand folgender am anderen Ende der elektrischen Leitung 15 vorliegenden Blindleitwerte.

Bei Kurzschluss beider Leiter mit Masse 6 an dem einen Ende ergeben sich am anderen Ende folgende Blindleitwerte.

- Blindleitwert Bkp an einem der Netzwerk-Anschlusstore 4a, 4b bei dessen Erregung mit einem Messsignal U und bei gleichzeitiger Erregung des anderen Entkoppelnetzwerk- Anschlusstors 4a, 4b mit dem gleichen gleichsinnig polarisierten Messsignal U
- Blindleitwert Bkn an einem der Netzwerk-Anschlusstore 4a, 4b bei dessen Erregung mit einem Messsignal und bei gleichzeitiger Erregung des anderen Entkoppelnetzwerk-Anschlusstors 4a, 4b mit dem gleichen jedoch gegensinnig polarisierten Messsignal -U

Bei Leerlauf beider Leiter mit Masse 6 an dem einen Ende ergeben sich am anderen Ende entsprechend folgende Blindleitwerte.

- Blindleitwert Blp an einem der Netzwerk-Anschlusstore 4a, 4b bei dessen Erregung mit einem Messsignal U und bei gleichzeitiger Erregung des anderen Entkoppelnetzwerk- Anschlusstors 4a, 4b mit dem gleichen gleichsinnig polarisierten Messsignal U
- Blindleitwert Bln an einem der Netzwerk-Anschlusstore 4a, 4b bei dessen Erregung mit einem Messsignal und bei gleichzeitiger Erregung des anderen Entkoppelnetzwerk- Anschlusstors 4a, 4b mit dem gleichen jedoch gegensinnig polarisierten Messsignal -U

Fig. 6:
Veranschaulichung der Bildung der Wellenwiderstände ZLp, ZLn sowie der elektrischen Winkel $\alpha$p und $\alpha$n der symmetrischen und der antisymmetrischen elektrischen Leitung 13 und 14 anhand der Darstellung der verkoppelten Leitung 15 durch finite Elemente zur individuellen Gestaltung der über die Leiterlänge I 10 verteilten Kapazitäten Cm' = DCm/dl der einzelnen elektrischen Leiter 8a, 8b gegen Masse und Cb' = dCb/dl der einzelnen Leiter 8a, 8b zueinander sowie die verteilte Induktivität Lp' = dLp/dl für in beiden Leitern gleichsinnig fließende Ströme und Ln' = dLn/dl für in beiden Leitern gegensinnig fließende Ströme, beeinflusst durch die verteilte magnetische Verkopplung M' = dM/dl, 21 der beiden Leiter.

Fig. 7:
Draufsicht auf ein Antennensystem 1 mit einer verkoppelten elektrischen Leitung 15 nach der Erfindung mit der Besonderheit, dass die an den zueinander symmetrisch angeordneten Antennen-Anschlusstoren 2a und 2b vorliegende symmetrische Admittanz YAp und die antisymmetrische Admittanz Yn bei der mindestens einen Frequenz f1 jeweils reell ist, sodass gilt:

$$Y1 = GAp \text{ und } Yn = GAn.$$

Die Entkopplung S4a4b und die Admittanzanpassung S4a4a=0, S4b4b =0 der beiden Ausgangs-Anschlusstore 4a, 4b an den Bezugsleitwert Y0 sind dadurch hergestellt, dass sowohl der elektrische Winkel

$\alpha$p = 2$\pi$ * II $\lambda p$ der symmetrischen Leitung 13 als auch der elektrische Winkel
$\alpha$n = 2$\pi$ * II $\lambda n$ der antisymmetrischen Leitung 14 jeweils $\alpha$p = $\alpha$n = 90°

betragen und der Leitungswellenleitwert der symmetrischen Leitung 13 $YLp = \sqrt{GAp * Y0}$ und der Leitungswellenleitwert der antisymmetrischen Leitung 14 $YLn = \sqrt{GAn * Y0}$ gewählt sind.

Fig. 8:

a) Frequenzabhängigkeit des Streuparameters S4a4b in dB um die Frequenz f1 =700MHz als Maß für die Entkopplung zwischen den Entkoppel-Netzwerk-Anschlusstoren 4a, 4b des Antennensystems 1 mit verkoppelter Leitung 15 nach **Figur 4.** Im Frequenzbereich um die Tiefenentkopplung bei f1 = 700MHz ergibt sich eine Verkopplung von - 15dB über eine Frequenzbandbreite von 30 MHz und von -20dB über eine Frequenzbandbreite von 16 MHz.
Als Vergleich hierzu zeigt der Streuparameter S2a2b die Strahlungsverkopplung der beiden Antennen an den Antennen-Anschlusstoren 2a, 2b bei einem Abstand voneinander von d/$\lambda$0 = 0,2 bei der Frequenz f1.

b) Frequenzabhängigkeit des Streuparameters S4a4b in dB um die Frequenz f1 =700MHz als Maß für den Reflexionsfaktor an jeweils einem Entkoppelnetzwerk-Anschlusstor 4a bzw. 4b bei Abschluss des anderen Entkoppelnetzwerk-Anschlusstors 4b bzw. 4a mit dem Normleitwert Y0. Als Vergleich hierzu zeigt der Streuparameter S2aS2b den Reflexionsfaktor an jeweils einem Antennen-Anschlusstor 2a bzw. 2b bei Abschluss des anderen Entkoppelnetzwerk-Anschlusstors 2b bzw. 2a mit dem Normleitwert Y0.

Fig. 9:

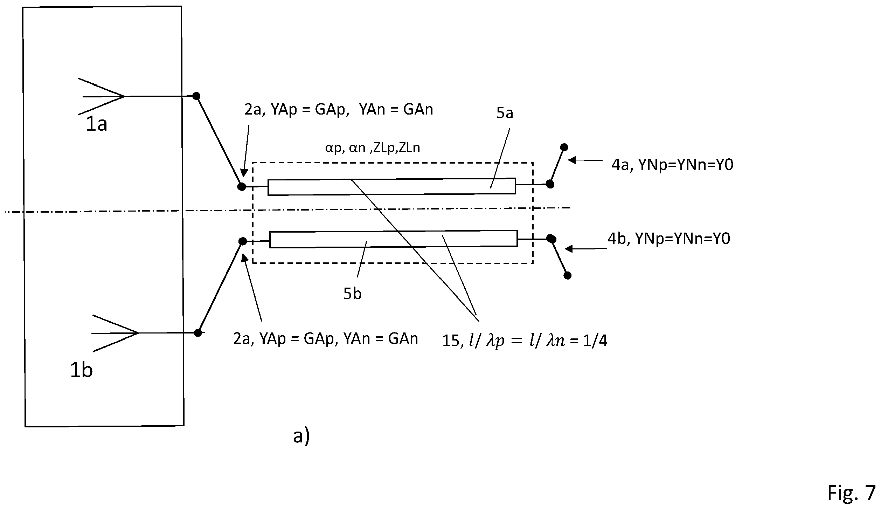

a) Draufsicht auf das Antennensystem 1 mit verkoppelter elektrischer Leitung 15, wie in Figur 7, jedoch mit dem Unterschied, dass die Admittanzen YAp und YAn an den Antennen-Anschlusstoren 2a, 2b bei der Frequenz f1 nicht reell sind und die verkoppelte elektrische Leitung 15 in der Weise ausgeführt ist, dass die Leitungswellenadmittanz YLp und der elektrische Winkel $\alpha$p der symmetrischen elektrischen Leitung 13 sowie die Leitungswellenadmittanz YLn und der elektrische Winkel $\alpha$n der antisymmetrischen elektrischen Leitung 14 nach den angegebenen Beziehungen für die Frequenz f1 jeweils derart gestaltet sind, dass an beiden Entkoppelnetzwerk-Anschlusstoren 4a', 4b' jeweils die symmetrische und die antisymmetrische Admittanz gleich sind, sodass gilt YNp = YNn und damit die beiden Entkopplungsnetzwerk-Anschlusstore 4a', 4b' voneinander entkoppelt sind.

b) Wie in Figur a) jedoch mit dem Unterschied, dass zur Erreichung der Impedanzanpassung an die genormte Admittanz Y0 an den Entkoppel-Netzwerk-Anschlusstoren 4a, 4b für die mindestens eine Frequenz f1 zwischen jedem der beiden voneinander entkoppelten Enden der verkoppelten elektrischen Leitung 15 - den Leitungs-Anschlusstoren 4a', 4b' - und dem entsprechenden Entkoppel-Netzwerk-Anschlusstor 4a, 4b ein einander gleiches Ausgangs-Anpassnetzwerk 25 zur Transformation der jeweils an beiden Enden der verkoppelten elektrischen Leitung 15 vorliegenden Admittanz in die genormte Admittanz Y0 eingefügt ist.

Fig.10:

a) Antennensystem 1 mit verkoppelter elektrischer Leitung 15 wie in Figur 4, jedoch mit dem Unterschied, dass zwischen jedem der beiden Antennen-Anschlusstore 2a, 2b und dem Anschluss an den entsprechenden Leiter 8a, 8b der verkoppelten elektrischen Leitung 15 ein einander gleiches Antennen-Anpassnetzwerk 24a, 24b geschaltet ist, durch welches die an den Antennen-Anschlusstoren 2a, 2b vorliegenden Antennen-Admittanzen YAp bzw. YAn bei der mindestens einen Frequenz f1 jeweils in eine reelle Admittanz GAp bzw. GAn transformiert ist und die verkoppelte elektrische Leitung 15 in der Weise gestaltet ist, dass die Leitungswellenadmittanz der symmetrischen elektrischen Leitung 13 $YLp = \sqrt{Gap \bullet Y0}$ und ihr elektrischer Winkel $\frac{l}{\lambda p} * 360 = 90°$ betragen und die Leitungswellenadmittanz der antisymmetrischen elektrischen Leitung 13 $YLn = \sqrt{Gan \bullet Y0}$ und ihr elektrischer Winkel $\frac{l}{\lambda n} * 360 = 90°$ betragen und die voneinander entkoppelten Entkoppelnetzwerk-Anschlusstore 4a, 4b an die Normadmittanz Y0 angepasst sind.

b) Schematische Draufsicht auf die Anordnung in Figur a.

Fig.11:

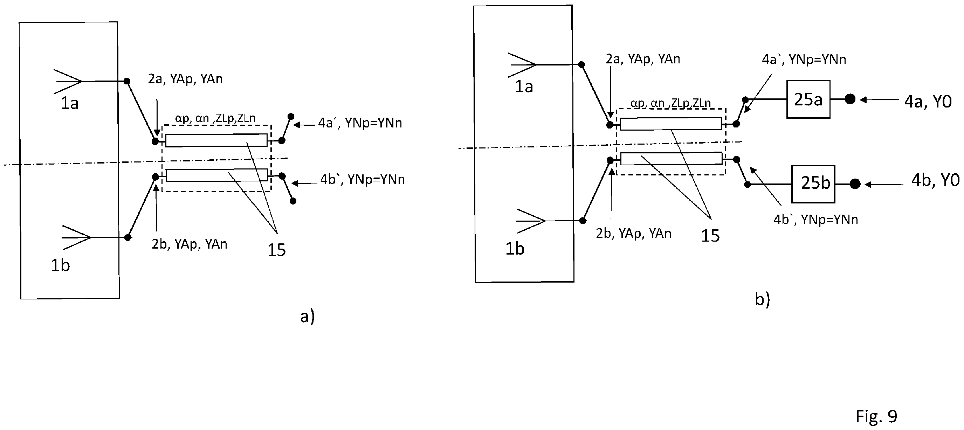

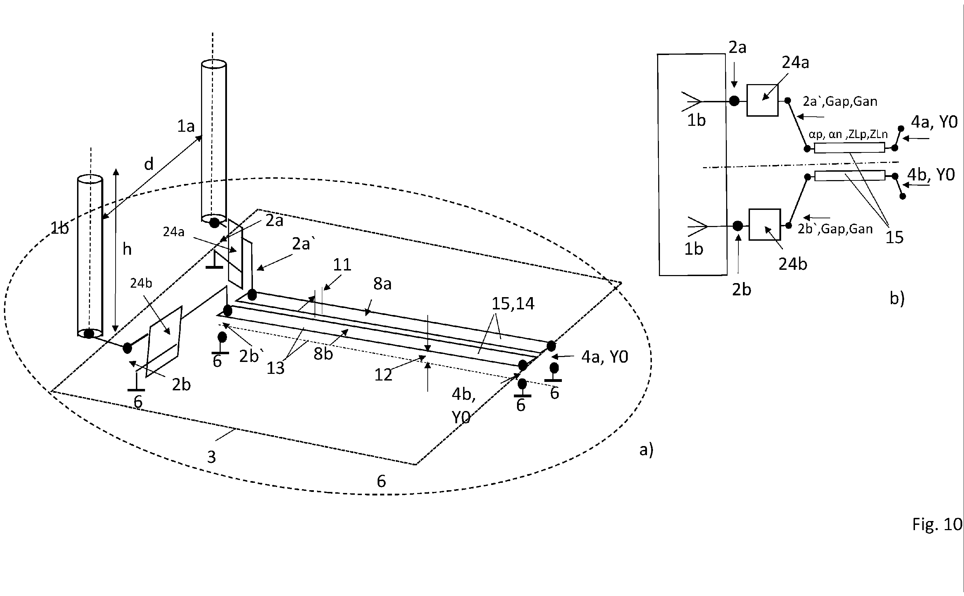

a) Schematische Draufsicht wie in Figur 10b, jedoch mit der Besonderheit, dass jedes Antennen-Anpassnetzwerk 24a, 24b aus einem parallel zum Antennen-Anschlusstor 2a, 2b geschalteten Parallelzweipol mit Blindleitwert Bp aus mindestens einem Blindelement und einem in Serie geschalteten Serienzweipol mit Blindwiderstand Xs aus mindestens einem Blindelement gebildet ist, deren Werte Bp und Xs nach den weiter unten angegebenen Funktionen von ZAn und ZAp gewählt sind, Zur Gestaltung einer verbesserten Admittanzanpassung über eine größere Frequenzbandbreite an den Normleitwert Y0 ist der verkoppelten Leitung 15 an den Leitungs- Anschlusstoren 4a', 4b', wie in Fig. 9b, jeweils ein Ausgangs-Anpassnetzwerk 25a, 25b nachgeschaltet, dessen Ausgang nun jeweils eines der Entkoppelnetzwerk-Anschlusstore 4a, 4b bildet.

Es zeigen:

a)
b) Wie in a), jedoch Bp realisiert als positiver Parallelblindleitwert 28 und Xs realisiert als positiver Serienblindwiderstand 29.
c) Wie in a), jedoch Bp realisiert als negativer Parallelblindleitwert 30 und Xs realisiert als negativer Serienblindwiderstand 31

Fig. 12:

Eine der in dem auf Z0 bezogenen kartesischen Reflexionsfaktor-Diagramm dargestellten Kurven zeigt den Verlauf der symmetrischen Antennenimpedanz ZAp an jeweils einem der Antennenanschlusstore 2a, 2b bei gleichsinniger Erregung des jeweils anderen der Antennenanschlustore 2a, 2b mit wachsender Frequenz und den Impedanzpukt Zp bei der Frequenz f1. In Entsprechung hierzu zeigt die andere Kurve den Verlauf der antisymmetrischen Antennenimpedanz ZAn an jeweils einem der Antennenanschlusstore 2a, 2b jedoch bei gegensinniger Erregung des jeweils anderen der Antennenanschlustore 2a, 2b mit wachsender Frequenz und den Impedanzpunkt Zn bei der Frequenz f1.
Ausgehend von den Impedanzpunkten Zp und Zn transformiert jedes Antennen-Anschlussnetzwerk 24a, 24b mit den in **Figur 11d** für eine der beiden Lösungsmöglichkeiten angegebenen Werten für Bp - realisiert durch Lp - und Xs - realisiert durch Cs - die symmetrische Impedanz Zp in den reellen Widerstand RAp und gleichermaßen die antisymmetrische Impedanz Zn in den reellen Widerstand RAn. Im Anschluss daran transformiert die entsprechend Figur 10 gestaltete verkoppelte elektrische Leitung 15 mit ihrer symmetrischen elektrischen Leitung 13 mit Leitungswellenadmittanz YLp und *ll* $\lambda p$ = ¼ den reellen Widerstand RAp in den Anpassungspunkt Z0 und entsprechend hierzu die antisymmetrische elektrische Leitung 14 mit Leitungswellenadmittanz YLn und *ll* $\lambda n$ = ¼ den reellen Widerstand RAn ebenso in den Anpassungspunkt Z0, wodurch bei der Frequenz f1 vollkommene Entkopplung zwischen den Entkoppelnetzwerk- Anschlusstoren 4a, 4b durch die verkoppelte elektrische Leitung 15 erreicht ist.

Fig. 13:

a) Frequenzabhängigkeit des Streuparameters S4a4b in dB um die Frequenz f1 =700MHz als Maß für die Entkopplung zwischen den Entkoppelnetzwerk-Anschlusstoren 4a, 4b des Antennensystems 1 mit verkoppelter Leitung 15 gemäß den Figuren 10 bis 12. Im Frequenzbereich um die Tiefenentkopplung bei f1 = 700MHz ergibt sich eine Verkopplung von < -15dB über eine Frequenzbandbreite von 28 MHz und von < -20dB über eine Frequenzbandbreite von 15 MHz. Als Vergleich hierzu zeigt der Streuparameter S2aS2b die Strahlungsverkopplung der beiden Antennen bei einem Abstand voneinander von d/$\lambda$0 = 0,2 bei der Frequenz f1.
b) Darstellung wie in Figur a), jedoch mit größerer Frequenzauflösung

Fig. 14:

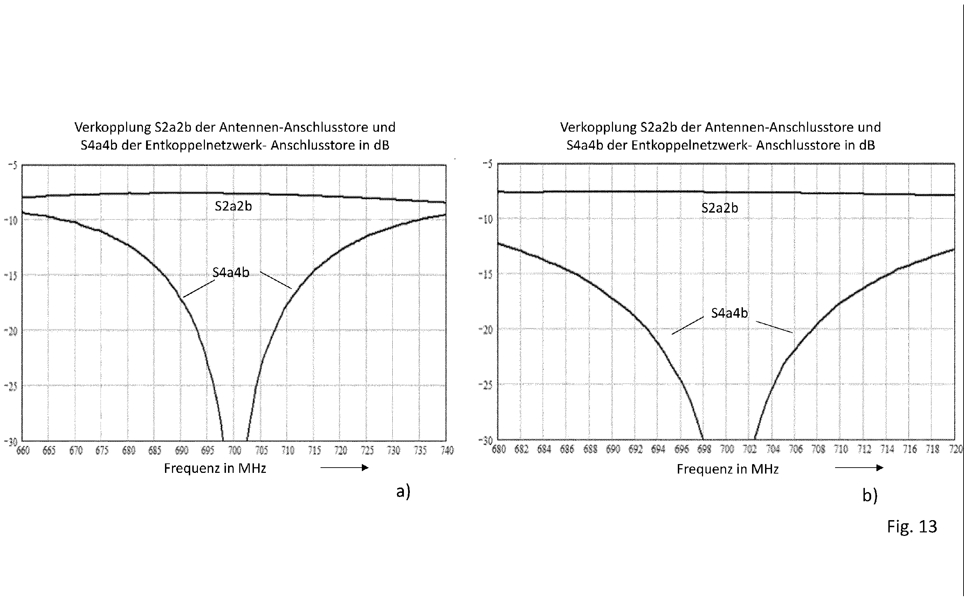

a) Korrespondierend mit Figur 13a:

Darstellung der Frequenzabhängigkeit des Streuparameters S4a4b in dB um die Frequenz f1 =700MHz als Maß für den Reflexionsfaktor an jeweils einem Entkoppelnetzwerk-Anschlusstor 4a bzw. 4b bei Abschluss des jeweils anderen Entkoppelnetzwerk-Anschlusstors 4b bzw. 4a mit dem Normleitwert Y0 = 1/Z0. Als Vergleich hierzu zeigt der Streuparameter S2aS2b den Reflexionsfaktor an jeweils einem Antennen-Anschlusstor 2a bzw. 2b bei Abschluss des jeweils anderen Entkoppelnetzwerk-Anschlusstors 2b bzw. 2a mit dem Normleitwert Y0 = 1/Z0.

b) Darstellung wie in Figur a), jedoch mit größerer Frequenzauflösung

Fig.15:

a) Zur Gestaltung einer verbesserten Admittanzanpassung an den Normleitwert Y0 mit den beiden Ausgangs-Anpassnetzwerken 25a, 25b in der Anordnung in Figur 9b an den Entkoppelnetzwerk-Anschlusstoren 4a, 4b über eine größere Frequenzbandbreite sind in den Ausgangs-Anpassnetzwerken 25a, 25b jeweils ein parallel geschalteter Parallelresonanzkreis 7a und ein seriell geschalteter Serienresonanzkreis 7b eingesetzt.

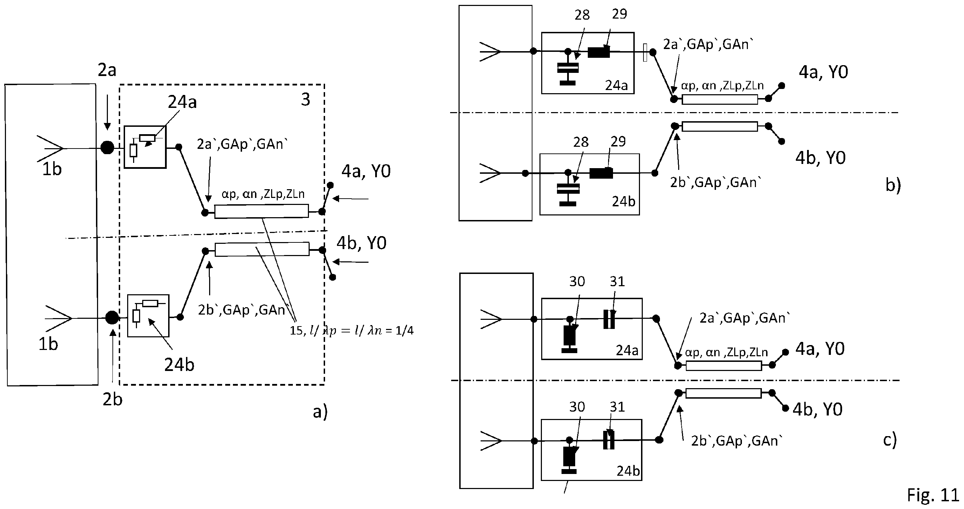

b) Zur Vergrößerung des Frequenzbereichs mit verbesserter Entkopplung zwischen den Entkoppelnetzwerk-Anschlusstoren 4a, 4b um die mindestens eine Frequenz f1 ausgehend von einer Realisierung der einander gleichen Antennen-Anschlussnetzwerke 24a, 24b nach einer Dimensionierung der beiden Zweipole aus Blindelementen wie in Figur 11a sind diese ergänzt zu jeweils einem parallel geschalteten Parallelresonanzkreis 7a und zu einem in Serie geschalteten Serienresonanzkreis 7b.

Fig. 16:

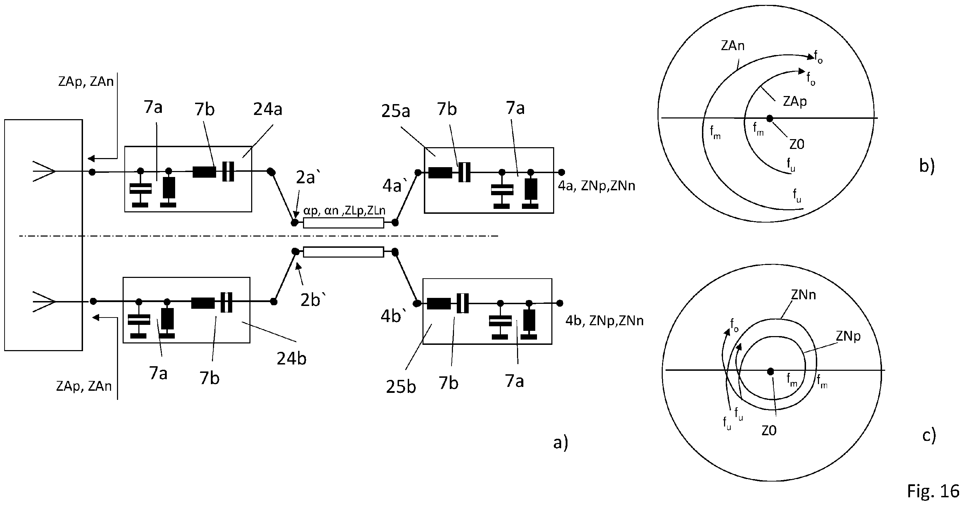

a) Zur Vergrößerung des Frequenzbereichs um einem Frequenzbereich um die Frequenz f1 mit verbesserter Entkopplung und verbesserter Impedanzanpassung an den Entkoppelnetzwerk-Anschlusstoren 4a, 4b sind in dem Ausgangs-Anpassnetzwerk 25a, 25b in Figur 16a jeweils mindestens ein Parallelresonanzkreis 7a und einen Serienresonanzkreis 7b vorhanden, welche in der Weise gestaltet sind, dass sowohl die Impedanz ZNp als auch die Impedanz ZNn an den Entkoppelnetzwerk-Anschlusstoren 4a, 4b in ihrem Verlauf in der komplexen Impedanzebene mit wachsender Frequenz die genormte Impedanz Z0 in einem kleinen Abstand umschlingen.

b) Typischer Verlauf der symmetrischen Antennenimpedanz ZAp sowie der antisymmetrischen Antennenimpedanz ZAn in der komplexen Reflexionsfaktorebene mit wachsender Frequenz f bezogen auf die normierte Impedanz Z0 für Impedanzanpassung. Beide Verläufe umschlingen den Anpassungspunkt Z0 teilweise. Der Abstand zwischen den Verläufen resultiert aus der Strahlungskopplung der beiden Antennen 1a,1b.

c) In Kombination mit dem Antennen-Anpassnetzwerk 24a, 24a und der erfindungsgemäß gestalteten verkoppelten elektrischen Leitung 15 ist das Antennen-Anpassnetzwerk 25a, 25a in der Weise gestaltet, dass die Impedanzverläufe für ZAp und ZAn in Figur b) in der Weise transformiert sind, dass diese in geringem Abstand voneinander mit wachsender Frequenz f den Impedanzpunkt Z0 für Impedanzanpassung mit geringer Abweichung von diesem gemeinsam umschlingen, wodurch erfindungsgemäß eine breite ausreichende Entkopplung der beiden Entkoppelnnetzwerk-Anschlusstore 4a, 4b voneinander erreicht wird.

Fig. 17:

Beispielhafte Frequenzabhängigkeit der Streuparameter um die Frequenz f1 =700 MHz als Maß für die breitbandige Entkopplung zwischen den Netzwerk-Anschlusstoren 4a, 4b des Antennensystems 1 mit verkoppelter Leitung 15. Im Frequenzbereich um f1 = 700MHz ergibt sich unter Verzicht auf eine Tiefenentkopplung eine verbesserte Entkopplung über einen größeren Frequenzbereich.

a) Zur Gestaltung einer verbesserten Admittanzanpassung über eine größere Frequenzbandbreite an den Normleitwert Y0 ist im Beispiel der verkoppelten Leitung 15 an den Leitungs- Anschlusstoren 4a', 4b', wie in Fig. 9b, jeweils ein Ausgangs-Anpassnetzwerk 25a, 25b nachgeschaltet, dessen Ausgang nun jeweils eines der Entkoppelnetzwerk-Anschlusstore 4a, 4b bildet.

b) Zur Transformation der Antennen-Admittanzen ist im Beispiel - wie in Fig. 10 - zwischen jedem der beiden Antennen-Anschlusstore 2a, 2b und dem entsprechenden Anschluss an die verkoppelte elektrische Leitung 15 ein einander gleiches Antennen-Anpassnetzwerk 24a, 24b, geschaltet, durch welches die jeweils an einem Antennen-Anschlusstor 2a, 2b vorliegende Antennen-Admittanz in eine einander gleiche reelle Admittanz GAp bzw. GAn transformiert ist

In a) und in b) sind jeweils die Verkopplungs- bzw. Reflexionsfaktoren als auf Z0 = 1/Y0 = 50 Ohm bezogene Streuparameter in dB dargestellt.

Es zeigen jeweils:

Kurve 1: Frequenzverlauf der Verkopplung der Antennen-Anschlusstore 2a, 2b anhand des Verlaufs des Streuparameters S2a2b in dB.

Kurve 2: Frequenzverlauf der Verkopplung der Netzwerk- Anschlusstore 4a, 4b anhand des Verlaufs des Streuparameters S4a4b in dB.

Kurve 3: Frequenzverlauf des Reflexionsfaktors S2a2a = S2b2b in dB jeweils an einem der Antennen-Anschlusstore 2a, 2b.

Kurve 4: Frequenzverlauf des Reflexionsfaktors S4a4a = S4b4b in dB jeweils an einem der Netzwerk-Anschlusstore 4a, 4b.

Fig. 18:

a) Realisierung der verkoppelten elektrische Leitung 15 als Mikrostreifenleitung mit Leiterstreifen 17 auf einem permittiven Substrat 27. Die Leiterbreite 26 ist unter Berücksichtigung der Permittivitätszahl des Substrats 27 zur Erreichung der gewünschten Kapazitätsbelegung Cm' und der Induktivitätsbelegung Lp' zur Gestaltung der Leitungswellenadmittanz YLp entsprechend gewählt. Ebenso sind der Leiterabstand 11 zur Gestaltung der Kapazitätsbelegung Cb' und der Belegung der Koppelinduktivität M', welche in der Induktivitätsbelegung Ln' enthalten ist, in der Weise gewählt, dass die geforderte Leitungswellenadmittanz YLp und die Phasenkonstante βp sowie die YLp und die Phasenkonstante βn eingestellt sind. Die Einstellung der Kenngrößen kann bevorzugt und effektiv durch ein Simulationsmodell der gekoppelten Leitung 15 erfolgen. Diese wird dazu im Querschnitt, wie in Figur b) entlang von deren Symmetrieebene in zwei Hälften geteilt, welche jeweils nur noch einen Leiter 8a, 8b beinhalten. Dies geschieht im symmetrischen Fall symmetrische Erregung (positiv) durch Abschluss der Symmetrieebene mit einer magnetischen Wand und im antisymmetrischen Fall (negativ) durch Abschluss der Symmetrieebene mit einer elektrischen Wand.

b) Simulationsmodell für den Querschnitt einer symmetrischen Mikrostreifenleitung 13 nach Figur a) zur Ermittlung des Wellenwiderstands ZLp

c) Simulationsmodell für den Querschnitt einer antisymmetrischen Mikrostreifenleitung 14 nach Figur a) zur Ermittlung des Wellenwiderstands ZLn

d) verkoppelte elektrische Leitung 15, realisiert als Zweidrahtleitung mit runden Leitern, mit Leiterdurchmesser 23 und Leiterabstand 11 über einer Massefläche im Masseabstand 19

e) Beispiel wie in Figur d) jedoch symmetrische Doppelleitung mit rundrohrförmiger Abschirmung

Fig. 19:

a) Antennensystem 1 nach der Erfindung mit Monopol-Antennen 1a, 1b mit jeweils einem gleichen kurzen elektrischen masse-unsymmetrischen Leitungsstück 35 zur Überbrückung des Antennenabstands d.
b) Antennensystem 1 nach der Erfindung mit Dipol-Antennen 1a', 1b' mit einer jeweils gleichen Umsymmetrierungsanordnung 34 mit kurzer masse-symmetrischer Eingangs- und masse-unsymmetrischer Ausgansleitung zur Überbrückung des Antennenabstands d und zur Umsymmetrierung des masse-symmetrischen Dipol- Anschlusstors 2a',2b' hin zum masse-unsymmetrischen Antennen-Anschlusstor 2a, 2b.

Fig. 20:

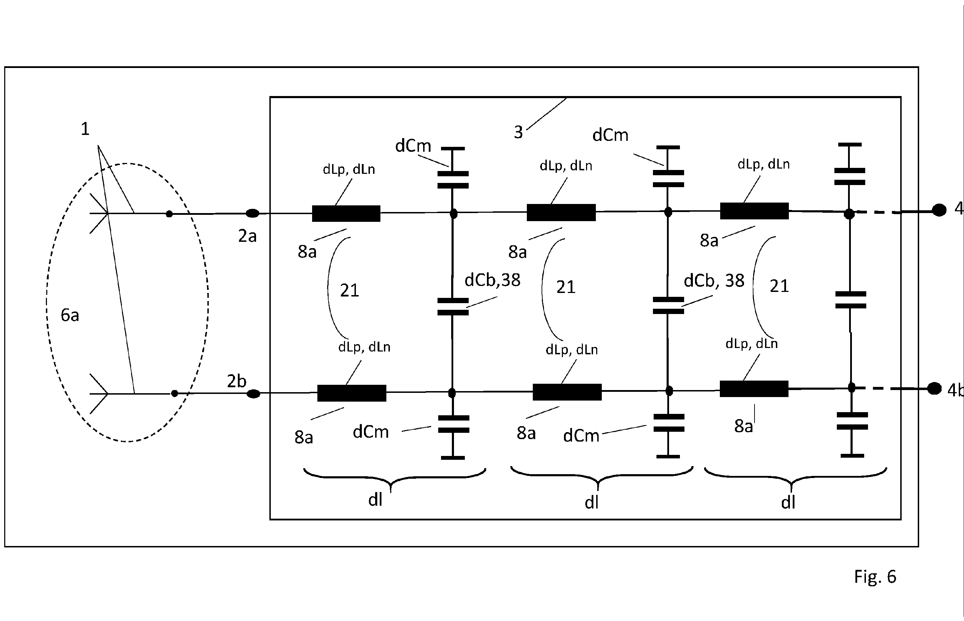

Zeigt das zu Figur 6 analoge Ersatzschaltbild für die beiden linearen elektromagnetisch verkoppelten Leiter 8a und 8b des Entkoppelnetzwerks 3 nach der Erfindung, jedoch mit konzentrierten elektrischen Bauelementen. Hierzu sind die aufeinanderfolgenden infinitesimalen Leitungsstücke der Länge dl, bestehend aus den infinitesimalen Blindelementen dLp = dLn, dCm, dCb der symmetrischen verkoppelten Leitung 15, durch aufeinanderfolgende, aus diskreten Blindelementen bestehende Schaltungsstufen S1, S2,.. hinreichender Anzahl N ersetzt. Anstelle der infinitesimalen Blindelemente dLp, dLn, dCm und dCb sind diesen entsprechende diskrete Bauelemente mit der Serien-Induktivität $\Delta Lp = \Delta Ls$ 36, der Brücken-Kapazität $\Delta Cb$ 38 und der Masse-Kapazität $\Delta Cm$ 37 eingesetzt. Die Anzahl der Schaltungsstufen S1, S2,.. und die Werte der diskreten Bauelement sind in der Weise gewählt, dass die Entkopplung der Entkoppelnetzwerk- Anschlusstore 4a, 4b bei einer hinreichend niedrigeren Frequenz f1 als der Grenzfrequenz ftn eingestellt ist. Für Anpassung an den genormten Wellenleitwert Y0 = 1/Z0 des Entkoppelnetzwerks 3 an den Entkoppelnetzwerk-Anschlusstoren 4a, 4b sind die bezogenen Wellen- Leitwerte YLp/YO und YLn/YO sowie die elektrischen Winkel $\alpha p$ und $\alpha n$ der nachgebildeten elektrischen Leitung aus den komplexen Antennenadmittanzen YAp/YO und YAn/YO gemäß Gleichung (2) gefordert. In vollkommener Analogie zur elektrischen Leitung mit verteilten Blindelementen sind die Wellen Leitwerte YLp und YLn, die elektrischen Winkel $\alpha p$ und $\alpha n$ aus den gleichsinnigen bzw. gegensinnigen Kurzschluss-und Leerlauf-Admittanzen Blp, Bkp, Bln, Bkn aus den Gleichungen (1) bestimmt.

Der zur verkoppelten Leitung 15 äquivalente Leitungswellenwiderstand ZLp = 1/YLp für gleichsinnige Erregung lautet

$$YLp = \frac{1}{ZLp} = \sqrt{\Delta Cm / \Delta Lp} \qquad (18a)$$

und für den dazugehörigen elektrischen Winkel der Schaltung ergibt sich

$$\alpha p = 2\pi * f1 * \sqrt{\Delta Lp * \Delta Cm} * \text{N.} \qquad (18b)$$

Der zur verkoppelten Leitung 15 äquivalente Leitungswellenwiderstand ZLn = 1/YLn für gegensinnige Erregung lautet

$$YLn = \frac{1}{ZLn} = \sqrt{(\Delta Cm + 2 * \Delta Cb) / \Delta Ln} \qquad (18c)$$

und für den dazugehörigen elektrischen Winkel der Schaltung ergibt sich

$$\alpha n = 2\pi * f1 * \sqrt{(\Delta Cm + 2 * \Delta Cb) * \Delta Ln} \; *\text{N} \qquad (19)$$

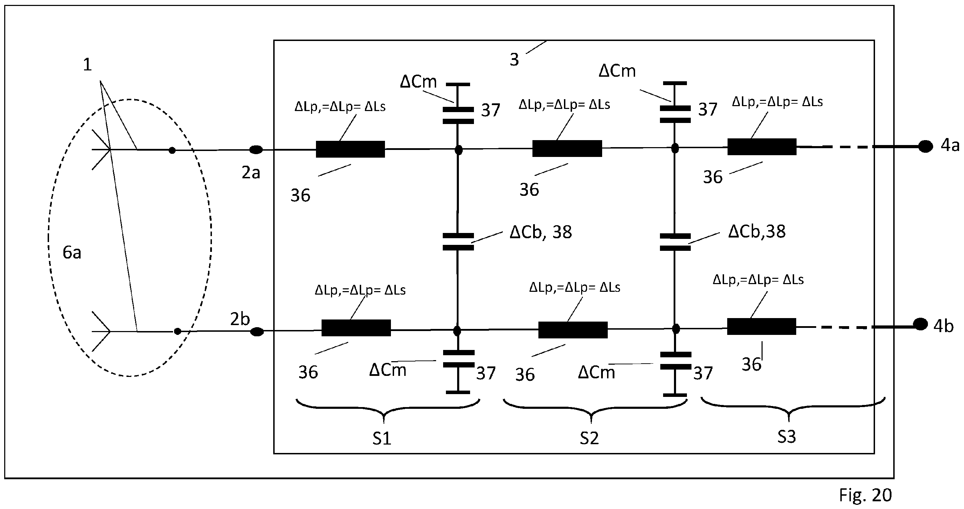

Für die Erreichung der Anpassung an den normierten Widerstand Z0=1/Y0 an den Entkoppelnetzwerk- Anschlusstoren 4a, 4b in Figur 20 bei der Entkopplungsfrequenz Frequenz f1 ist die Einstellung der Wellenwiderstände ZLp u ZLn sowie die Einstellung der elektrischen Winkel $\alpha p$ und $\alpha n$ des Entkoppelnetzwerks 3 gefordert, welche sich aus den Antennen-Admittanzen YAp und YAn anhand der Gleichungen (2) ergeben.

Für die vorliegenden Betrachtungen ist es notwendig, die Entkopplungsfrequenz hinreichend unterhalb der Grenzfrequenz ftn einer Schaltungsstufe mit Tiefpassstruktur zu wählen. Für diese gilt:

$$\text{ftn} = 1/(2\pi * \sqrt{(\Delta Cm + 2 * \Delta Cb) * \Delta Ln}\;) \qquad (20)$$

Somit ist die kleinste notwendige Anzahl N der Stufen für den elektrischen Winkel $\alpha n$ aus Gleichung (19) der Schaltung gegeben durch

$$\text{N} = \alpha n * ftn/f1$$

Die elektrischen Eigenschaften der kontinuierlichen elektrischen Leitung aus den linearen elektrischen Leitern 8a, 8b - bestehend aus ihren infinit kleinen Elementen - sind mit der nachgebildeten elektrischen Leitung aus konzentrierten Bauelementen umso genauer erreicht, je größer die Anzahl N der Stufen für den elektrischen

Winkel $\alpha n$ gewählt ist. Hierfür sollte das Verhältnis $\dfrac{f1}{ftn} < 0.5$ gewählt sein.

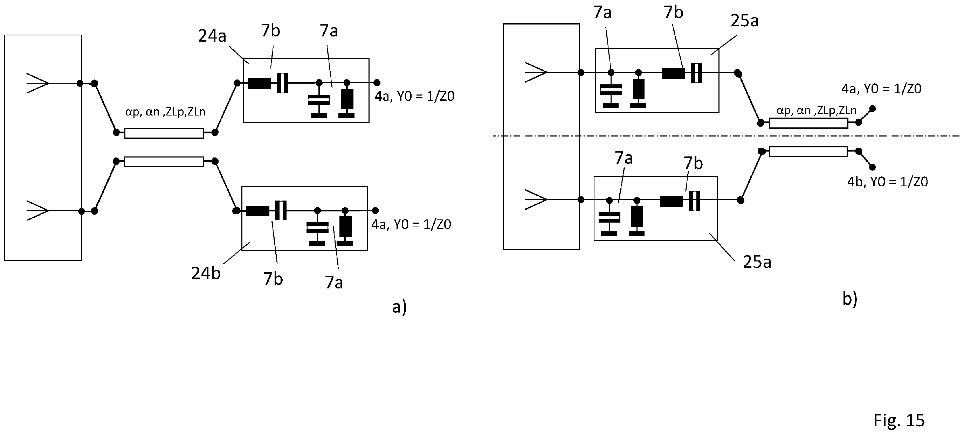

Auf diese Weise können die linearen elektrischen Leiter 8a, 8b in den Figuren 7, 9, 11, 15, 16 in vollkommener Analogie jeweils durch die aus konzentrierten Bauelementen bestehende, nachgebildete verkoppelte elektrische Leitung ersetzt werden, um die gleiche Entkopplung sowie Anpassung an den Entkoppelnetzwerk-Anschlusstoren 4a, 4b zu erreichen.

Fig. 21:
zeigt das Entkoppelnetzwerk 3 nach der Erfindung wie in Figur 20, in welchem jedoch in allen Stufen S1, S2.. die diskreten induktiven Bauelemente der Induktivität ⊿Lp, ⊿Ls 36 jeweils durch eine diskrete zweipolige Serien-Blindelementschaltung 43, die diskreten kapazitiven Bauelemente mit der Brücken-Kapazität ⊿Cb 38 jeweils durch eine diskrete zweipolige Brücken-Blindelementschaltung 45 und die diskreten kapazitiven Bauelemente mit der Masse-Kapazität ⊿Cm 37 jeweils durch eine diskrete zweipolige Masse-Blindelementschaltung 44 ersetzt sind. Für alle eingesetzten Blindelementschaltungen zur Bildung der Entkopplung an der Entkopplungsfrequenz f1 gilt, dass jeweils die ersetzende Blindelementschaltung 43, 44, 45 in der Weise gestaltet ist, dass sie bei der Entkopplungs-Frequenz f1 und in deren Frequenzumgebung den hinreichend gleichen Blindwiderstandswert besitzt, wie das zu ersetzende diskrete Blindelement.

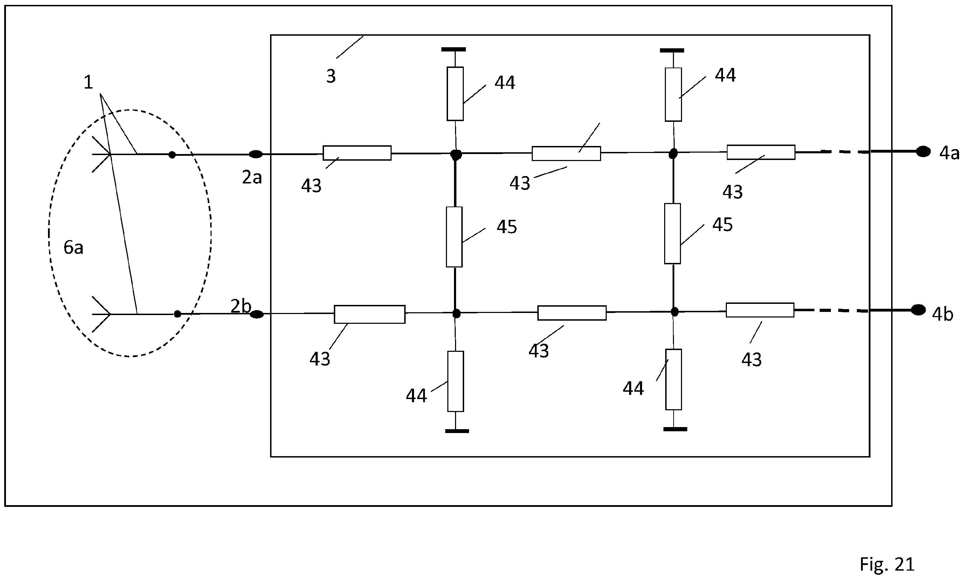

Fig. 22:
zeigt das Entkoppelnetzwerk 3 wie in Figur 21 nach der Erfindung, in welchem mit nur zwei, jedoch zueinander ungleichen Stufen S1und S2 Entkopplung zwischen den Entkoppelnetzwerk- Anschlusstoren 4a, 4b bei zwei Frequenzen f1 und f2 erreicht ist. Im Zusammenwirken von der induktiven Serien-Blindelementschaltung 43 mit der zweipoligen Brücken-Blindelementschaltung 45 der erste Stufe S1 ist die Entkopplung am Entkoppelnetzwerk-Anschlusstor 4a, 4b für die Frequenz f1 dadurch gegeben, dass die zweite Stufe S2 für die erste Frequenz f1 durchlässig gestaltet ist. Diese Durchlässigkeit ist dadurch erreicht, dass in der Serien-Blindelementschaltung 43'der zweiten Stufe S2 ein für diese Frequenz f1 durchlässiger serieller Serienresonanzkreis 46 und in der Brücken-Blindelementschaltung 45' ein für diese Frequenz f1 sperrender serieller Parallel-Resonanzkreis 47 vorhanden ist, um die erreichte Entkopplung nicht zu beeinträchtigen. Die Entkopplung am Entkoppelnetzwerk- Anschlusstor 4a, 4b bei einer weiteren Frequenz f2 ist durch erfindungsgemäße Abstimmung der Serien-Blindelementschaltung 43' und der Brücken-Blindelementschaltung 45' gegeben. Die nachgeschalteten Ausgangs-Anpassnetzwerke 25a, 25b sind ohne Einfluss auf die Entkopplung und sind ausschließlich zur Impedanzanpassung vorhanden. Ebenso dienen die beiden Antennen-Anpassnetzwerke 24a, 24b ausschließlich zur Transformation der Antennenimpedanz an deren Ausgängen, welche aufgrund der Strahlungsverkopplung der Antennen ebenso verkoppelt sind.

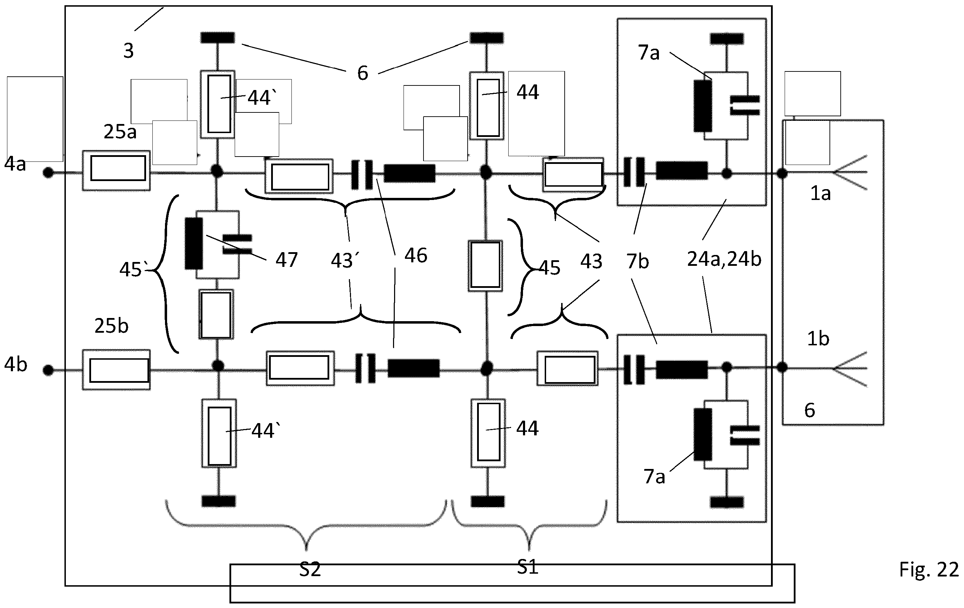

Fig. 23:
Frequenzverlauf der Verkopplung der Entkoppelnetzwerk-Anschlusstore S4a4b des Entkoppelnetzwerks 3 in dB in Figur 22 für Tiefentkopplung bei den Frequenzen f1 und f2.

Fig. 24:

Antennensystem 1 nach der Erfindung wie in Fig. 21, jedoch mit einem Entkoppelnetzwerk 3 mit nur einer Stufe S1, bestehend aus den beiden bei der Frequenz f1 induktiven diskreten zweipoligen Serien-Blindelementschaltungen 43 mit der Reaktanz X1, der die Entkopplung bei der Frequenz f1 bewirkenden, bei der Frequenz f1 kapazitiven, diskreten zweipoligen Brücken-Blindelementschaltung 45 mit der Admittanz B1 und der diskreten Masse-Blindelementschaltung 44 zur Impedanzanpassung.

Mit den zueinander gleichen strahlungsgekoppelten Antennen 1a, 1b ist für die Frequenz f1 die Reaktanz X1 aus den gleichsinnigen und gegensinnigen Antennenadmittanzen YAp = GAp + jBAp und YAn = GAn + jBAn die für die Entkopplung bei der Frequenz f1 mit einem reinen Blindleitwert B1 notwendige Reaktanz X1, wie folgt, ermittelt. Hierfür sind zwei Werte für X1 möglich:

$$X11 = \frac{GAp * BAn - GAn * BAp + \sqrt{GAp * GAn * |YAp - YAn|^2}}{GAp * |YAn|^2 - GAn|YAp|^2}$$

und $\qquad\qquad\qquad\qquad$ (21)

$$X12 = \frac{Gap * Ban - Gan * BAp - \sqrt{Gap * Gan * |Yap - Yan|^2}}{GAp * |YAn|^2 - GAn|YAp|^2} \; .$$

Somit ist X1 = X11 oder X1 = X12 gewählt.

Mit dem daraus gewählten Wert für X1 ist mit

$$B1 = B1p - B1n \qquad\qquad (22)$$

mit den Werten

$$B1p = \frac{BAp - X1 * |YAp|^2}{X1^2 * |YAp|^2 - 2 * X1 * BAp + 1}$$

und

$$B1n = \frac{BAn - X1 * |YAn|^2}{X1^2 * |YAn|^2 - 2 * X1 * BAn + 1}$$

unabhängig von der diskreten Masse-Blindelementschaltung 44 Entkopplung zwischen den Entkoppelnetzwerk-Anschlusstoren 4a, 4b erreicht.

Fig. 25:

In vollkommener Dualität zu der in Figur 20 dargestellten, aus diskreten Bauelementen ∆Lp = ∆Ls, ∆Cb, ∆Cm

gestalteten Leitungsnachbildung nach der Erfindung mit dem Charakter einer Tiefpassstruktur ist die in der vorliegenden Figur dargestellte Leitungsnachbildung mit einer Hochpassstruktur, bestehend aus einer Reihe von Stufen S1, S2.. mit jeweils zwei Serienkapazitäten ΔCs, einer Brückeninduktivität ΔLb und zwei Masse-Induktivitäten ΔLm gestaltet.

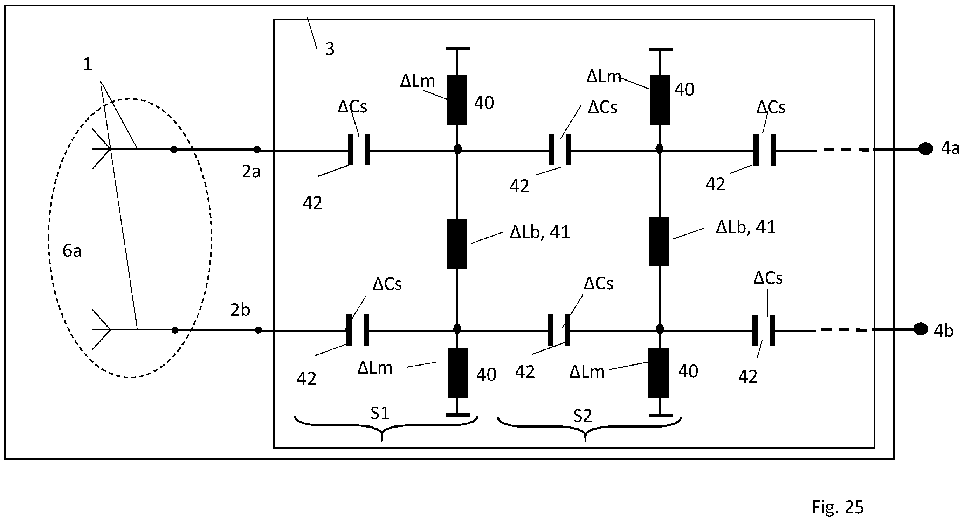

Durch duale Transformation der Schaltung in Figur 20 ergibt sich bei gleichsinniger Erregung der Wellenwiderstand der äquivalenten Leitung in Figur 25 zu

$$ZLp = \sqrt{\frac{\Delta Lm}{\Delta Cs}} \text{ und bei gegensinniger Erregung zu } ZLn = \sqrt{\frac{\Delta Lm * \Delta Lp}{\Delta Cs * (\Delta Lb + 2 * \Delta Lm)}}$$

Entsprechend ergibt sich die Grenzfrequenz einer Stufe mit Hochpassstruktur bezüglich der gegensinnigen Erregung zu

$$fhn = \frac{1}{2\pi} * \sqrt{\frac{\Delta Lb + 2 * \Delta Lm}{\Delta Cs * \Delta Lm * \Delta Lp}}$$

Um bei Frequenzen im Frequenzbereich der Entkopplungsfrequenz f1 und bei Frequenzen darüber hinreichend gute Anpassung zu erreichen, sollte das Verhältnis f1/fhn > 2 eingehalten sein.

Fig. 26:
Zeigt die Zusammenführung des in Figur 20 dargestellten Entkoppelnetzwerks 3 mit einer aus konzentrierten Blindelementen gebildeten Leitungsnachbildung mit Tiefpassstruktur mit dem in Figur 25 dargestellten Entkoppelnetzwerk 3 mit einer aus konzentrierten Blindelementen gebildeten Leitungsnachbildung mit Hochpassstruktur. Mit der kombinierten Struktur ist ein Entkoppelnetzwerk 3 gegeben, durch dessen Tiefpassstruktur-Eigenschaft bei einer niedrigen Frequenz f1 und durch dessen Hochpassstruktur-Eigenschaft bei einer höheren Frequenz f2 jeweils Entkopplung erreicht ist.

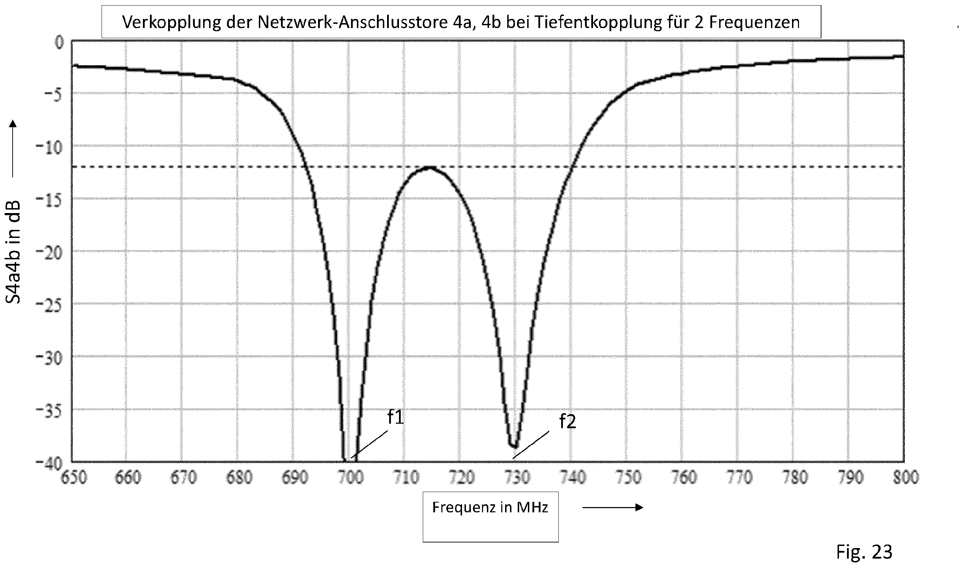

Die Serien-Einzelelemente 36 und 42 in den Figuren 20 und 25 sind in der kombinierten Struktur jeweils durch einen Parallel-Resonanzkreis 36, 42 ersetzt, welcher bei der niedrigen Frequenz f1 den positiven Blindwiderstandswert ΔLs der Tiefpassstruktur und entsprechend bei der höheren Frequenz f2 den negativen Blindwiderstandswert ΔCs der Hochpassstruktur besitzt. Die Masse-Einzelelemente 37 und 40 in den Figuren 20 und 25 sind in der kombinierten Struktur jeweils durch einen Serien-Resonanzkreis 37, 40 ersetzt, welcher bei der niedrigen Frequenz f1 den negativen Masse-Blindwiderstandswert ΔCm der Tiefpassstruktur und entsprechend bei der höheren Frequenz f2 den positiven Blindwiderstandswert ΔLm der Hochpassstruktur aufweist. Ebenso sind die Brücken-Einzelelemente 38 und 41 in den Figuren 20 und 25 in der kombinierten Struktur jeweils durch einen Serien-Resonanzkreis 38, 41 ersetzt, welcher bei der niedrigen Frequenz f1 den negativen Brücken-Blindwiderstandswert ΔCb der Tiefpassstruktur und entsprechend bei der höheren Frequenz f2 den positiven Blindwiderstandswert ΔLb der Hochpassstruktur aufweist. Mit einem derartigen Entkoppelnetzwerk 3 kann ein Frequenzverlauf der Entkopplung ähnlich wie in Figur 23 erreicht werden.

Im Folgenden werden weitere Vorteile der Erfindung im Einzelnen beschrieben:
Ein besonderer Vorteil einer Antennenanlage 1 mit Netzwerk 3 nach der Erfindung besteht in der Möglichkeit jede von zwei einzelnen infolge ihres kleinen Abstands voneinander strahlungsverkoppelten Antennen 1a, 1b mit einer Sende-Empfangseinrichtung über eine verkoppelte elektrische Leitung 15 zu verbinden, welche die durch die Verkopplung bedingten gegenseitigen Störungen in den Sende-Empfangseinrichtungen 16a, 16b vermeidet und mit besonders geringem wirtschaftlichen Aufwand individuell gestalten werden kann. Darüber hinaus ist die verkoppelte Leitung in der Lage, gleichzeitig Entkopplung und Impedanzanpassung an den genormten Widerstand Z0=1/Y0 zu erreichen. Dieser beträgt in der gängigen Technik zumeist Z0 =50 Ohm.

Insbesondere besteht die vorteilhafte Möglichkeit, die Antennen 1a,1b zusammen mit der verkoppelten elektrischen Leitung als EntkopplungsNetzwerk 3 auf einem gemeinsamen mechanischen Träger anzuordnen. Durch die unmittelbare mechanische Verbindung der Antennen mit einer auf einer elektrische Leiterplatte als mechanischen Träger ausgeführten verkoppelten elektrischen Leitung 15 ist eine besondere Raumersparnis ermöglicht, welche im Kraftfahrzeugbau häufig entscheidend ist.

Die Anordnung in den Figur 4 und 7 nach der Erfindung mit einem ausschließlich aus einer erfindungsgemäß gestalteten verkoppelten elektrischen Leitung 15 als Entkoppelnetzwerk 3 ist individuell und wirtschaftlich extrem aufwandsarm zu realisieren und kann - entsprechend den angegeben Dimensionierungen - flexibel an das Antennensystem 1 angepasst werden. Damit wird die in Figur 8a, 8b dargestellte Entkopplung erreicht. Dabei ist es besonders vorteilhaft, die verkoppelte elektrische Leitung 15 als Mikrostreifenleitung 26 auf der Leiterplatte auszuführen, wie sie beispielhaft in Figur 18a dargestellt ist.

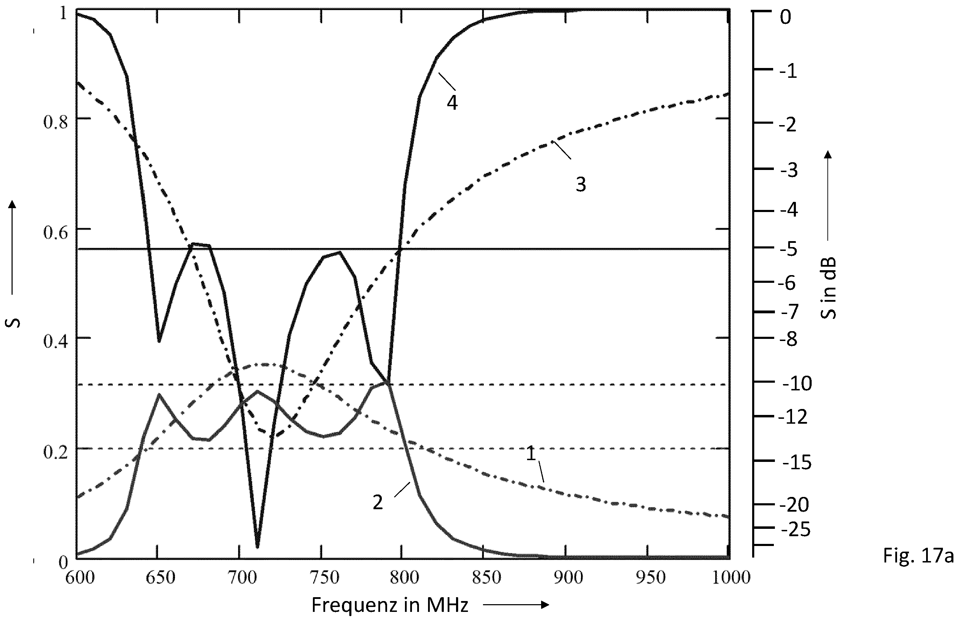

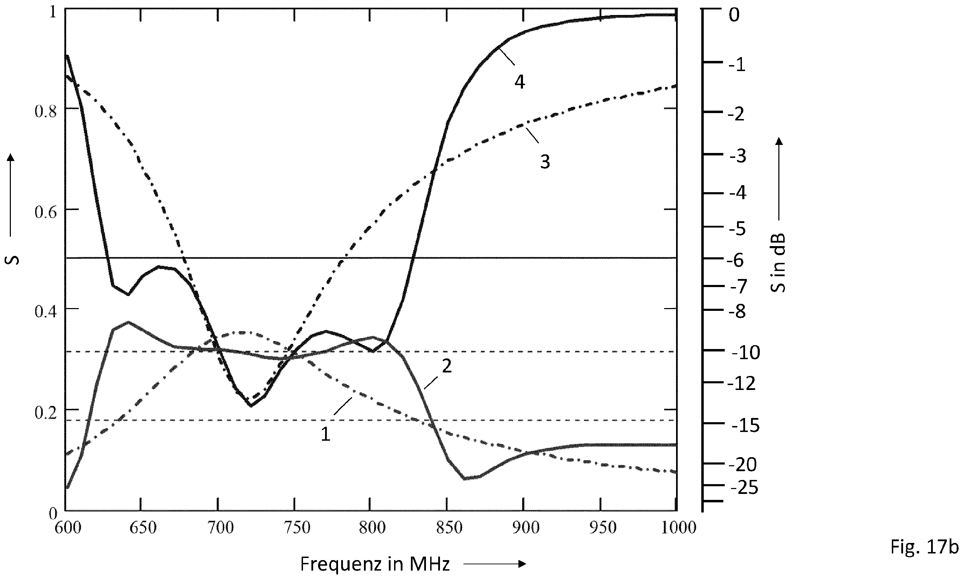

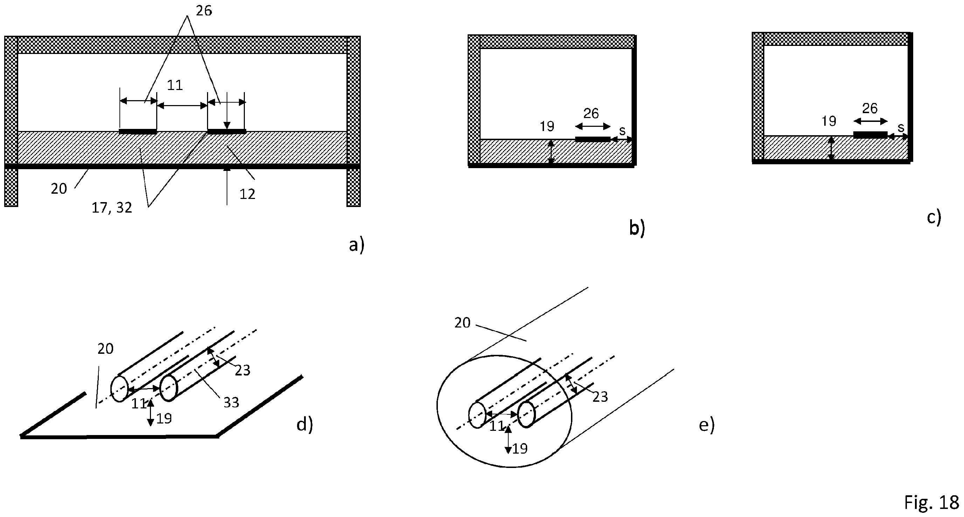

Mit nur wenigen elektrischen Bauteilen kann die Anordnung in Figur 7 mit einem Antennen-Anpassnetzwerk 24a, 24b und einem Ausgangs-Anpassnetzwerk 25a, 25b - wie in Figur 16a dargestellt - ergänzt werden und die breitbandige und häufig ausreichende Entkopplung gemäß Figur 17a, 17b über einen größeren Frequenzbereich hergestellt werden. Die Herstellung der verkoppelten elektrischen Leitung 15 erfolgt nach den oben genannten Dimensionierungen für die Leitungs-Wellenwiderstände ZLp und Zln, sowie für die elektrischen Winkel $\alpha$p und $\alpha$n, welche sich aus den oben angegebenen mathematischen Beziehungen aus den Antennenimpedanzen ZAp = 1/YAp und ZAn = 1/YAn ergeben. Die Umsetzung in die geometrische Struktur der verkoppelten elektrischen Leitung 15 als Mikrostreifenleitung 26 erfolgt zweckmäßig anhand eines Simulationsmodells. Dieses kann hierzu zweckmäßig im Querschnitt entlang dessen Symmetrieebene in zwei Hälften geteilt werden, welche jeweils nur noch eine Leitung beinhalten. Dies geschieht im Fall der symmetrischen Leitung 13 durch Abschluss der Symmetrieebene mit einer magnetischen Wand gemäß Figur 18b und im Fall der antisymmetrischen Leitung durch Abschluss der Symmetrieebene mit einer elektrischen Wand, wie in Figur 18c. Darauf können die Leiterbreite 11 und der halbe Leiterbstand 11 bei gegebener Substrathöhe 19 und bei vorgegebenem Dielektrikum so lange variiert werden, bis sich für den Querschnitt links der gewünschte Leitungs-Wellenwiderstand ZLp und die Phasenkonstante $\beta$p und für den Querschnitt rechts der gewünschte Leitungs-Wellenwiderstand ZLn und die Phasenkonstante $\beta$n einstellt. Zusätzlich können z. B. die einander gegenüberliegenden Ränder der Streifenleiter unter Abstand zahnförmig ineinandergreifen, womit ZLp mit $\beta$p und ZLn mit $\beta$n besser gesondert eingestellt werden können. Für die Simulation stehen professionelle leistungsstarke digitale Rechenprogramme zum Beispiel nach der Methode der finiten Elemente zur Verfügung, welche die gezielte Ermittlung von geeigneten gedruckten Leiterstrukturen für eine verkoppelte elektrische Leitung 15 In Mikrostreifenleitungstechnik mit den geforderten Parametern ermöglichen. Ein Vergleich der Darstellung einer verkoppelten Leitung 15 als Mikrostreifenleitung 26 mit den in den Figuren 18d und 18e verkoppelten elektrischen Leitungen 15 veranschaulicht die vorteilhaft einfache und flexible Gestaltbarkeit der Mikrostreifenleitung 26 im Gegensatz zu einer Realisierung als Zweidrahtleitung über einer leitenden Ebene oder als Zweidrahtleitung mit kreisförmiger Abschirmung.

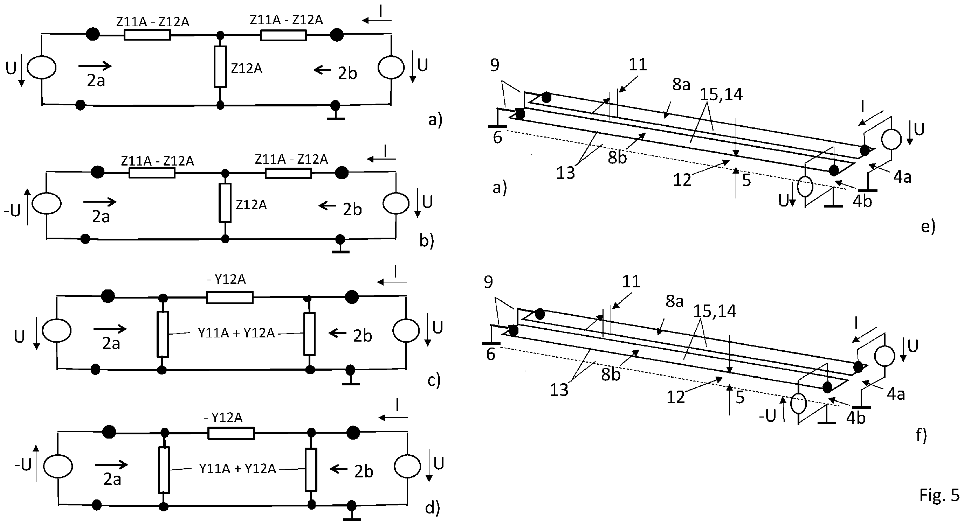

Im Folgenden werden die in Figur 5a bis 5d am Tor 2b und somit ebenso am Antennenanschlusstor 2a vorliegenden symmetrischen, mit der Endung p gekennzeichneten und die antisymmetrischen, mit der Endung n gekennzeichneten Impedanzen (Z..) bzw. Admittanzen (Y..) - welche einander jeweils reziprok entsprechen - definiert:

Fig. a) U/I = ZAp = Z11A+Z12A; bezogen auf Z0 gilt: zAp = rAp+j*xAp = ZAp/Z0

Fig. b) U/I = ZAn = Z11A -Z12A; bezogen auf Z0 gilt: zAn = rAn + j*xAn = ZAn/Z0

Fig. c) I/U = YAp = Y11A +Y12A; bezogen auf Y0 gilt: yAp = gAp + j*bAp = YAp/YO

Fig. d) I/U = YAn = Y11A -Y12A; bezogen auf Y0 gilt: yAn = gAn + j*bAn = YAn/YO (10)

Die Ausgangstore des Antennen-Anpassnetzwerks 24a, 24b sind mit 2a' und 2b' bezeichnet. Entsprechend gelten die obigen Beziehungen für die mit Apostroph' zu kennzeichnenden Impedanzen bzw. Admittanzen zur Beschreibung des zwischen den Toren 2a' und 2b' bestehenden Zweitors bzw. Vierpols.

In vollkommener Entsprechung zu den Figuren 5a bis 5d sind die elektrischen Kenngrößen als Vierpole am Ausgang des Netzwerks 3 zwischen den Antennenanschlusstoren 4a und 4b mit den Impedanzen bzw. Admittanzen erfasst. In Analogie zu diesen Figuren gilt zwischen den Ausgängen des Netzwerks 3 jeweils wie:

Fig. a) U/I = ZNp = Z11N+Z12N; bezogen auf Z0 gilt: zNp = rNp+j*xNp = ZNp/ZO

Fig. b) U/I = ZNn = Z11N -Z12N; bezogen auf Z0 gilt: zNn = rNn + j*xNn = ZNn/ZO

Fig. c) I/U = YNp = Y11N +Y12N; bezogen auf Y0 gilt: yNp = gNp + j*bNp = YNp/Y0

Fig. d) I/U = YNn = Y11N -Y12N; bezogen auf Y0 gilt: yAn = gNn + j*bNn = YNn/Y0 (11)

Auf Basis der hier getroffenen Definitionen für die Impedanz bzw. Admittanzen an den Anschlusstoren lautet die auf die normierte Admittanz Z0 bezogene Impedanzmatrix bzw. die auf Y0 bezogene Admittanzmatrix für die Antennen-Anschlusstoren 2a, 2b, wie folgt:

$$zAM = \frac{1}{2} * \begin{bmatrix} zAp + zAn & zAp - zAn \\ zAp - zAn & zAp + zAn \end{bmatrix} \quad bzw.\, yAM = \frac{1}{2} * \begin{bmatrix} yAp + yAn & yAp - yAn \\ yAp - yAn & yAp + yAn \end{bmatrix} \quad (12)$$

In Entsprechung hierzu lautet die bezogene Impedanzmatrix zNM bzw. die Admittanzmatrix yNM an den Entkoppelnetzwerk-Anschlusstoren 4a, 4b, wie folgt:

$$zNM = \frac{1}{2} * \begin{bmatrix} zNp + zNn & zNp - zNn \\ zNp - zNn & zNp + zNn \end{bmatrix} \quad bzw.\, yNM = \frac{1}{2} * \begin{bmatrix} yNp + yNn & yNp - yNn \\ yNp - yNn & yNp + yNn \end{bmatrix} \quad (13)$$

wobei gilt: $yAM = zAM^{-1}$ und $yAN = zAN^{-1}$

Anhand der symmetrischen und unsymmetrischen Impedanzen bzw. Admittanzen kann daraus jeweils die Verkopplung zwischen den beiden Antennen-Anschlusstoren 2a und 2b bzw. zwischen den beiden Entkoppelnetzwerk-Anschlusstoren 4a und 4b als Streuparameter S2a2b bzw. S4a4b bei Abschluss jeweils eines der Tore mit dem Normwiderstand Z0 =1/Y0 nach folgenden Beziehungen dargestellt werden:

$$S2a2b = \frac{yAn - yAp}{1 + yAp + yAn + yAp * yAn;} = \frac{zAp - zAn}{1 + zAp + zAn + zAp * zAn;} \text{ mit } S2a2b_{dB} = 20 * log(\,|S2a2b|) \quad (14)$$

$$S4a4b = \frac{yNn - yNp}{1 + yNp + yNn + yNp * yAN;} = \frac{zNp - zNn}{1 + zNp + zNn + zNp * zNn;} \text{ mit } S4a4b_{dB} = 20 * log(\,|S4a4b|) \quad (16)$$

Vollkommene, d. h. Tiefentkopplung ist zwischen den Entkopplungsnetzwerk-Anschlusstoren 4a und 4b bei der Frequenz f1 dann erreicht, wenn die Differenz zwischen der symmetrischen mit der Endung "p" gekennzeichneten Impedanz bzw. Admittanz und der unsymmetrischen mit der Endung "n" gekennzeichneten Impedanz bzw. Admittanz bei dieser Frequenz verschwindet, d.h. wenn yNn = yNp gleichbedeutend mit zNp = zNn erfüllt ist.

Als Maß für die Impedanzanpassung an den Normwiderstand Z0 an einem Anschlusstor wird der Reflexionsfaktor betrachtet, welcher sich jeweils einstellt, wenn das andere Anschlusstor mit dem Normwiderstand Z0 abgeschlossen ist.

Somit gilt für die Antennenanschlusstore 2a, 2b:

$$S2a2a = S2b2b = \frac{1 - yAp * yAn}{1 + yAp + yAn + yAp * yAn;} \text{ mit } S2a2a_{dB} = S2b2b_{dB} = 20 * log(\,|S4a4a|) \quad (15)$$

Und für die Entkopplungsnetzwerk-Anschlusstore 4a, 4b gilt entsprechend:

$$S4a4a = S4b4b = \frac{1 - yNp * yNn}{1 + yNp + yNn + yNp * yNn;} \text{ mit } S4a4a_{dB} = S4b4b_{dB} = 20 * log(\,|S4a4a|) \quad (16)$$

Damit ist gezeigt, dass die Reflexion *S4a4a* = *S4b4b* an den Entkopplungsnetzwerk-Anschlusstoren 4a, 4b dann verschwindet, wenn die symmetrische, mit der Endung "p" gekennzeichnete Impedanz bzw. Admittanz und unsymmetrische mit der Endung "n" gekennzeichneten Impedanz bzw. Admittanz bei dieser Frequenz gleich sind d.h. yNn = yNp gleichbedeutend mit zNp = zNn erfüllt ist.

Erfindungsgemäß leistet somit die verkoppelte elektrische Leitung 15 in der wirtschaftlich besonders vorteilhaften Grundform der Erfindung in Figur 4a, 4b und in Figur 7 sowohl die Tiefentkopplung bei der Frequenz f1 - das ist die vollkommene Entkopplung zwischen den Netzwerk-Anschlusstoren 4a, 4b - sondern transformiert darüber hinaus auch die an den Antennen-Anschlusstoren 2a, 2b vorliegenden Impedanzen in der Weise, dass an jedem der Entkopplungsnetzwerk-Anschlusstore 4a, 4b Impedanzanpassung an Z0 = 1/Y0 gegeben ist, wenn das andere Anschlusstor jeweils mit Z0 abgeschlossen ist. Gemäß der Erfindung ist dies dadurch erreicht, dass die Geometrie und Ausführungsform der verkoppelten elektrischen Leitung 15 in der Weise gestaltet sind, dass sowohl die auf Y0 bezogene Leitungswellenadmittanz yLp = YLp/YO der symmetrischen elektrischen Leitung 13 und deren elektrischer Winkel αp als auch die entsprechende auf Y0 bezogene Leitungswellenadmittanz yLn = YLn/YO der antisymmetrischen elektrischen Leitung 14 und deren elektrischer Winkel αn gemäß den nachfolgenden Beziehungen gebildet sind, welche durch die auf Y0 bezogenen Admittanzen YAp/YO und YAn/YO des Antennensystem 1 vorgegeben sind, wobei folgende Forderungen gelten:

$$YLp/Y0 = yLp = \sqrt{\frac{|yAp|^2 - gAp}{gAp - 1}}; \quad \alpha p = arc\,tan(\frac{1 - gAp}{bAp} \bullet yLp)$$

$$YLn/Y0 = yLn = \sqrt{\frac{|yAn|^2 - gAn}{gAn - 1}}; \quad \alpha n = arc\,tan(\frac{1 - gAn}{bAn} \bullet yLn)$$

und folgende Festlegungen gelten:

$$yAp = \frac{YAp}{Y0} = gAp + j * bAp; \text{ und } yAn = \frac{YAn}{Y0} = gAn + j * An;$$

mit $j^2$ = -1

Zur Gestaltung einer verkoppelten elektrischen Leitung 15 mit den erfindungsgemäß geforderten Werten für YLp, YLn und den geforderten elektrischen Winkeln αp und αn ist es vorteilhaft, zunächst unabhängig von der Leitungslänge I 10 die elektrische Struktur der verkoppelten elektrischen Leitung 15 zu ermitteln, welche für YLp, YLn und für die Phasenkonstanten βp und βn Werte in der Weise liefert, dass deren Verhältnis βp /βn = αp /αn erfüllt ist und die geometrische Leitungslänge I 10 gemäß I = αp / βp , gleichbedeutend mit αn/βn für die Frequenz f1 zu wählen.

Als Hinführung zur Erreichung dieses Ziels sind *YLp* , *YLn* und *βp/βn* gemäß den oben angegebenen Beziehungen aus den verteilten Kapazitäten und Induktivitäten wie folgt zu gestalten:

$$\beta p/\beta n = \sqrt{\frac{Lp`}{Ln`} * \frac{Cm`}{(Cm` + 2*Cb`)}}; \quad YLp = \frac{1}{ZLp} = \sqrt{\frac{Cm`}{Lp`}}, \quad YLn = \frac{1}{ZLn} = \sqrt{\frac{Cm` + 2*Cb`}{Ln`}} \qquad (17)$$

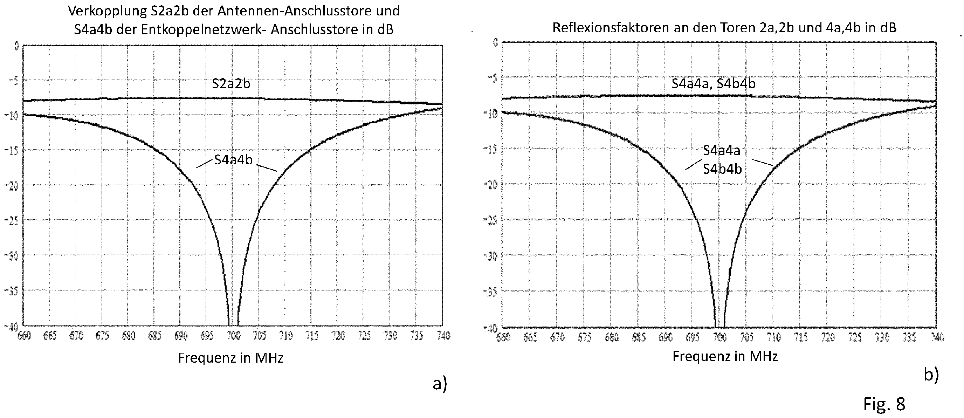

Die Entkopplung der Antennenanschlusstore 4a, 4b und die Reflexionsdämpfung sind In den **Figuren 8a und 8b** dargestellt und im Zusammenhang mit diesen Figuren bereits oben diskutiert.

Für den besonderen Fall, in welchem die Dimensionierung der verkoppelten elektrischen Leitung 15 aufgrund von besonderen symmetrischen und antisymmetrischen Antennenimpedanzen ZAp und ZAn des Antennensystems 1 bei der Frequenz f1 schwierig ist, oder zu unhandlichen Abmessungen führt, erfolgt in einer vorteilhaften Ausführung der Erfindung in **Figur 9a** die Transformation der Antennenimpedanzen ZAp und ZAn durch die verkoppelte elektrische Leitung 15 an deren Ende in zwei einander gleiche Admittanzen YNp = YNn, wodurch Entkopplung der beiden Netzwerk-Anschlusstore 4a, 4b am Ende der verkoppelten Leitung 15 in **Figur 9a** erreicht ist.

Um gleiche auf Y0 bezogene vorgegebene Admittanz $\frac{YNp}{Y0} = \frac{YNn}{Y0} = \frac{YN}{Y0} = yN = gN + j \bullet bN$ zu erreichen, sind die Frequenz f1 für die symmetrische Leitung 13 die auf Y0 bezogene Leitungswellenadmittanz $\frac{YLp}{Y0}$ entsprechend

$$YLp/Y0 = yLp = \sqrt{\frac{gN \bullet |yAp|^2 - gAp \bullet |yN|^2}{gAp - gN}}$$

und der elektrische Winkel in Grad entsprechend

$$\alpha p = 180/\pi \bullet arc\, tan(\frac{gN - gAp}{gN \bullet bAp + bN \bullet gAp} \bullet yLp)$$

zu wählen und für die antisymmetrischen Leitung 14 ist die auf Y0 bezogene Leitungswellenadmittanz entsprechend

$$YLn/Y0 = yLn = \sqrt{\frac{gN \bullet |yAn|^2 - gAn \bullet |yN|^2}{gAn - gN}}$$

und der elektrische Winkel entsprechend

$$\alpha n = 180/\pi \bullet arc\, tan(\frac{gN - gAn}{gN \bullet bAn + bN \bullet gAn} \bullet yLn)$$

einzustellen.

Zur Admittanzanpassung an die genormte Admittanz Y0 an den Entkoppel-Netzwerk-Anschlusstoren 4a, 4b für die Frequenz f1 ist in **Figur 9b** zwischen jedem der beiden voneinander entkoppelten Enden der verkoppelten elektrischen Leitung 15 - den Leitungs- Anschlusstoren 4a', 4b' - und dem entsprechenden Entkoppelnetzwerk-Anschlusstor 4a, 4b ein einander gleiches Ausgangs-Anpassnetzwerk 25a, 25b zur Transformation der jeweils an beiden Enden der verkoppelten elektrischen Leitung 15 vorliegenden Admittanz in die genormte Admittanz Y0 eingefügt.

Für den Sonderfall, dass das Antennensystem 1 an den Antennen-Anschlusstoren 2a, 2b bei der Frequenz f1 reelle Admittanzen YAp = GAp und YAn = GAn wie **in Figur 7** aufweist, ist die Entkopplung $S_{4a4b}$ und die Admittanzanpassung ($S_{4a4a}$=0, $S_{4b4b}$ =0) der beiden Ausgangs-Anschlusstore 4a, 4b an den Bezugsleitwert Y0 dadurch hergestellt sind, dass sowohl der elektrische Winkel $\alpha p = 2\pi * l / \lambda p$ der symmetrischen Leitung 13 als auch der elektrische Winkel $\alpha n = 2\pi * l / \lambda n$ der antisymmetrischen Leitung 14 jeweils $\alpha p = \alpha n = 90°$ betragen und der Leitungswellenleitwert der symmetrischen Leitung 13 $YLp = \sqrt{GAp * Y0}$ und der Leitungswellenleitwert der antisymmetrischen Leitung 14 $YLn = \sqrt{GAn * Y0}$ gewählt sind.

Die Wellenlängen der symmetrischen und der unsymmetrischen Wellen sind mit $\lambda p$ und $\lambda n$ beschrieben.

Im Allgemeinen Ist dieser Sonderfall YAp = GAp und YAn = GAn wie in Figur 7 nicht gegeben. In diesem Fall ist es erfindungsgemäß gemäß **Figur 10** vorgesehen, zwischen jedem der beiden Antennen-Anschlusstore 4a, 4b und dem Anschluss an den entsprechenden Leiter 8a, 8b der verkoppelten elektrischen Leitung 15 ein einander gleiches Antennen-Anpassnetzwerk 24a, 24b mit den Ausgangstoren 2a' bzw. 2b' zu schalten, durch welches die an den Antennen-Anschlusstoren 2a, 2b vorliegenden Antennen-Admittanzen YAp bzw. YAn bei der Frequenz f1 jeweils in eine reelle Admittanz GAp bzw. GAn transformiert ist. Die verkoppelte elektrische Leitung 15 ist, wie bereits oben beschrieben, in der Weise gestaltet, dass die Leitungswellenadmittanz der symmetrischen elektrischen Leitung 13

$YLp = \sqrt{GAp \bullet Y0}$ und ihr elektrischer Winkel $\alpha p = \frac{l}{\lambda p} * 360 = 90°$ betragen und die Leitungswellenadmittanz der antisymmetrischen elektrischen Leitung 14 $YLn = \sqrt{GAn \bullet Y0}$ und ihr elektrischer Winkel

$\alpha n = \frac{l}{\lambda n} * 360 = 90°$ betragen.

Zur Erreichung der reellen Admittanzen GAp und GAn ist jedes Antennen-Anpassnetzwerk 24a ,24b wie in den **Figuren 11b und 11c** dargestellt, aus einem parallel zum Antennen-Anschlusstor 2a, 2b geschalteten Parallelzweipol 28, 30 mit Blindleitwert Bp aus mindestens einem Blindelement und einem in Serie geschalteten Serienzweipol 29, 31 mit Blindwiderstand Xs aus mindestens einem Blindelement gebildet, wobei Bp/Y0 bzw. Xs/Z0 bei der Frequenz f1 zur Erfüllung der Forderung YAp = GAp bzw. YAn = GAn folgende Werte besitzen mit den beiden in den Figuren 11b bzw 11c dargestellten Lösungen aus folgenden Beziehungen:

$$bp = Bp/Y0$$

$$= \frac{|zAn|^2 - |zAp|^2}{2 * (xAp * |zAn|^2 - xAn * |zAp|^2)}$$

$$* \left[ 1 \pm \sqrt{1 - \frac{4 \cdot (xAp * |zAn|^2 - xAn * |zAp|^2) * (xAn - xAp)}{(|zAp|^2 - |zAn|^2)^2}} \right]$$

und

$$xs = Xs/Z0 = \frac{|zAn|^2 - |zAp|^2}{2 * (xAp * |zAn|^2 - xAn * |zAp|^2)}$$

mit

$$zAp = rAp + j \bullet xAp = \frac{ZAp}{Z0} = \frac{Y0}{YAp} \quad und \quad zAn = rAn + j \bullet xAn = \frac{ZAn}{Z0} = \frac{Y0}{YAn}$$

*sowie $|zAn|^2 = (rAn)^2 + (xAn)^2$ und $|zAn|^2 = (rAn)^2 + (xAn)^2$*

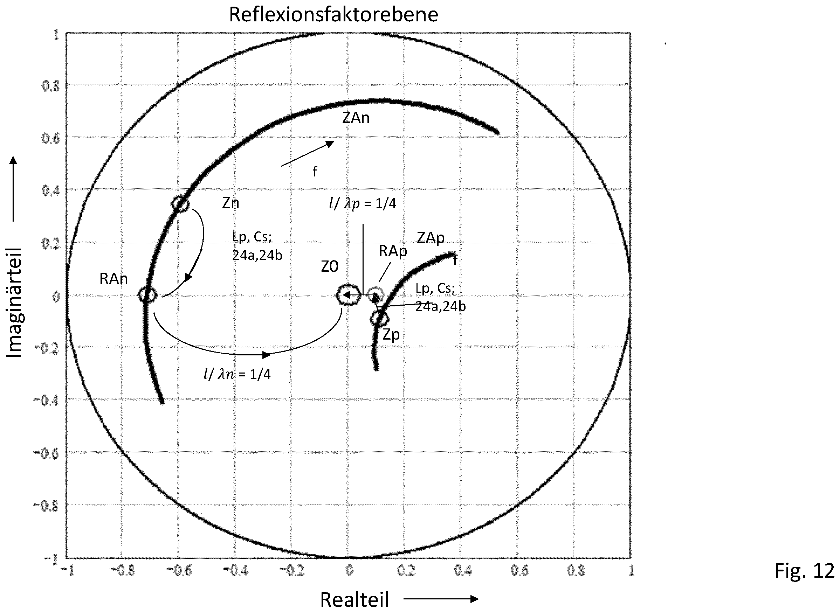

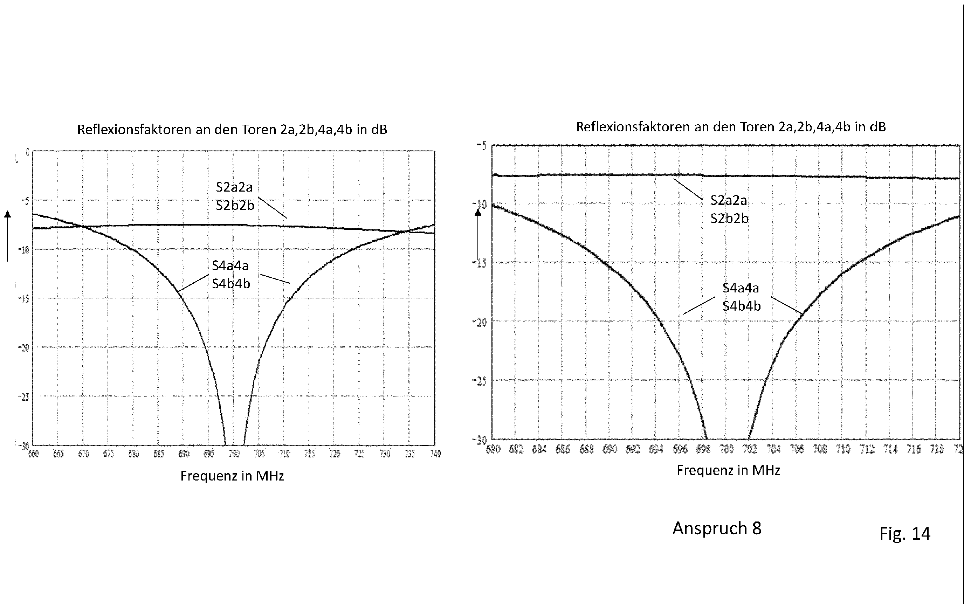

Die Wahl dieser Kombination aus Parallelzweipol Bp und Serienzweipol Xs nach einer der angegebenen Dimensionierungen für die Frequenz f1 bewirkt in der komplexen Reflexionsfaktorebene in Figur 12 die Transformation des Impedanzpunkts Zp in den reellen Widerstand RAp und gleichermaßen die Transformation des Impedanzpunkts Zn in den reellen Widerstand RAn, sodass bei der Frequenz f1 die vollkommene Entkopplung zwischen den Entkoppelnetzwerk- Anschlusstoren 4a, 4b über die Viertelwellentransformation der symmetrischen elektrischen Leitung 13 bzw. der antisymmetrischen elektrischen Leitung 14 der verkoppelten elektrischen Leitung 15 erfolgt. Als Maß für die Entkopplung zwischen den Entkoppelnetzwerk-Anschlusstoren 4a, 4b zeigen die Figuren 13a und 13b die bereits oben im Zusammenhang mit Fig. 14 beschriebene Frequenzabhängigkeit des Streuparameters S4a4b in dB im Vergleich zum Streuparameter S2a2b des Antennensystems 1. Analog hierzu zeigen die Figuren 14a und 14b den Streuparameter S4a4a = S4b4b in dB als Reflexionsfaktor an jeweils einem der den Entkoppelnetzwerk-Anschlusstore 4a, 4b bzw. an jeweils einem der Antennen-Anschlusstore 2a, 2b - bei Frequenzen um f1=700MHz - jeweils bei Abschluss des anderen Anschlusstores mit Z0=1/Y0.

In einer Weiterführung der Erfindung ist es häufig vorteilhaft, auf die Tiefentkopplung bei der Frequenz f1 teilweise zu Gunsten einer in der Frequenz breitbandigeren jedoch ausreichenden Entkopplung der Anschlusstore 4a, 4b zu verzichten und die größere Bandbreite dadurch herbeizuführen, dass die Frequenzverläufe für die Antennenimpedanzen ZAp und ZAn in Fig.12 und in Fig. 16b nach der Transformation durch die Antennen-Anpassnetzwerke 24a, 24b und die darauf folgende Transformation über die verkoppelte Leitung 15 in geringem Abstand voneinander verlaufen. Dies wird erfindungsgemäß dadurch erreicht, dass ausgehend von einer Realisierung der Antennen-Anschlussnetzwerke 24a, 24b nach einer der beschriebenen Dimensionierungen der beiden Zweipole aus Blindelementen gemäß den Figuren 11a und 11b diese ergänzt sind zu jeweils mindestens einem parallel geschalteten Parallelresonanzkreis 7a und einem in Serie geschalteten Serienresonanzkreis 7b , wie in Figur 16a angedeutet.

Zur Impedanzanpassung der auf diese Weise hinreichend voneinander entkoppelten Anschlusstore 4a, 4b ist erfindungsgemäß vorgesehen, die Ausgangs-Anpassnetzwerke 25a, 25b in der Weise zu gestalten, dass die Frequenzverläufe der Impedanzen ZNp und ZNn an den Entkoppelnetzwerk-Anschlusstoren 4a, 4b in ihrem Verlauf in der komplexen Impedanzebene mit wachsender Frequenz zwischen einer unteren Frequenz fu und einer oberen Frequenz fo um eine Mittenfrequenz fm die genormte Impedanz Z0 in kleinem Abstand umschlingen, wie es in Figur 16c skizziert ist. Diese Ausgangsanpassung wird mit jeweils mindestens einem Parallelresonanzkreis 7a und einem Serienresonanzkreis 7b in den Ausgangsanpassnetzwerken 25a, 25b in Figur 16a erreicht. Eine hiermit erreichte breitbandige Entkopplung ist durch den Frequenzverlauf des Streuparameters S4a4b beispielhaft in Figur 17a um eine Mittenfrequenz von 750 MHz dargestellt. Die breitbandig erreichte Verbesserung der Entkopplung durch das Entkoppelnetzwerk 3 nach der Erfindung geht aus dem Abstand zur Kurve S4a4b des zum Vergleich dargestellten Streuparameters S2a2b zwischen den Antennen-Anschlusstoren 2a, 2b hervor. Der Vergleich mit dem in Figur 17b zusätzlich dargestellten Frequenzverlauf der Tiefentkopplung nach einer Anordnung wie in Figur 10 zeigt den Vorteil der breitbandig erreichbaren Entkopplung, welche bei vielen Anwendungen ausreicht, um die am Eingang besprochenen, gegenseitig verursachten Störungen in den Sende-Empfangseinrichtungen 16a, 16b zu vermeiden.

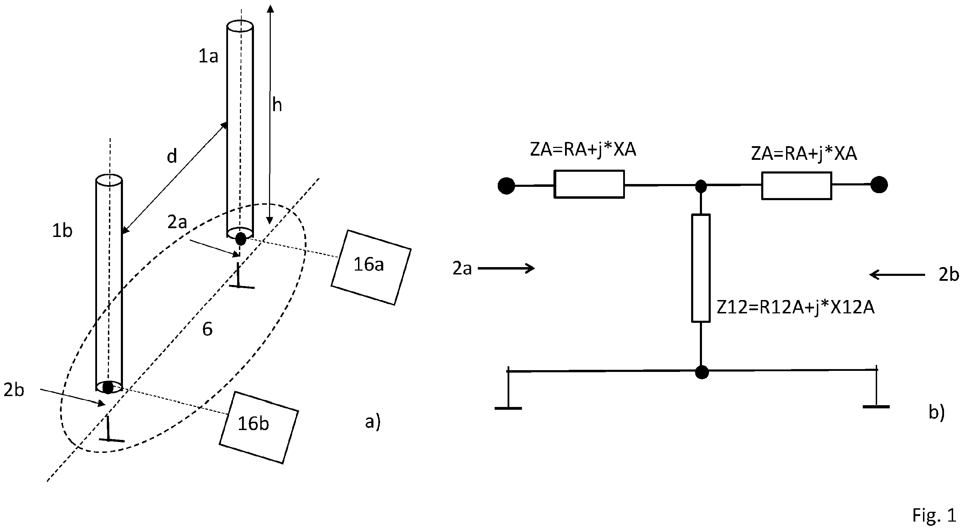

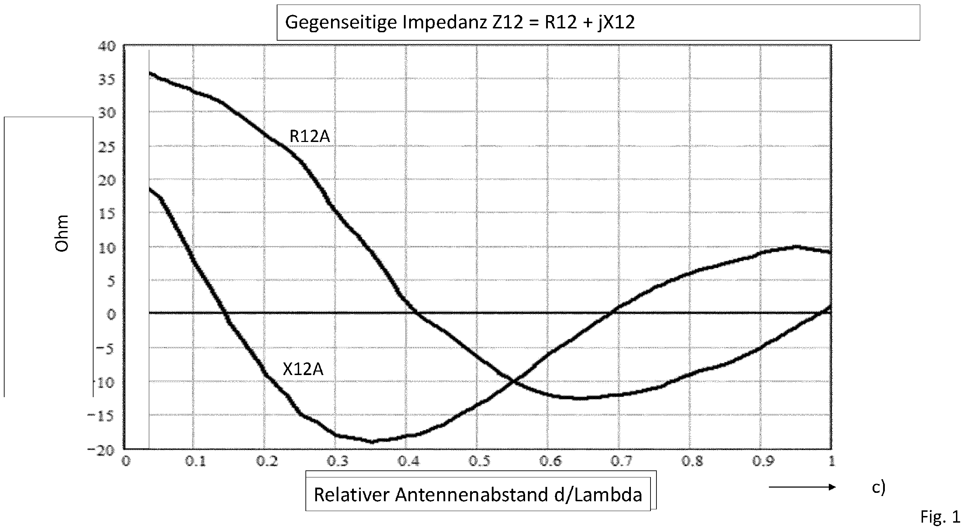

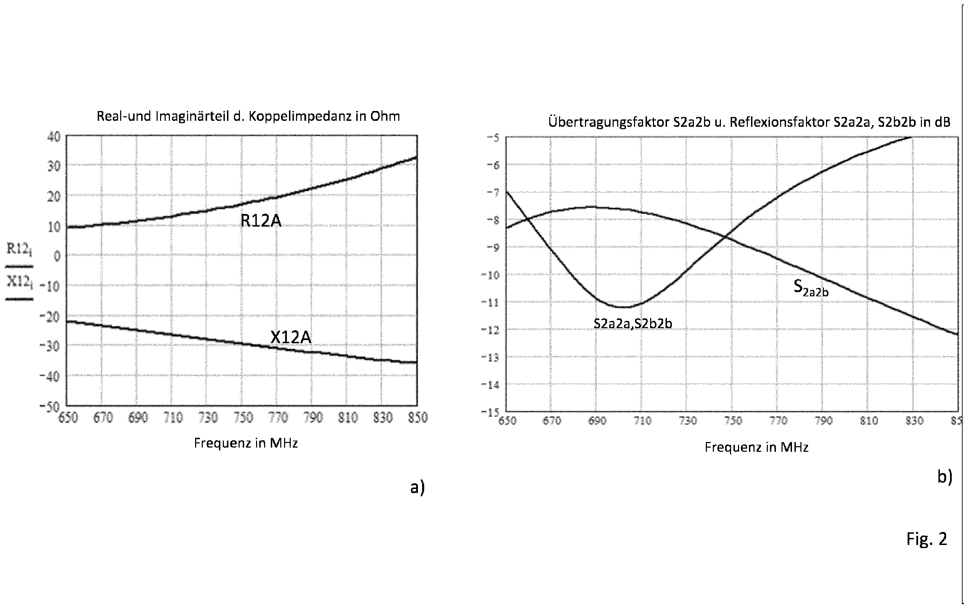

Die in den Figuren 1-18 gezeigten Beispiele legen die Anwendung der Lehren der vorliegenden Erfindung auf einander gleiche stabförmige Monopole 1a, 1b nahe. Die Erfindung ist jedoch in keiner Weise auf diese Antennenform beschränkt. Vielmehr trifft sie auf alle einander gleichen Antennenpaare (Antennen-Doubletten) zu, welche zueinander in Strahlungskopplung stehen. Hierbei ist ausschließlich die Strahlungskopplung gemäß dem Streuparameter S2a2b zwischen den Antennen-Anschlusstoren 2a, 2b von Bedeutung, welcher von der richtungsabhängigen Strahlungskopplung der Antennen-Doublette mit einer im Fernfeld befindlichen Antenne - und somit vom Richtdiagramm der Antennen-Doublette - unabhängig ist. Somit ist die Erfindung nicht auf paarige stabförmige Monopole beschränkt, sondern erfasst gleichermaßen alle paarigen, masse-unsymmetrischen Monopolstrukturen deren Monopol-Anschlusstor 2a', 2b' mit einem Pol durch die Masse 6 gegeben ist. Ähnlich verhält es sich mit paarigen Antennen mit massesymmetrischen DipolStrukturen mit jeweils einem masse-symmetrischen Anschlusstor 2a', 2b'. Zur Wahrung der Symmetrie der Anordnung ist im Übergang zu dem zugeordneten masse-unsymmetrischen Anschlusstor 2a, 2b jeweils eine Umsymmetrierungsanordnung 34 nachgeschaltet. Somit ist die Erfindung auch nicht auf paarige, stabförmige Dipole beschränkt, sondern erfasst gleichermaßen alle paarigen, masse-symmetrischen Dipolstrukturen, deren Dipol-Anschlusstor 2a', 2b' jeweils durch masse-symmetrische Anschlüsse gestaltet ist.

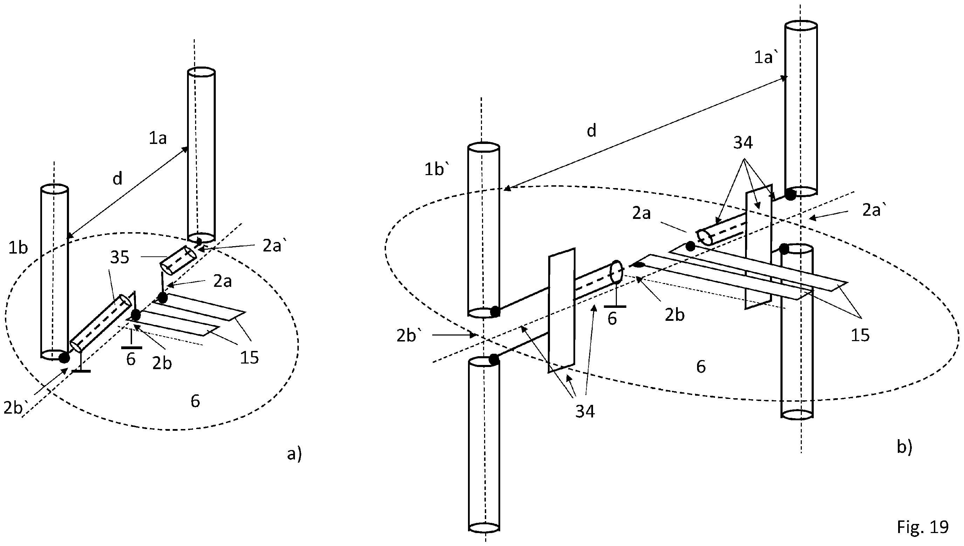

Figur 19a zeigt eine Anordnung, bei der jede der einander gleichen Antennen 1a, 1b als eine mit einem ihrer Fußpunkt-Anschlüsse 2a',2b' mit Masse 6 verbundene Monopol-Antenne 1a, 1b gebildet ist. Zur Überbrückung des Antennenabstands d mit dem zugehörigen Antennen-Anschlusstor 2a, 2b ist dieses über ein jeweils gleiches kurzes masse-unsymmetrisches Leitungsstück 35 verbunden.

Im Gegensatz hierzu ist in Figur 19b jede der einander gleichen Antennen 1a, 1b jeweils als eine symmetrisch zur Masse 6 gestaltete Dipol-Antenne 1a', 1b' gebildet. Jedes masse-symmetrische Anschlusstor 2a', 2b' ist jeweils mit dem zugeordneten Antennen-Anschlusstor 2a, 2b über eine jeweils gleiche Umsymmetrierungsanordnung 34 mit kurzer masse-symmetrischer Eingangs- und masse-unsymmetrischer Ausgansleitung zur Überbrückung des Antennenabstands d und zur Umsymmetrierung des masse-symmetrischen Dipol- Anschlusstors 2a',2b' hin zum masse-unsymmetrischen Antennen-Anschlusstor 2a, 2b verbunden.

## Liste der Bezeichnungen

Antennensystem 1
strahlungsgekoppelte Antennen 1a, 1b
Antennen-Anschlusstor 2a, 2b
Antennen-Anpassnetzwerk-Anschlusstor 2a', 2b'
Netzwerk 3
Netzwerk- Anschlusstor 4a, 4b
Leitungs- Anschlusstoren 4a', 4b'
Antennenpfad 5a, 5b
gemeinsamen Masse 6
Parallelresonanzkreis, Serienresonanzkreis 7a, 7b
linearer elektrischer Leiter 8a, 8b
Masseschluss 9
Gemeinsame Länge l 10
Leiterabstand 11
Masse-Abstand 12
Symmetrische (gleichsinnig erregte) elektrische Leitung 13
antisymmetrische (gegensinnig erregte) elektrische Leitung 14
verkoppelte Leitung 15
Sende-Empfangseinrichtung 16
Streifenleiter 17
Leiterabstand 18
Masse-Abstand 19
Massefläche 20
Koppelinduktivität M 21,
spannungsführende Anschlusspunkt 22a,22b

Leiterdurchmesser 23

Antennen-Anpassnetzwerke 24a, 24b

Ausgangs-Anpassnetzwerk 25a, 25b

Leiterbreite 26

permittives Substrat 27

positiver Parallelblindleitwert 28

positiver Serienblindwiderstand 29

negativer Parallelblindleitwert 30

negativer Serienblindwiderstand 31

Mikrostreifenleitung 32

runder Leiter 33

Umsymmetrierungsanordnung 34

masse-unsymmetrisches Leitungsstück 35

Diskretes induktives Bauelement der Induktivität $\Delta Lp$, $\Delta Ls$ 36

Diskretes kapazitives Bauelement mit der Masse-Kapazität $\Delta Cm$ 37

Diskretes kapazitives Bauelement mit der Brücken-Kapazität $\Delta Cb$ 38

spannungsführender Anschlusspunkt 39a, 39b

Diskretes induktives Bauelement mit der Masse-Induktivität $\Delta Lm$ 40

Diskretes induktives Bauelement mit der Brücken-Induktivität $\Delta Lb$ 41

Diskretes kapazitives Bauelement mit der Serien-Kapazität $\Delta Cs$ 42

Diskrete zweipolige Serien-Blindelementschaltung; induktiv bei f1 43

Diskrete zweipolige Masse-Blindelementschaltung; kapazitiv bei f1, f2 44, 44'

Diskrete zweipolige Brücken-Blindelementschaltung; kapazitiv bei f1, f2 45

Trenn-Serienresonanzkreis 46

Trenn-Parallelresonanzkreis 47

Antennenadmittanz YAp = GGp + j*BAp und YAn = Gan + j*Ban YAp/Y0= yAp = gAp + j*bAp und YAn = yAn = gAn + j*bAn

genormter reeller Bezugswiderstand Z0 = 1/Y0

Antennenabstand d

Verkopplung: Antennen-Anschlusstore, Streuparameter S2a2b_dB

Verkopplung: Entkoppelnetzwerk- Anschlusstore, Streuparameter S4a4b_dB

Reflexionsfaktor: Antennen-Anschlusstore, Streuparameter S2a2a_dB, S2b2b_dB

Reflexionsfaktor: Entkoppelnetzwerk- Anschlusstore, Streuparameter S4a4a_d B, S4b4b_d B

Blindleitwert zur Masse Bp

Infinitesimale Serieninduktivitäten dLp, dLn

Infinitesimale Massekapazität dCm

Infinitesimale Brückenkapazität dCb

verteilte Kapazität gegen Masse Cm' = dCm/dl

verteilten Kapazität der Leiter zueinander Cb' = dCb/dl

symmetrischer Leitungswellenleitwert *YLp* = 1/*ZLp*

antisymmetrischer Leitungswellenleitwert *YLn* = 1/*ZLn*

symmetrische Leitungs-Phasenkonstante $\dfrac{d\alpha p}{dl}$ = βp

antisymmetrische Leitungs-Phasenkonstante $\dfrac{d\alpha n}{dl}$ = βn

Freiraumwellenlänge $\lambda 0$

symmetrische Wellenlänge $\lambda p$

antisymmetrische Wellenlänge $\lambda n$

elektrischer Winkel $\alpha p$

elektrischer Winkel $\alpha n$

**Patentansprüche**

1.  Antennensystem (1) mit zwei linearen, einander gleichen, gegenseitig strahlungsgekoppelten zueinander symmetrisch angeordneten Antennen (1a, 1b) mit jeweils einem Antennen-Anschlusstor (2a, 2b) und einem an die Antennen-Anschlusstore (2a, 2b) eingangsseitig angeschlossenen und aus Blindelementen gebildeten Netzwerk (3) mit jeweils einem, einander gleichen, einer Antenne (1a, 1b) gesondert zugeordneten Antennenpfad (5a, 5b) zu einem Netzwerk- Anschlusstor (4a, 4b), umfassend die folgenden Merkmale:

- jedes Antennen-Anschlusstor (2a, 2b) besteht jeweils aus einem gegen Masse spannungsführenden Anschlusspunkt (22a, 22b) und einem Masse-Anschlusspunkt (6), welcher mit einer für alle Anschlusstore (2a, 2b, 4a, 4b) gemeinsamen Masse (6) verbunden ist;
- jeder spannungsführende Anschlusspunkt (22a, 22b) eines Antennen-Anschlusstors (2a, 2b) ist jeweils mit dem spannungsführenden Anschlusspunkt (39a, 39b) des entsprechenden Netzwerk-Anschlusstors (4a, 4b) eines Antennenpfades (5a, 5b) durch einen linearen elektrischen Leiter (8a, 8b) verbunden;
- zumindest längs der beiden linearen elektrischen Leiter (8a, 8b) ist eine in einem Masse-Abstand (12) flächig gestaltete Massefläche (5) vorhanden;
- die beiden elektrischen Leiter (8a, 8b) sind zumindest über eine gemeinsame Länge l (10) sowohl in einem Leiterabstand (11) parallel zueinander als auch in dem Masse-Abstand (12) parallel zur Massefläche (9) geführt, sodass durch die beiden linearen elektrischen Leiter (8a, 8b) jeweils sowohl eine auf die Masse (6) bezogene symmetrische elektrische Leitung (13) als auch zwischen den beiden linearen elektrischen Leitern (8a, 8b) eine aufeinander bezogene antisymmetrische elektrische Leitung (14) und somit eine gekoppelte elektrische Leitung (15) gebildet ist;
- ein bei gleichsinniger Erregung der gekoppelten elektrischen Leitung (15) vorliegender Wellenwiderstand ZLp und ein elektrischer Winkel αp sowie ein bei gegensinniger Erregung der gekoppelten elektrischen Leitung (15) vorliegender Wellenwiderstand ZLn und ein elektrischer Winkel αn sind in der Weise gestaltet, dass bei mindestens einer Frequenz f1 die zwischen den Netzwerk-Anschlusstoren (4a, 4b) bestehende Verkopplung (S4a4b) durch den Einsatz des Netzwerks (3) wesentlich kleiner ist als die zwischen den entsprechenden Antennen-Anschlusstoren (2a, 2b) bestehende Verkopplung (S2a2b),
- **dadurch gekennzeichnet, dass**
das Antennensystem (1) an den Antennen-Anschlusstoren (2a, 2b) bei der mindestens einen Frequenz f1 reelle Admittanzen GAp und GAn aufweist, sodass YAp = GAp und YAn = GAn gilt und eine Entkopplung der beiden Netzwerk- Anschlusstore (4a, 4b) und eine Admittanzanpassung ($S_{4a4a}$=0, $S_{4b4b}$ =0) der beiden Netzwerk-Anschlusstore (4a, 4b) an eine genormte Admittanz Y0 dadurch hergestellt sind, dass sowohl der elektrische Winkel αp = 2π ∗ l/λp der symmetrischen Leitung (13) als auch der elektrische Winkel αn = 2π ∗ l/λn der antisymmetrischen Leitung (14) jeweils αp = αn = 90° betragen und der Leitungswellenleitwert der symmetrischen Leitung (13) als $YLp = \sqrt{GAp * Y0}$ und der Leitungswellenleitwert der antisymmetrischen Leitung (14) als

$$YLn = \sqrt{GAn * Y0}$$ gewählt sind, wobei λp und λn die Wellenlängen der symmetrischen und der antisymmetrischen Wellen beschreiben und gleich groß eingestellt sind.

2. Antennensystem (1) nach Anspruch 1,
**dadurch gekennzeichnet, dass**
von dem Antennensystem (1) zur Gestaltung des Zusammenwirkens mit der gekoppelten elektrischen Leitung

• die Admittanz YAp =GAp + jBAp an einem der Antennen-Anschlusstore (2a, 2b), welche sich bei dessen Erregung mit einem Messsignal und bei gleichzeitiger Erregung des anderen Antennen - Anschlusstors (2a, 2b) mit dem gleichen gleichsinnig polarisierten Messsignal einstellt und
• die Admittanz YAn =GAn + jBAn an einem der Antennen -Anschlusstore, die sich bei dessen Erregung mit einem Messsignal und bei gleichzeitiger Erregung des anderen Antennen - Anschlusstors (2a, 2b) mit dem gleichen jedoch gegensinnig polarisierten Messsignal einstellt, erfasst sind.

3. Antennensystem (1) nach Anspruch 1 oder 2,
**dadurch gekennzeichnet, dass**

zur Gestaltung des Zusammenwirkens in dem Antennensystem (1) die elektrischen Eigenschaften der an ihrem einen Ende von den Antennen-Anschlusstoren (2a, 2b) losgelösten gekoppelten elektrischen Leitung (15) der geometrischen Länge l (10) anhand folgender am anderen Ende der gekoppelten elektrischen Leitung (15), also an den Netzwerk-Anschlusstoren (4a, 4b) vorliegenden Blindleitwerte
zum einen bei Kurzschluss beider Leiter mit Masse (6) an dem einen Ende erfasst und eingestellt sind

- diese sind -

• Blindleitwert Bkp an einem der Netzwerk-Anschlusstore (4a, 4b) bei dessen Erregung mit einem Messsignal und bei gleichzeitiger Erregung des anderen Netzwerk- Anschlusstors (4a, 4b) mit dem gleichen gleichsinnig polarisierten Messsignal,
• Blindleitwert Bkn an einem der Netzwerk-Anschlusstore (4a, 4b) bei dessen Erregung mit einem Messsignal und bei gleichzeitiger Erregung des anderen Netzwerk- Anschlusstors (4a, 4b) mit dem gleichen jedoch gegensinnig polarisierten Messsignal,

und zum anderen anhand folgender Blindleitwerte, welche bei Leerlauf beider Leiter an dem einen Ende der gekoppelten elektrischen Leitung (15) erfasst und eingestellt sind
- diese sind -

• Blindleitwert Blp an einem der Netzwerk-Anschlusstore (4a, 4b) bei dem gleichen gleichsinnig polarisierten Messsignal,
• Blindleitwert Bln an einem der Netzwerk-Anschlusstore (4a, 4b) bei dessen Erregung mit einem Messsignal und bei gleichzeitiger Erregung des anderen Netzwerk- Anschlusstors (4a, 4b) mit dem gleichen jedoch gegensinnig polarisierten Messsignal,

und daraus die reelle Leitungswellenadmittanz YLp der gleichsinnig erregten elektrischen Leitung (13) und deren elektrischer Winkel $\alpha p$ sowie die reelle Leitungswellenadmittanz YLn der gegensinnig erregten elektrischen Leitung (14) und deren elektrischer Winkel $\alpha p$ und $\alpha n$ anhand folgender Beziehungen gesondert ermittelt und eingestellt sind

$$YLp = \sqrt{-Bkp * Blp} \quad \text{und} \quad YLn = \sqrt{-Bkn * Bln}$$

$$\alpha p = arc\,tan(\sqrt{-Blp/Bkp})\,; \quad \alpha n = arc\,tan(\sqrt{-Bln/Bkn}).$$

4. Antennensystem (1) nach Anspruch 1, 2 oder 3,
   **dadurch gekennzeichnet, dass**
   an beiden Netzwerk-Anschlusstoren (4a, 4b) bei der mindestens einen Frequenz f1 Impedanzanpassung an den in der Technik genormten reellen Widerstand Z0 = 1/Y0 dadurch besteht, dass die Struktur und die Länge I (10) der gekoppelten elektrischen Leitung (15) in der Weise gestaltet sind, dass sowohl die auf Y0 bezogene Leitungswellenadmittanz yLp = YLp/YO der symmetrischen elektrischen Leitung (13) und deren elektrischer Winkel $\alpha p$ als auch die entsprechende auf Y0 bezogene Leitungswellenadmittanz yLn = YLn/YO der antisymmetrischen elektrischen Leitung (14) und deren elektrischer Winkel $\alpha n$ gemäß den nachfolgenden Beziehungen gebildet sind, welche durch die auf Y0 bezogenen Admittanzen YAp/YO und YAn/YO des Antennensystem (1) an den Antennen-Anschlusstoren (2a, 2b) vorgegeben sind, wobei gilt:

$$yAp = \frac{YAp}{Y0} = gAp + j * bAp; \quad \text{und} \quad yAn = \frac{YAn}{Y0} = gAn + j * bAn;$$

$$YLp/Y0 = yLp = \sqrt{\frac{|yAp|^2 - gAp}{gAp - 1}}; \qquad \alpha p = arc\,tan(\frac{1 - gAp}{bAp} \bullet yLp)$$

$$YLn/Y0 = yLn = \sqrt{\frac{|yAn|^2 - gAn}{gAn - 1}}\,; \qquad \alpha n = arc\,tan(\frac{1 - gAn}{bAn} \bullet yLn)$$

mit $j^2$ = -1.

5. Antennensystem (1) nach einem der Ansprüche 1 bis 3,

**dadurch gekennzeichnet, dass**

bei der mindestens einen Frequenz f1 an jeweils einem der beiden Netzwerk-Anschlusstore (4a, 4b) sowohl bei gleichsinniger als auch bei gegensinniger Erregung am jeweils anderen Netzwerk-Anschlusstor (4a, 4b) die gleiche auf Y0 bezogene vorgegebene Admittanz

$$\frac{YNp}{Y0} = \frac{YNn}{Y0} = \frac{YN}{Y0} = yN = gN + j \bullet bN$$

dadurch gegeben ist, dass für die symmetrische Leitung (13) die auf Y0 bezogene Leitungswellenadmittanz $\frac{YLp}{Y0}$ entsprechend

$$YLp/Y0 = yLp = \sqrt{\frac{gN \bullet |yAp|^2 - gAp \bullet |yN|^2}{gAp - gN}}$$

und der elektrische Winkel in Grad entsprechend

$$\alpha p = 180/\pi \bullet arc\,tan(\frac{gN - gAp}{gN \bullet bAp + bN \bullet gAp} \bullet yLp)$$

sowie für die antisymmetrischen Leitung (14) die auf Y0 bezogene Leitungswellenadmittanz YLn entsprechend

$$YLn/Y0 = yLn = \sqrt{\frac{gN \bullet |yAn|^2 - gAn \bullet |yN|^2}{gAn - gN}}$$

und der elektrische Winkel entsprechend

$$\alpha n = 180/\pi \bullet arc\,tan(\frac{gN - gAn}{gN \bullet bAn + bN \bullet gAn} \bullet yLn)$$

gewählt sind, wodurch Entkopplung der beiden Netzwerk-Anschlusstore (4a, 4b) am Ende der gekoppelten Leitung (15) erreicht ist.

6. Antennensystem (1) nach Anspruch 5,
   **dadurch gekennzeichnet, dass**
   zur Erreichung der Impedanzanpassung der Netzwerk-Anschlusstore (4a, 4b) an die genormte Admittanz Y0 für die mindestens eine Frequenz f1 zwischen jedem der beiden voneinander entkoppelten Enden der gekoppelten elektrischen Leitung - den Leitungs- Anschlusstoren (4a', 4b') - und dem entsprechenden Entkoppel-Netzwerk-Anschlusstor (4a, 4b) ein einander gleiches Ausgangs-Anpassnetzwerk (25) zur Transformation der jeweils an den Leitungs- Anschlusstoren (4a', 4b') der gekoppelten elektrischen Leitung (15) vorliegenden Admittanz in die genormte Admittanz Y0 eingefügt ist.

7. Antennensystem (1) nach Anspruch 5 oder 6,
   **dadurch gekennzeichnet, dass**
   zwischen jedem der beiden Antennen-Anschlusstore (2a, 2b) und dem Anschluss an den entsprechenden Leiter (8a,8b) der gekoppelten elektrischen Leitung (15) ein einander gleiches Antennen-Anpassnetzwerk (24a, 24b) geschaltet ist, durch welches die an beiden Anschlusstoren (2a, 2b) vorliegenden Antennen-Admittanzen YAp bzw. YAn bei der mindestens einen Frequenz f1 jeweils in eine reelle Admittanz GAp bzw. GAn transformiert ist und die gekoppelte elektrische Leitung (15) in der Weise gestaltet ist, dass die Leitungswellenadmittanz der symmetrischen elektrischen Leitung (13) $YLp = \sqrt{GAp \bullet Y0}$ und ihr elektrischer Winkel $\alpha p = \frac{l}{\lambda p} * 360 = 90°$ betragen und die Leitungswellenadmittanz der antisymmetrischen elektrischen Leitung (14) $YLn = \sqrt{GAn \bullet Y0}$ und ihr elektrischer Winkel $\alpha n = \frac{l}{\lambda n} * 360 = 90°$ betragen.

**8.** Antennensystem (1) nach Anspruch 7,
**dadurch gekennzeichnet, dass**
zur Erreichung der reellen Admittanzen GAp und GAn jedes Antennen-Anpassnetzwerk (24a,24b) aus einem parallel zum Antennen-Anschlusstor (2a, 2b) geschalteten Parallelzweipol mit Blindleitwert Bp aus mindestens einem Blindelement und einem in Serie geschalteten Serienzweipol mit Blindwiderstand Xs aus mindestens einem Blindelement gebildet ist, wobei Bp/Y0 bzw. Xs/Z0 bei der mindestens einen Frequenz f1 zur Erfüllung der Forderung YAp = GAp bzw. YAn = GAn folgende alternative Werte besitzen

$$bp = Bp/Y0 = \frac{|zAn|^2 - |zAp|^2}{2 * (xAp * |zAn|^2 - xAn * |zAp|^2)}$$
$$* \left[1 \pm \sqrt{1 - \frac{4 \cdot (xAp * |zAn|^2 - xAn * |zAp|^2) * (xAn - xAp)}{(|zAp|^2 - |zAn|^2)^2}}\right]$$

und

$$xs = Xs/Z0 = \frac{|zAn|^2 - |zAp|^2}{2 * (xAp * |zAn|^2 - xAn * |zAp|^2)}$$

wobei gilt:

$$zAp = rAp + j \bullet xAp = \frac{ZAp}{Z0} = \frac{Y0}{YAp} \quad und \quad zAn = rAn + j \bullet xAn = \frac{ZAn}{Z0} = \frac{Y0}{YAn}.$$

**9.** Antennensystem (1) nach Anspruch 8,
**dadurch gekennzeichnet, dass**
in jedem Antennen-Anpassnetzwerk (24a, 24b) in der ersten der alternativen Kombinationen der Parallelzweipol mit Blindleitwert Bp als ein kapazitves Bauelement mit Kapazität Cp und der Serienzweipol mit Blindwiderstand Xs als ein induktives Bauelement mit Induktivität Ls ausgeführt oder in der zweiten der alternativen Kombinationen der Parallelzweipol mit Blindleitwert Bp als ein induktives Bauelement mit Induktivität Lp und der Serienzweipol mit Blindwiderstand Xs als kapazitves Bauelement mit Kapazität Cs mit Induktivität Ls ausgeführt ist.

**10.** Antennensystem (1) nach einem der vorstehenden Ansprüche 8 oder 9,
**dadurch gekennzeichnet, dass**
zur Erweiterung des Frequenzbereichs um die mindestens eine Frequenz f1 als Mittenfrequenz in welchem sowohl eine Verbesserung der Entkopplung zwischen den Netzwerk-Anschlusstoren (4a, 4b) als auch eine verbesserte Impedanzanpassung an den Normwiderstand Z0 dadurch erreicht ist, dass der Parallelzweipol als Parallelresonanzkreis und der Serienzweipol als Serienresonanzkreis in den Antennen-Anpassnetzwerken (24a, 24b) ausgeführt ist.

**11.** Antennensystem (1) nach Anspruch 10,
**dadurch gekennzeichnet, dass**
das Antennen-Anpassnetzwerk (24a, 24b) in der Weise gestaltet ist, dass der frequenzabhängige Verlauf der transformierten Antennenimpedanz ZAp = 1/YAp bzw. ZAn = 1/YAn in der komplexen Impedanzebene mit wachsender Frequenz den reellen Widerstandswert RAp =1/GAp bzw. RAn =1/GAn jeweils mit kleiner Abweichung zumindest teilweise umschlingt und der Widerstandswert RAp bzw. RAn durch die Transformation mit der gekoppelten elektrischen Leitung (15) in den Bezugswiderstand Z0 an den Netzwerk-Anschlusstoren (4a, 4b) sowohl die Entkopplung als auch die Impedanzanpassung über einen größeren Frequenzbereich um die Frequenz f1 verbessert ist.

12. Antennensystem (1) nach Anspruch 11,
**dadurch gekennzeichnet, dass**
zur Vergrößerung des Frequenzbereichs mit verbesserter Entkopplung zwischen den Netzwerk-Anschlusstoren (4a, 4b) um die mindestens eine Frequenz f1 ausgehend von einer Realisierung der einander gleichen Antennen-Anschlussnetzwerke (24a, 24b) nach einer Dimensionierung der beiden Zweipole aus Blindelementen in Anspruch 8 diese ergänzt sind zu jeweils einem parallel geschalteten Parallelresonanzkreis (7a) und einem in Serie geschalteten Serienresonanzkreis (7b).

13. Antennensystem (1) nach Anspruch 12,
**dadurch gekennzeichnet, dass**
zur Vergrößerung des Frequenzbereichs um die mindestens eine Frequenz f1 mit verbesserter Entkopplung und verbesserter Impedanzanpassung in einem Frequenzbereich um die Frequenz f1 an den Netzwerk-Anschlusstoren (4a, 4b) das Ausgangs-Anpassnetzwerk (25a, 25b) jeweils mindestens einen Parallelresonanzkreis (7a) und einen Serienresonanzkreis (7b) enthält, welche in der Weise gestaltet sind, dass sowohl die Impedanz ZNp als auch die Impedanz ZNn an den Netzwerk-Anschlusstoren (4a, 4b) in ihrem Verlauf in der komplexen Impedanzebene mit wachsender Frequenz die genormte Impedanz Z0 in kleinem Abstand umschlingen.

14. Antennensystem (1) nach einem der vorstehenden Ansprüche 1 bis 13,
**dadurch gekennzeichnet,**

**dass** die elektrischen Eigenschaften der gekoppelten elektrischen Leitung (15) individuell durch Gestaltung der über die Leiterlänge l (10) verteilten Kapazitäten Cm' = $\Delta$Cm/$\Delta$l der einzelnen elektrischen Leiter (8a, 8b) gegen Masse und Cb' = $\Delta$Cb/$\Delta$l der einzelnen Leiter zueinander sowie die verteilten Induktivitäten Lp' = $\Delta$Lp/$\Delta$l für gleichsinnigen Stromfluss in den der beiden Leitern und die verteilten Induktivitäten Ln' = $\Delta$Ln/$\Delta$l für gegensinnigen Stromfluss in den in den beiden Leitern in der Weise eingestellt sind, dass die geforderten Werte für den

Leitungswellenleitwert $\quad YLp = \dfrac{1}{ZLp} = \sqrt{Cm`/Lp`}\quad$ und für den elektrischen Winkel pro Längeneinheit

$$\frac{d\alpha p}{dl} = \beta p = 2\pi * f1 * \sqrt{Lp` * Cm`}$$ der symmetrischen elektrischen Leitung (13)

und die geforderten Werte für den Leitungswellenwiderstand

$$YLn = \frac{1}{ZLn} = \sqrt{(Cm` + 2 * Cb`)/Ln`}$$

und für den elektrischen Winkel pro Längeneinheit

$$\frac{d\alpha n}{dl} = \beta n = 2\pi * f1 * \sqrt{(Cm` + 2 * Cb`) * Ln`}$$

der antisymmetrischen elektrischen Leitung (14) erreicht sind.

15. Antennensystem (1) nach Anspruch 14,
**dadurch gekennzeichnet, dass**
die gekoppelte elektrische Leitung (15) als Mikrostreifenleitung mit Leiterstreifen (17) auf einem permittiven Substrat (27) ausgeführt ist und eine Leiterbreite (26) unter Berücksichtigung der Permittivitätszahl des Substrats (27) zur Erreichung der gewünschten Kapazitätsbelegung Cm' und der Induktivitätsbelegung Lp' zur Gestaltung der Leitungswellenadmittanz YLp und der Phasenkonstanten $\beta$p entsprechend gewählt sind und der Leiterabstand (11) zur Gestaltung der Kapazitätsbelegung Cb' und - unter Wirkung der Belegung der Koppelinduktivität M' - die Induktivitätsbelegung Ln' in der Weise gewählt sind, dass die geforderte Leitwellenadmittanz YLn und die Phasenkonstante βn eingestellt sind.

16. Antennensystem (1) nach einem der vorstehenden Ansprüche 1 bis 15,
**dadurch gekennzeichnet, dass**
jede der einander gleichen Antennen (1a, 1b) als eine mit einem ihrer Fußpunkt-Anschlüsse (2a',2b') mit Masse (6) verbundene Monopol-Antenne (1a, 1b) gebildet ist, welche zur Überbrückung des Antennenabstands d mit dem zugehörigen Antennen-Anschlusstor (2a, 2b) über ein jeweils gleiches kurzes elektrisches masse-unsymmetrisches Leitungsstück 35 verbunden ist.

17. Antennensystem (1) nach einem der vorstehenden Ansprüche 1 bis 16,
**dadurch gekennzeichnet, dass**
jede der einander gleichen Antennen (1a, 1b) jeweils als eine symmetrisch zur Masse (6) gestaltete Dipol-Antenne (1a', 1b') gebildet ist, deren massesymmetrisches Anschlusstor (2a', 2b') jeweils mit dem zugeordneten Antennen-Anschlusstor (2a, 2b) über eine jeweils gleiche Umsymmetrierungsanordnung (34) mit kurzer masse-symmetrischer Eingangs- und masse-unsymmetrischer Ausgangsleitung zur Überbrückung des Antennenabstands d und zur Umsymmetrierung des masse-symmetrischen Dipol- Anschlusstors (2a',2b') hin zum masse-unsymmetrischen Antennen-Anschlusstor (2a, 2b) verbunden ist.

18. Antennensystem (1) nach einem der vorstehenden Ansprüche 1 bis 17,
**dadurch gekennzeichnet, dass**
die beiden linearen elektromagnetisch gekoppelten Leiter (8a, 8b) des Netzwerks (3) mit ihren aufeinanderfolgenden infinitesimalen Leitungsstücken der Länge dl, bestehend aus den infinitesimalen Blindelementen dLp = dLn, dCm, dCb der symmetrischen gekoppelten Leitung (15), ersetzt sind durch aufeinanderfolgende, entsprechend den Leitungsstücken jedoch aus diskreten Blindelementen bestehenden Schaltungsstufen S1, S2,.. endlicher Anzahl, worin anstelle der infinitesimalen Blindelemente dLp, dLn, dCm und dCb diesen entsprechende diskrete Bauelemente mit der Induktivität ΔLp = ΔLs (36), der Brücken-Kapazität ΔCb (38) und der Masse-Kapazität ΔCm (37) eingesetzt sind und die Werte der diskreten Bauelement in der Weise gewählt sind, dass die Entkopplung der Netzwerk-Anschlusstore (4a, 4b) bei einer hinreichend niedrigeren Frequenz f1 als der Grenzfrequenz ftn eingestellt ist.

19. Antennensystem (1) nach Anspruch 18,
**dadurch gekennzeichnet, dass**
die diskreten Blindelemente (36, 37, 38) jeweils durch eine zweipolige diskrete Blindelemente-Schaltung (43, 44, 45) in der Weise ersetzt sind, dass bei der Entkopplungsfrequenz f1 jeweils gilt:

die Anstelle der Induktivität ΔLp, ΔLs (36) seriell eingesetzte Blindelementschaltung (43) ist induktiv und besitzt den gleichen Blindwiderstandswert wie die Induktivität ΔLp, ΔLs (36);
die Anstelle der Brücken-Kapazität ΔCb (38) eingesetzte Brücken-Blindelementschaltung (45) ist kapazitiv und besitzt den gleichen Blindwiderstandswert wie die Brücken-Kapazität ΔCb (38);
die Anstelle der Masse-Kapazität ΔCm (37) eingesetzte Masse-Blindelementschaltung (44) ist kapazitiv und besitzt den gleichen Blindwiderstandswert wie die Masse-Kapazität ΔCm (37).

20. Antennensystem (1) nach einem der vorstehenden Ansprüche 18 oder 19,
**dadurch gekennzeichnet, dass**
im Netzwerk (3) mindestens zwei Stufen S1, S2.. gebildet sind, durch deren erste Stufe S1 im Zusammenwirken von der induktiven Serien-Blindelementschaltung (43) mit der zweipoligen Brücken-Blindelementschaltung (45) die Entkopplung am Netzwerk- Anschlusstor (4a, 4b) für die Frequenz f1 auch dadurch gegeben ist, dass in der Serien-Blindelementschaltung (43') der zweiten Stufe S2 ein für diese Frequenz f1 durchlässiger serieller Serienresonanzkreis (46) und in der Brücken-Blindelementschaltung (45') ein für diese Frequenz f1 sperrender serieller Parallel-Resonanzkreis (47) vorhanden ist und die Entkopplung am Netzwerk-Anschlusstor (4a, 4b) bei einer weiteren Frequenz f2 durch Abstimmung der Serien-Blindelementschaltung (43') und der Brücken-Blindelementschaltung (45') gegeben ist.

21. Antennensystem (1) nach Anspruch 18, 19 oder 20,
**dadurch gekennzeichnet, dass**

das als Tiefpassstruktur gestaltete Netzwerk (3) jedoch dual hierzu als Hochpassstruktur realisiert ist, wofür die Induktivität ΔLp = ΔLs (36) durch die Serienkapazität ΔCs (42),

die Brücken-Kapazität ΔCb (38) durch Brücken-Induktivität ΔLm (41)
und die Masse-Kapazität ΔCm (37) durch die Masse-Induktivität ΔLm (40) ersetzt sind, und die Größen der Serienkapazität ΔCs (42), der Masse-Kapazität ΔCm (37) und der Masse-Induktivität ΔLm (40) gemäß den unter Anwendung der Dualitätsbildungsregeln durch duale Transformation der Tiefpassstruktur-Elemente gewonnenen Hochpassstruktur-Elementen gewählt sind,
und die Werte der diskreten Bauelemente in der Weise gewählt sind, dass die Entkopplung der Netzwerk-Anschlusstore (4a, 4b) bei einer hinreichend höheren Frequenz f1 als der Grenzfrequenz fhp eingestellt ist.

## Claims

1. An antenna system (1) comprising two linear, mutually identical, mutually radiation coupled antennas (1a, 1b) arranged symmetrically with respect to one another, said antennas (1a, 1b) having a respective antenna connection gate (2a, 2b) and a network (3), which is connected at the input side to the antenna connection gates (2a, 2b) and which is formed from dummy elements, and having a respective antenna path (5a, 5b) to a network connection gate (4a, 4b), said antenna paths (5a, 5b) being identical to one another and being separately associated with an antenna (1a, 1b), the antenna system (1) comprising the following features:

   - each antenna connection gate (2a, 2b) in each case consists of a connection point (22a, 22b) live to ground and a ground connection point (6) which is connected to a common ground (6) for all the connection gates (2a, 2b, 4a, 4b);
   - each live connection point (22a, 22b) of an antenna connection gate (2a, 2b) is in each case connected to the live connection point (39a, 39b) of the corresponding network connection gate (4a, 4b) of an antenna path (5a, 5b) by a linear electrical conductor (8a, 8b);
   - a ground plane (5) areally designed at a ground spacing (12) is at least present along the two linear electrical conductors (8a, 8b);
   - the two electrical conductors (8a, 8b) are guided at least over a common length l (10), both at a conductor spacing (11) in parallel with one another and at the ground spacing (12) in parallel with the ground plane (9), so that, due to the two linear electrical conductors (8a, 8b), in each case both a symmetrical electrical line (13) related to the ground (6) is formed and, between the two linear electrical conductors (8a, 8b), an antisymmetrical electrical line (14) related to one another is formed, thereby forming a coupled electrical line (15);
   - a wave impedance ZLp that is present upon an excitation of the coupled electrical line (15) in the same direction and an electrical angle αp as well as a wave impedance ZLn present on an excitation of the coupled electrical line (15) in the opposite direction and an electrical angle an are designed such that, at at least one frequency f1, the coupling (S4a4b) present between the network connection gates (4a, 4b) is substantially smaller, due to the use of the network (3), than the coupling (S2a2b) present between the corresponding antenna connection gates (2a, 2b),
   - **characterized in that**

      the antenna system (1) has real admittances GAp and GAn at the antenna connection gates (2a, 2b) at the at least one frequency f1 so that YAp = GAp and YAn = GAn applies and a decoupling of the two network connection gates (4a, 4b) and an admittance matching ($S_{4a4a}$=0, $S_{4b4b}$ =0) of the two network connection gates (4a, 4b) to a standardized admittance Y0 are established **in that** both the electrical angle $\alpha p = 2\pi * l / \lambda p$ of the symmetrical line (13) and the electrical angle $\alpha n = 2\pi * l / \lambda n$ of the antisymmetrical line (14) each amount to αp = αn = 90° and the line wave conductance of the symmetrical line (13) is selected as

      $$YLp = \sqrt{GAp * Y0}$$

      and the line wave conductance of the antisymmetrical line (14) is selected as

      $$YLn = \sqrt{GAn * Y0},$$ , wherein

      λp and λn describe the wavelengths of the symmetrical and the antisymmetrical waves and are set as equal.

2. An antenna system (1) according to claim 1,
   **characterized in that**,
   to design the cooperation with the coupled electrical line,

      • the admittance YAp =GAp + jBAp at one of the antenna connection gates (2a, 2b), which admittance is present on the excitation of said one antenna connection gate (2a, 2b) with a measurement signal and on a simultaneous excitation of the other antenna connection gate (2a, 2b) with the same measurement signal polarized in the same sense, and
• the admittance YAn =GAn + jBAn at one of the antenna connection gates, which admittance is present on the excitation of said one antenna connection gate with a measurement signal and on a simultaneous excitation of the other antenna connection gate (2a, 2b) with the same but oppositely polarized measurement signal, are detected by the antenna system (1).

3. An antenna system (1) according to claim 1 or 2,
**characterized in that**,

to design the cooperation in the antenna system (1), the electrical properties of the coupled electrical line (15), which is released at its one end from the antenna connection gates (2a, 2b) and which has the geometric length l (10), are detected and set based on the following susceptances present at the other end of the coupled electrical line (15), i.e. at the network connection gates (4a, 4b),
on the one hand, in the case of a short-circuit of both conductors with ground (6) at the one end,

- these are -

• susceptance Bkp at one of the network connection gates (4a, 4b) on its excitation with a measurement signal and on a simultaneous excitation of the other network connection gate (4a, 4b) with the same measurement signal polarized in the same sense,
• susceptance Bkn at one of the network connection gates (4a, 4b) on its excitation with a measurement signal and on a simultaneous excitation of the other network connection gate (4a, 4b) with the same but oppositely polarized measurement signal,

and, on the other hand, based on the following susceptances which are detected and set in an open-circuit operation of both conductors at the one end of the coupled electrical line (15)

- these are -

• susceptance Blp at one of the network connection gates (4a, 4b) with the same measurement signal polarized in the same sense,
• susceptance Bln at one of the network connection gates (4a, 4b) on its excitation with a measurement signal and on a simultaneous excitation of the other network connection gate (4a, 4b) with the same but oppositely polarized measurement signal,

and, from this, the real line wave admittance YLp of the electrical line (13) excited in the same direction and the electrical angle $\alpha p$ of said electrical line (13) as well as the real line wave admittance YLn of the electrical line (14) excited in the opposite direction and the electrical angles $\alpha p$ and $\alpha n$ of said electrical line (14) are separately determined and set based on the following relationships

$$YLp = \sqrt{-Bkp * Blp} \quad \text{and} \quad YLn = \sqrt{-Bkn * Bln}$$

$$\alpha p = arc\,tan(\sqrt{-Blp/Bkp})\,; \quad \alpha n = arc\,tan(\sqrt{-Bln/Bkn}).$$

4. An antenna system (1) according to claim 1, 2 or 3,
**characterized in that**,
at both network connection gates (4a, 4b) at the at least one frequency f1, there is an impedance matching to the real resistance Z0 = 1/Y0 standardized in technology **in that** the structure and the length l (10) of the coupled electrical line (15) are designed such that both the line wave admittance yLp = YLp/Y0, related to Y0, of the symmetrical electrical line (13) and the electrical angle $\alpha p$ of said symmetrical electrical line (13) and the corresponding line wave admittance yLn = YLn/Y0, related to Y0, of the antisymmetrical electrical line (14) and the electrical angle $\alpha n$ of said antisymmetrical electrical line (14) are formed in accordance with the following relationships which are predefined by the admittances YAp/Y0 and YAn/Y0, related to Y0, of the antenna system (1) at the antenna connection gates (2a, 2b), wherein it applies:

$$yAp = \frac{YAp}{Y0} = gAp + j * bAp; \quad \text{and} \quad yAn = \frac{YAn}{Y0} = gAn + j * bAn;$$

$$YLp/Y0 = yLp = \sqrt{\frac{|yAp|^2 - gAp}{gAp - 1}}; \quad \alpha p = arc\, tan(\frac{1 - gAp}{bAp} \bullet yLp)$$

$$YLn/Y0 = yLn = \sqrt{\frac{|yAn|^2 - gAn}{gAn - 1}}; \quad \alpha n = arc\, tan(\frac{1 - gAn}{bAn} \bullet yLn)$$

where $j^2 = -1$.

5. An antenna system (1) according to any one of the claims 1 to 3, **characterized in that**,

at the at least one frequency f1 at a respective one of the two network connection gates (4a, 4b), both on an excitation in the same direction and on an excitation in the opposite direction at the respective other network connection gate (4a, 4b), the same predefined admittance

$$\frac{YNp}{Y0} = \frac{YNn}{Y0} = \frac{YN}{Y0} = yN = gN + j \bullet bN$$

related to Y0 is given **in that**, for the symmetrical line (13), the line wave admittance $\frac{YLp}{Y0}$ related to Y0 in accordance with

$$YLp/Y0 = yLp = \sqrt{\frac{gN \bullet |yAp|^2 - gAp \bullet |yN|^2}{gAp - gN}}$$

and the electrical angle in degrees in accordance with

$$\alpha p = 180/\pi \bullet arc\, tan(\frac{gN - gAp}{gN \bullet bAp + bN \bullet gAp} \bullet yLp)$$

are selected and, for the antisymmetrical line (14), the line wave admittance YLn related to Y0 in accordance with

$$YLn/Y0 = yLn = \sqrt{\frac{gN \bullet |yAn|^2 - gAn \bullet |yN|^2}{gAn - gN}}$$

and the electrical angle in accordance with

$$\alpha n = 180/\pi \bullet arc\, tan(\frac{gN - gAn}{gN \bullet bAn + bN \bullet gAn} \bullet yLn)$$

are selected, whereby a decoupling of the two network connection gates (4a, 4b) at the end of the coupled line (15) is achieved.

6. An antenna system (1) according to claim 5,

**characterized in that**,

to achieve the impedance matching of the network connection gates (4a, 4b) to the standardized admittance Y0 for the at least one frequency f1, a mutually identical output matching network (25) for transforming the admittance, which is in each case present at the line connection gates (4a', 4b') of the coupled electrical line (15), into the standardized admittance Y0 is inserted between each of the two mutually decoupled ends of the coupled electrical line - the line connection gates (4a', 4b') - and the corresponding decoupling network connection gate (4a, 4b).

7. An antenna system (1) according to claim 5 or 6,
   **characterized in that**,
   between each of the two antenna connection gates (2a, 2b) and the connection to the corresponding conductor (8a, 8b) of the coupled electrical line (15), a mutually identical antenna matching network (24a, 24b) is connected by which the antenna admittances YAp and YAn respectively, which are present at the two connection gates (2a, 2b), are transformed at the at least one frequency f1 into a real admittance GAp or GAn in each case and the coupled electrical line (15) is designed such that the line wave admittance of the symmetrical electrical line (13) amounts to

   $$YLp = \sqrt{GAp \bullet Y0}$$ and the electrical angle of said symmetrical electrical line (13) amounts to

   $$\alpha p = \frac{l}{\lambda p} * 360 = 90°$$ and the line wave admittance of the antisymmetrical electrical line (14) amounts to $$YLn = \sqrt{GAn \bullet Y0}$$ and the electrical angle of said antisymmetrical electrical line (14) amounts to

   $$\alpha n = \frac{l}{\lambda n} * 360 = 90°$$ .

8. An antenna system (1) according to claim 7,
   **characterized in that**,
   to achieve the real admittances GAp and GAn, each antenna matching network (24a, 24b) is formed from a parallel two-terminal circuit, connected in parallel with the antenna connection gate (2a, 2b) and having a susceptance Bp from at least one dummy element, and a series two-terminal circuit connected in series and having a reactance Xs from at least one dummy element, wherein Bp/Y0 and Xs/Z0 respectively have the following alternative values at the at least one frequency f1 in order to satisfy the requirement YAp = GAp or YAn = GAn

   $$bp = Bp/Y0 = \frac{|zAn|^2 - |zAp|^2}{2 * (xAp * |zAn|^2 - xAn * |zAp|^2)}$$

   $$* \left[ 1 \pm \sqrt{1 - \frac{4 \cdot (xAp * |zAn|^2 - xAn * |zAp|^2) * (xAn - xAp)}{(|zAp|^2 - |zAn|^2)^2}} \right]$$

   and

   $$xs = Xs/Z0 = \frac{|zAn|^2 - |zAp|^2}{2 * (xAp * |zAn|^2 - xAn * |zAp|^2)}$$

   where it applies:

   $$zAp = rAp + j \bullet xAp = \frac{ZAp}{Z0} = \frac{Y0}{YAp} \quad and \quad zAn = rAn + j \bullet xAn = \frac{ZAn}{Z0} = \frac{Y0}{YAn}.$$

9. An antenna system (1) according to claim 8,
   **characterized in that**,
   in each antenna matching network (24a, 24b), in the first of the alternative combinations, the parallel two-terminal circuit having a susceptance Bp is designed as a capacitive component having a capacitance Cp and the series two-terminal circuit having a reactance Xs is designed as an inductive component having an inductance Ls or, in the second of the alternative combinations, the parallel two-terminal circuit having a susceptance Bp is designed as an inductive component having an inductance Lp and the series two-terminal circuit having a reactance Xs is designed as a capacitive component having a capacitance Cs with an inductance Ls.

10. An antenna system (1) according to one of the preceding claims 8 or 9,
**characterized in that**,
to extend the frequency range around the at least one frequency f1 as a center frequency in which both an improvement of the decoupling between the network connection gates (4a, 4b) and an improved impedance matching to the standard resistance Z0 are achieved **in that** the parallel two-terminal circuit is designed as a parallel resonant circuit and the series two-terminal circuit is designed as a series resonant circuit in the antenna matching networks (24a, 24b).

11. An antenna system (1) according to claim 10,
**characterized in that**
the antenna matching network (24a, 24b) is designed such that the frequency-dependent progression of the transformed antenna impedance ZAp = 1/YAp or Zan = 1/YAn in the complex impedance plane with an increasing frequency at least partly wraps around the real resistance value RAp =1/GAp or RAn =1/GAn with a small deviation in each case and the resistance value RAp or RAn is improved by the transformation with the coupled electrical line (15) into the reference resistance Z0 at the network connection gates (4a, 4b) as well as the decoupling and the impedance matching over a larger frequency range around the frequency f1.

12. An antenna system (1) according to claim 11,
**characterized in that**,
to increase the frequency range with an improved decoupling between the network connection gates (4a, 4b) around the at least one frequency f1, starting from a realization of the mutually identical antenna connection networks (24a, 24b) in accordance with a dimensioning of the two two-terminal circuits from dummy elements in claim 8, said two two-terminal circuits are supplemented in order in each case to form a parallel resonant circuit (7a) connected in parallel and a series resonant circuit (7b) connected in series.

13. An antenna system (1) according to claim 12,
**characterized in that**,
to increase the frequency range around the at least one frequency f1 with an improved decoupling and an improved impedance matching in a frequency range around the frequency f1 at the network connection gates (4a, 4b), the output matching network (25a, 25b) in each case includes at least one parallel resonant circuit (7a) and one series resonant circuit (7b) that are designed such that both the impedance ZNp and the impedance ZNn at the network connection gates (4a, 4b) in their progression in the complex impedance plane with an increasing frequency wrap around the standardized impedance Z0 at a small spacing.

14. An antenna system (1) according to any one of the preceding claims 1 to 13,
**characterized in that**

the electrical properties of the coupled electrical line (15) are individually set by the design of the capacitances Cm' = ΔCm/Δl, distributed over the conductor length l (10), of the individual electrical conductors (8a, 8b) to ground and

Cb' = ΔCb/Δl of the individual conductors with respect to one another as well as by the distributed inductances Lp' = ΔLp/Δl for a current flow in the same direction in the two conductors and the distributed inductances Ln' = ΔLn/Δl for a current flow in an opposite direction in the two conductors such that the required values for the line wave conductance

$$YLp = \frac{1}{ZLp} = \sqrt{Cm`/Lp`}$$

and for the electrical angle per unit length

$$\frac{d\alpha p}{dl} = \beta p = 2\pi * f1 * \sqrt{Lp` * Cm`}$$

of the symmetrical electrical line (13) and the required values for the line wave conductance

$$YLn = \frac{1}{ZLn} = \sqrt{(Cm` + 2 * Cb`)/Ln`}$$

and for the electrical angle per unit length

$$\frac{d\alpha n}{dl} = \beta n = 2\pi * f1 * \sqrt{(Cm` + 2 * Cb`) * Ln`}$$

of the antisymmetrical electrical line (14) are reached.

**15.** An antenna system (1) according to claim 14,
**characterized in that**
the coupled electrical line (15) is designed as a microstrip line comprising conductor strips (17) on a permittive substrate (27) and a conductor width (26) is selected accordingly, taking into account the permittivity of the substrate (27) for achieving the desired capacitance assignment Cm' and the inductance assignment Lp' to design the line wave admittance YLp and the phase constant $\beta p$, and the conductor spacing (11) for designing the capacitance assignment Cb' and - under the effect of the assignment of the coupling inductance M' - the inductance assignment Ln' are selected such that the required line wave admittance YLn and the phase constant $\beta n$ are set.

**16.** An antenna system (1) according to any one of the preceding claims 1 to 15,
**characterized in that**
each of the mutually identical antennas (1a, 1b) is formed as a monopole antenna (1a, 1b) which is connected to ground (6) with one of its nadir terminals (2a', 2b') and which, in order to bridge the antenna spacing d, is connected to the associated antenna connection gate (2a, 2b) via a respective identical short electrical ground-unsymmetrical line piece 35.

**17.** An antenna system (1) according to any one of the preceding claims 1 to 16,
**characterized in that**
each of the mutually identical antennas (1a, 1b) is in each case formed as a dipole antenna (1a', 1b') which is designed symmetrical to ground (6) and whose ground-symmetrical connection gate (2a', 2b') is in each case connected to the associated antenna connection gate (2a, 2b) via a respective identical re-balancing arrangement (34) having a short ground-symmetrical input line and a ground-unsymmetrical output line for bridging the antenna spacing d and for re-balancing the ground-symmetrical dipole connection gate (2a', 2b') with respect to the ground-unsymmetrical antenna connection gate (2a, 2b).

**18.** An antenna system (1) according to any one of the preceding claims 1 to 17,
**characterized in that**
the two linear electromagnetically coupled conductors (8a, 8b) of the network (3) with their consecutive infinitesimal line pieces of the length dl, consisting of the infinitesimal dummy elements dLp = dLn, dCm, dCb of the symmetrical coupled line (15), are replaced by consecutive circuit stages S1, S2,.. of a finite number that correspond to the line pieces, but consist of discrete dummy elements, wherein, instead of the infinitesimal dummy elements dLp, dLn, dCm and dCb, discrete components corresponding thereto and having the inductance $\Delta Lp = \Delta Ls$ (36), the bridge capacitance $\Delta Cb$ (38) and the ground capacitance $\Delta Cm$ (37) are used and the values of the discrete components are selected such that the decoupling of the network connection gates (4a, 4b) is set at a sufficiently lower frequency f1 than the cut-off frequency ftn.

**19.** An antenna system (1) according to claim 18,
**characterized in that**
the discrete dummy elements (36, 37, 38) are each replaced by a two-pole discrete dummy circuit (43, 44, 45) such that, at the decoupling frequency f1, it applies in each case:

the dummy circuit (43) used in series instead of the inductance $\Delta Lp$, $\Delta Ls$ (36) is inductive and has the same reactance value as the inductance $\Delta Lp$, $\Delta Ls$ (36);
the bridge dummy circuit (45) used instead of the bridge capacitance $\Delta Cb$ (38) is capacitive and has the same reactance value as the bridge capacitance ΔCb (38);
the ground dummy circuit (44) used instead of the ground capacitance ΔCm (37) is capacitive and has the same reactance value as the ground capacitance ΔCm (37).

**20.** An antenna system (1) according to one of the preceding claims 18 or 19,
**characterized in that**,
in the network (3), at least two stages S1, S2.. are formed by whose first stage S1, in the cooperation of the inductive series dummy circuit (43) with the two-pole bridge dummy circuit (45), the decoupling at the network connection gate (4a, 4b) for the frequency f1 is also given **in that** a serial series resonant circuit (46) which is permeable for this frequency f1 is present in the series dummy circuit (43') of the second stage S2 and a serial parallel resonant circuit (47) which is blocking for this frequency f1 is present in the bridge dummy circuit (45'), and the decoupling at the network connection gate (4a, 4b) at a further frequency f2 is given by a matching of the series dummy circuit (43') and the bridge dummy circuit (45').

**21.** An antenna system (1) according to claim 18, 19 or 20,
**characterized in that**

the network (3) designed as a low-pass structure is, however, realized dually thereto as a high-pass structure, for which purpose the
inductance ΔLp = ΔLs (36) is replaced by the series capacitance ΔCs (42),
the bridge capacitance ΔCb (38) is replaced by the bridge inductance ΔLm (41),
and the ground capacitance ΔCm (37) is replaced by the ground inductance ΔLm (40), and the magnitudes of the series capacitance ΔCs (42), of the ground capacitance ΔCm (37), and of the ground inductance ΔLm (40) are selected in accordance with the high-pass structure elements obtained by a dual transformation of the low-pass structure elements while applying the duality formation rules,
and the values of the discrete components are selected such that the decoupling of the network connection gates (4a, 4b) is set at a sufficiently higher frequency f1 than the cut-off frequency fhp.

**Revendications**

**1.** Système d'antennes (1) comprenant deux antennes linéaires (1a, 1b) identiques, disposées symétriquement l'une par rapport à l'autre et couplées mutuellement par rayonnement, ayant chacune une porte de connexion d'antenne (2a, 2b) et un réseau (3) connecté, côté entrée, aux portes de connexion d'antenne (2a, 2b), formé d'éléments réactifs et présentant un trajet d'antenne (5a, 5b) respectif identique vers une porte de connexion de réseau (4a, 4b), qui est attribué séparément à une antenne (1a, 1b), comprenant les éléments suivantes :

- chaque porte de connexion d'antenne (2a, 2b) se compose d'un point de connexion (22a, 22b) respectif sous tension par rapport à la masse et d'un point de connexion de masse (6) relié à une masse (6) commune à toutes les portes de connexion (2a, 2b, 4a, 4b) ;
- chaque point de connexion (22a, 22b) sous tension d'une porte de connexion d'antenne (2a, 2b) est relié au point de connexion (39a, 39b) respectif sous tension de la porte de connexion de réseau (4a, 4b) correspondante d'un trajet d'antenne (5a, 5b) par l'intermédiaire d'un conducteur électrique linéaire (8a, 8b) ;
- au moins le long des deux conducteurs électriques linéaires (8a, 8b), il existe un plan de masse (5) conçu de manière plane à une distance de masse (12) ;
- les deux conducteurs électriques (8a, 8b) sont menés, au moins sur une longueur commune l (10), aussi bien parallèlement l'un à l'autre à une distance de conducteur (11) que parallèlement au plan de masse (9) à une distance de masse (12), de sorte que les deux conducteurs électriques linéaires (8a, 8b) forment aussi bien une ligne électrique (13) symétrique par rapport à la masse (6) qu'une ligne électrique antisymétrique (14) entre les deux conducteurs électriques linéaires (8a, 8b), et donc une ligne électrique couplée (15) ;
- une impédance caractéristique ZLp et un angle électrique αp, présents lors de l'excitation dans le même sens de la ligne électrique couplée (15), ainsi qu'une impédance caractéristique ZLn et un angle électrique an, présents lors de l'excitation en sens opposé de la ligne électrique couplée (15), sont conçus de telle manière, qu'à au moins une fréquence f1, le couplage (S4a4b) existant entre les portes de connexion de réseau (4a, 4b) est considérablement plus petit que le couplage (S2a2b) existant entre les portes de connexion d'antenne (2a, 2b) correspondantes en raison de l'utilisation du réseau (3),
- **caractérisé en ce que**
le système d'antennes (1) présente, aux portes de connexion d'antenne (2a, 2b), à ladite au moins une fréquence f1, des admittances réelles GAp et GAn, de sorte que YAp = GAp et YAn = Gan, et un découplage des deux portes de connexion de réseau (4a, 4b) et une adaptation d'admittance ($S_{4a4a} = 0$, $S_{4b4b} = 0$) des deux portes de connexion de réseau (4a, 4b) à une admittance normalisée Y0 sont réalisés du fait qu'aussi bien l'angle électrique $\alpha p = 2\pi * l / \lambda p$ de la ligne symétrique (13) que l'angle électrique $\alpha n = 2\pi * l / \lambda n$ de la ligne antisymétrique (14) sont chacun $\alpha p = \alpha n = 90°$ et que la conductance d'onde de la ligne symétrique (13) est choisie comme

$$YLp = \sqrt{GAp * Y0}$$

et que la conductance de la ligne antisymétrique (14) est choisie comme

$$YLn = \sqrt{GAn * Y0}$$

, où Âp et An décrivent les longueurs d'onde des ondes symétriques et antisymétriques et sont réglés à la même valeur.

2. Système d'antennes (1) selon la revendication 1,
   **caractérisé en ce que**
   le système d'antennes (1), pour concevoir la coopération avec la ligne électrique couplée, permet de détecter

   • l'admittance YAp = GAp + jBAp à l'une des portes de connexion d'antenne (2a, 2b), qui s'établit lorsque celle-ci est excitée par un signal de mesure et que l'autre porte de connexion d'antenne (2a, 2b) est excitée simultanément par le même signal de mesure polarisé dans le même sens, et
   - l'admittance YAn = GAn + jBAn à l'une des portes de connexion d'antenne, qui s'établit lorsque celle-ci est excitée par un signal de mesure et que l'autre porte de connexion d'antenne (2a, 2b) est excitée simultanément par le même signal de mesure, cependant polarisé dans le sens opposé.

3. Système d'antennes (1) selon la revendication 1 ou 2,
   **caractérisé en ce que**

   pour concevoir la coopération dans le système d'antennes (1), celui-ci permet de détecter et de régler les propriétés électriques de la ligne électrique couplée (15) de longueur géométrique I (10), qui, à l'une de ses extrémités, est détachée des portes de connexion d'antenne (2a, 2b), à l'aide des valeurs de susceptance suivantes, présentes à l'autre extrémité de la ligne électrique couplée (15), c'est-à-dire aux portes de connexion de réseau (4a, 4b),
   d'une part, en cas de court-circuit des deux conducteurs avec la masse (6) à l'une des extrémités,
   lesdites valeurs de susceptance étant donc

   • la valeur de susceptance Bkp à l'une des portes de connexion de réseau (4a, 4b) lorsque celle-ci est excitée par un signal de mesure et que l'autre porte de connexion de réseau (4a, 4b) est excitée simultanément par le même signal de mesure polarisé dans le même sens,
   • la valeur de susceptance Bkn à l'une des portes de connexion de réseau (4a, 4b) lorsque celle-ci est excitée par un signal de mesure et que l'autre porte de connexion de réseau (4a, 4b) est excitée simultanément par le même signal de mesure, cependant polarisé dans le sens opposé,

   et d'autre part à l'aide des valeurs de susceptance suivantes, qui sont détectées et réglées à une extrémité de la ligne électrique couplée (15) lorsque les deux conducteurs sont en circuit ouvert,
   lesdites valeurs de susceptance étant donc

   • la valeur de susceptance Blp à l'une des portes de connexion de réseau (4a, 4b) avec le même signal de mesure polarisé dans le même sens,
   • la valeur de susceptance Bln à l'une des portes de connexion de réseau (4a, 4b) lorsque celle-ci est excitée par un signal de mesure et que l'autre porte de connexion de réseau (4a, 4b) est excitée simultanément par le même signal de mesure, cependant polarisé dans le sens opposé,

   et à partir de là, l'admittance d'onde réelle YLp de la ligne électrique (13) excitée dans le même sens et son angle électrique $\alpha p$ ainsi que l'admittance d'onde réelle YLn de la ligne électrique (14) excitée dans le sens opposé et son angle électrique $\alpha p$ et $\alpha n$ sont déterminés et réglés séparément à l'aide des relations suivantes

$$YLp = \sqrt{-Bkp * Blp} \qquad \text{et} \qquad YLn = \sqrt{-Bkn * Bln}$$

$$\alpha p = arc\ tan\ (\sqrt{-Blp\ /\ Bkp})\ ;\ \ \alpha n = arc\ tan\ (\sqrt{-Bln\ /\ Bkn})$$

4. Système d'antennes (1) selon la revendication 1, 2 ou 3,
   **caractérisé en ce que**
   aux deux portes de connexion de réseau (4a, 4b), à ladite au moins une fréquence f1, il existe une adaptation d'impédance à la résistance réelle Z0 = 1/YO, normalisée dans la technique, par le fait que la structure et la longueur l (10) de la ligne électrique couplée (15) sont conçues de telle sorte qu'aussi bien l'admittance d'onde yLp = YLp/Y0, rapportée à Y0, de la ligne électrique symétrique (13) et son angle électrique $\alpha p$ que l'admittance d'onde correspondante yLn = YLn/Y0, rapportée à Y0, de la ligne électrique antisymétrique (14) et son angle électrique $\alpha n$ sont formés selon les relations suivantes qui sont prédéfinies par les admittances YAp/YO et YAn/YO, rapportées à Y0, du système d'antennes (1) aux portes de connexion d'antenne (2a, 2b), où :

$$yAp = \frac{YAp}{Y0} = gAp + j * bAp\ ;\ \ \ \ et\ \ \ \ \ yAn = \frac{YAn}{Y0} = gAn + j * bAn\ ;$$

$$YLp\ /\ Y0 = yLp = \sqrt{\frac{|yAp|^2 - gAp}{gAp - 1}}\ ;\ \ \ \alpha p = arc\ tan\ (\frac{1 - gAp}{bAp} \bullet yLp)$$

$$YLn\ /\ Y0 = yLn = \sqrt{\frac{|yAn|^2 - gAn}{gAn - 1}}\ ;\ \ \ \alpha n = arc\ tan\ (\frac{1 - gAn}{bAn} \bullet yLn)$$

avec : $j^2 = -1$.

5. Système d'antennes (1) selon l'une des revendications 1 à 3,
   **caractérisé en ce que**
   à ladite au moins une fréquence f1, à l'une des deux portes de connexion de réseau (4a, 4b) respectives, aussi bien pour une excitation dans le même sens que pour une excitation en sens opposé sur l'autre porte de connexion de réseau (4a, 4b), la même admittance prédéfinie, rapportée à Y0

$$\frac{YNp}{Y0} = \frac{YNn}{Y0} = \frac{YN}{Y0} = yN = gN + j \bullet bN$$

est donnée du fait que, pour la ligne symétrique (13), l'admittance d'onde $\frac{YLp}{Y0}$, rapportée à Y0, est choisie en correspondance comme

$$YLp\ /\ Y0 = yLp = \sqrt{\frac{gN \bullet |yAp|^2 - gAp \bullet |yN|^2}{gAp - gN}}$$

et l'angle électrique en degrés est choisi en correspondance comme

$$\alpha p = 180\ /\ \pi \bullet arc\ tan\ (\frac{gN - gAp}{gN \bullet bAp + bN \bullet gAp} \bullet yLp)$$

ainsi que, pour la ligne antisymétrique (14), l'admittance d'onde YLn, rapportée à Y0, est choisie en correspondance comme

$$YLn\ /\ Y0 = yLn = \sqrt{\frac{gN \bullet |yAn|^2 - gAn \bullet |yN|^2}{gAn - gN}}$$

et l'angle électrique est choisi en correspondance comme

$$\alpha n = 180 / \pi \bullet \arctan \left( \frac{gN - gAn}{gN \bullet bAn + bN \bullet gAn} \bullet yLn \right)$$

ce qui permet d'obtenir le découplage des deux portes de connexion de réseau (4a, 4b) à l'extrémité de la ligne couplée (15).

**6.** Système d'antennes (1) selon la revendication 5,
**caractérisé en ce que**
pour obtenir l'adaptation d'impédance des portes de connexion de réseau (4a, 4b) à l'admittance normalisée Y0, à ladite au moins une fréquence f1, un réseau d'adaptation de sortie (25) respectif identique est inséré entre chacune des deux extrémités, découplées l'une de l'autre, de la ligne électrique couplée, à savoir entre les portes de connexion de ligne (4a', 4b') et la porte de connexion de réseau de découplage (4a, 4b) correspondante, ledit réseau d'adaptation de sortie étant destiné à transformer en l'admittance normalisée Y0 l'admittance qui se présente respectivement aux portes de connexion de ligne (4a', 4b') de la ligne électrique couplée (15).

**7.** Système d'antennes (1) selon la revendication 5 ou 6,
**caractérisé en ce que**
un réseau d'adaptation d'antenne (24a, 24b) respectif identique est connecté entre chacune des deux portes de connexion d'antenne (2a, 2b) et le raccord au conducteur correspondant (8a, 8b) de la ligne électrique couplée (15), réseau par lequel les admittances d'antenne YAp et YAb respectivement présentes aux deux portes de connexion (2a, 2b), à ladite au moins une fréquence f1, sont transformées respectivement en une admittance réelle GAp et GAn, et la ligne électrique couplée (15) est conçue de telle sorte que l'admittance d'onde de la ligne électrique symétrique (13) est $YLp = \sqrt{GAp \bullet Y0}$ et que son angle électrique est $\alpha p = \frac{l}{\lambda p} * 360 = 90°$ et que l'admittance d'onde de la ligne électrique antisymétrique (14) est $YLn = \sqrt{GAn \bullet Y0}$ et que son angle électrique est $\alpha n = \frac{l}{\lambda n} * 360 = 90°$ .

**8.** Système d'antennes (1) selon la revendication 7,
**caractérisé en ce que**
pour obtenir les admittances réelles GAp et GAn, chaque réseau d'adaptation d'antenne (24a, 24b) est formé d'un dipôle parallèle monté en parallèle avec la porte de connexion d'antenne (2a, 2b), ayant une susceptance Bp et formé d'au moins un élément réactif, et d'un dipôle série monté en série, ayant une réactance Xs et formé d'au moins un élément réactif, où Bp/YO et Xs/Z0 possèdent respectivement les valeurs optionnelles suivantes, à ladite au moins une fréquence f1, afin de satisfaire à l'exigence YAp = GAp et YAn = GAn

$$bp = Bp/Y0 = \frac{|zAn|^2 - |zAp|^2}{2 * (xAp * |zAn|^2 - xAn * |zAp|^2)}$$
$$* \left[ 1 \pm \sqrt{1 - \frac{4 \cdot (xAp * |zAn|^2 - xAn * |zAp|^2) * (xAn - xAp)}{(|zAp|^2 - |zAn|^2)^2}} \right]$$

et

$$xs = Xs/Z0 = \frac{|zAn|^2 - |zAp|^2}{2 * (xAp * |zAn|^2 - xAn * |zAp|^2)}$$

où

$$zAp = rAp + j \bullet xAp = \frac{ZAp}{Z0} = \frac{Y0}{YAp} \quad \text{et} \quad zAn = rAn + j \bullet xAn = \frac{ZAn}{Z0} = \frac{Y0}{YAn}$$

**9.** Système d'antennes (1) selon la revendication 8,
**caractérisé en ce que**
dans chaque réseau d'adaptation d'antenne (24a, 24b), dans la première des combinaisons optionnelles, le dipôle parallèle à susceptance Bp est réalisé comme un composant capacitif à capacité Cp, et le dipôle série à réactance Xs est réalisé comme un composant inductif à inductance Ls, ou, dans la deuxième des combinaisons optionnelles, le dipôle parallèle à susceptance Bp est réalisé comme un composant inductif à inductance Lp, et le dipôle série à réactance Xs est réalisé comme un composant capacitif à capacité Cs et à inductance Ls.

**10.** Système d'antennes (1) selon l'une des revendications 8 ou 9,
**caractérisé en ce que**
pour étendre la plage de fréquences autour de ladite au moins une fréquence f1 comme fréquence centrale, aussi bien une amélioration du découplage entre les portes de connexion de réseau (4a, 4b) qu'une adaptation d'impédance améliorée à la résistance normalisée Z0 sont obtenues par réalisation du dipôle parallèle comme un circuit résonant parallèle et par réalisation du dipôle série comme un circuit résonant série dans les réseaux d'adaptation d'antenne (24a, 24b).

**11.** Système d'antennes (1) selon la revendication 10,
**caractérisé en ce que**
le réseau d'adaptation d'antenne (24a, 24b) est conçu de telle sorte que l'évolution, dépendante de la fréquence, de l'impédance d'antenne transformée ZAp = 1/YAp ou ZAn = 1/YAn dans le plan d'impédance complexe avec une fréquence croissante entoure au moins partiellement la valeur de résistance réelle RAp =1/GAp ou RAn =1/GAn respectivement avec un petit écart, et que la valeur de résistance RAp ou RAn est améliorée par la transformation avec la ligne électrique couplée (15) en la résistance de référence Z0 aux portes de connexion de réseau (4a, 4b), ce qui améliore tant le découplage que l'adaptation d'impédance sur une plus grande plage de fréquences autour de la fréquence f1.

**12.** Système d'antennes (1) selon la revendication 11,
**caractérisé en ce que**
pour augmenter la plage de fréquences autour de ladite au moins une fréquence f1 avec un découplage amélioré entre les portes de connexion de réseau (4a, 4b), en partant d'une réalisation des réseaux de connexion d'antenne (24a, 24b) identiques l'un à l'autre, après un dimensionnement des deux dipôles formés d'éléments réactifs selon la revendication 8, ceux-ci sont complétés respectivement pour donner un circuit résonant parallèle (7a) monté en parallèle et un circuit résonant série (7b) monté en série.

**13.** Système d'antennes (1) selon la revendication 12,
**caractérisé en ce que**
pour augmenter la plage de fréquences autour de ladite au moins une fréquence f1 avec un découplage amélioré et une adaptation d'impédance améliorée dans une plage de fréquences autour de la fréquence f1 aux portes de connexion de réseau (4a, 4b), le réseau d'adaptation de sortie (25a, 25b) respectif comprend au moins un circuit résonant parallèle (7a) et un circuit résonant série (7b) qui sont conçus de telle sorte qu'aussi bien l'impédance ZNp que l'impédance ZNn aux portes de connexion de réseau (4a, 4b) entourent l'impédance normalisée Z0 à une faible distance dans leur évolution dans le plan d'impédance complexe avec une fréquence croissante.

**14.** Système d'antennes (1) selon l'une des revendications précédentes 1 à 13,
**caractérisé en ce que**
les propriétés électriques de la ligne électrique couplée (15) sont réglées individuellement par la configuration des capacités, réparties sur la longueur de conducteur l (10), Cm' = ΔCm/Δl des différents conducteurs électriques (8a, 8b) par rapport à la masse et Cb' = ΔCb/Δl des différents conducteurs les uns par rapport aux autres, ainsi que des inductances réparties Lp' = ΔLp/Δl pour un flux de courant dans le même sens dans les deux conducteurs et des inductances réparties Ln' = ΔLn/Δl pour un flux de courant dans le sens opposé dans les deux conducteurs, de manière à obtenir les valeurs requises pour la conductance d'onde $YLp = \frac{1}{ZLp} = \sqrt{Cm'/Lp'}$ et pour l'angle

$$\frac{dap}{dl} = \beta p = 2\pi * f1 * \sqrt{Lp' * Cm'}$$

électrique, par unité de longueur, de la ligne électrique symétrique (13),

$$YLn = \frac{1}{ZLn} = \sqrt{(Cm' + 2 * Cb'/Ln')}$$

et les valeurs requises pour l'impédance caractéristique et pour l'angle

$$\frac{dan}{dl} = \beta n = 2\pi * f1 * \sqrt{(Cm' + 2 * Cb') * Ln'}$$

électrique, par unité de longueur, de la ligne électrique antisymétrique (14).

**15.** Système d'antennes (1) selon la revendication 14,
**caractérisé en ce que**
la ligne électrique couplée (15) est réalisée sous forme de ligne à micro-rubans ayant des rubans conducteurs (17) sur un substrat permittif (27), et la largeur de conducteur (26) est choisie en correspondance en tenant compte de la permittivité relative du substrat (27) en vue d'obtenir la capacité linéique Cm' souhaitée et l'inductance linéique Lp' pour configurer l'admittance d'onde YLp et la constante de phase βp, et la distance (11) des conducteurs pour configurer la capacité linéique Cb' et - sous l'effet de l'affectation de l'inductance de couplage M' - l'inductance linéique Ln' sont choisies de manière à établir l'admittance d'onde requise YLn et la constante de phase βn.

**16.** Système d'antennes (1) selon l'une des revendications précédentes 1 à 15,
**caractérisé en ce que**
chacune des antennes (1a, 1b) identiques est formée comme une antenne monopôle (1a, 1b) reliée à la masse (6) par l'un de ses points de connexion de base (2a', 2b'), laquelle est reliée à la porte de connexion d'antenne (2a, 2b) correspondante par l'intermédiaire d'un court tronçon de ligne électrique 35 respectif identique, asymétrique par rapport à la masse, pour ponter la distance d entre les antennes.

**17.** Système d'antennes (1) selon l'une des revendications précédentes 1 à 16,
**caractérisé en ce que**
chacune des antennes (1a, 1b) identiques est formée comme une antenne dipôle (1a', 1b') symétrique par rapport à la masse (6), dont la porte de connexion (2a', 2b') symétrique par rapport à la masse est reliée à la porte de connexion d'antenne (2a, 2b) associée respective par l'intermédiaire d'un dispositif de re-symétrisation (34) identique ayant une courte ligne d'entrée symétrique par rapport à la masse et une courte ligne de sortie asymétrique par rapport à la masse pour ponter la distance d entre les antennes et pour resymétriser la porte de connexion de dipôle (2a', 2b') symétrique par rapport à la masse vers la porte de connexion d'antenne (2a, 2b) asymétrique par rapport à la masse.

**18.** Système d'antennes (1) selon l'une des revendications précédentes 1 à 17,
**caractérisé en ce que**
les deux conducteurs linéaires (8a, 8b) du réseau (3), couplés électroma-gnétiquement, ayant leurs tronçons de ligne infinitésimaux successifs de longueur dl, constitués des éléments réactifs infinitésimaux dLp = dLn, dCm, dCb de la ligne couplée symétrique (15) sont remplacés par des étages de circuit S1, S2, ... successifs, correspondant aux tronçons de ligne, mais constitués d'éléments réactifs discrets, en nombre fini, dans lesquels les éléments réactifs infinitésimaux dLp, dLn, dCm et dCb sont remplacés par des composants discrets, correspondant à ces éléments et ayant l'inductance ΔLp = ΔLs (36), la capacité en pont ΔCb (38) et la capacité de masse ΔCm (37), et les valeurs des composants discrets sont choisies de manière à ce que le découplage des portes de connexion de réseau (4a, 4b) soit établi à une fréquence f1 suffisamment inférieure à la fréquence limite ftn.

**19.** Système d'antennes (1) selon la revendication 18,
**caractérisé en ce que**
les éléments réactifs discrets (36, 37, 38) sont remplacés chacun par un circuit d'éléments réactifs discret bipolaire (43, 44, 45) de telle sorte que, à la fréquence de découplage f1, on a respectivement :

le circuit d'éléments réactifs (43), utilisé en série à la place de l'inductance ΔLp, ΔLs (36), est inductif et possède la même valeur de réactance que l'inductance ΔLp, ΔLs (36) ;
le circuit d'éléments réactifs en pont (45), utilisé à la place de la capacité en pont ΔCb (38), est capacitif et possède la même valeur de réactance que la capacité en pont ΔCb (38) ;
le circuit d'éléments réactifs de masse (44), utilisé à la place de la capacité de masse ΔCm (37), est capacitif et possède la même valeur de réactance que la capacité de masse ΔCm (37).

**20.** Système d'antennes (1) selon l'une des revendications précédentes 18 ou 19,
**caractérisé en ce que**
au moins deux étages S1, S2.. sont formés dans le réseau (3), dont le premier étage S1, par coopération du circuit inductif d'éléments réactifs en série (43) avec le circuit d'éléments réactifs en pont bipolaire (45), assure le découplage à la porte de connexion de réseau (4a, 4b) pour la fréquence f1 également par le fait que dans le circuit d'éléments réactifs en série (43') du deuxième étage S2, il existe un circuit résonant série (46) en série perméable à cette fréquence f1, et dans le circuit d'éléments réactifs en pont (45'), il existe un circuit résonant parallèle (47) en série bloquant cette fréquence f1, et que le découplage à la porte de connexion de réseau (4a, 4b) est assuré pour une autre fréquence f2 par l'accord du circuit d'éléments réactifs en série (43') et du circuit d'éléments réactifs en pont (45').

**21.** Système d'antennes (1) selon la revendication 18, 19 ou 20,
**caractérisé en ce que**
le réseau (3) conçu comme une structure passe-bas est cependant réalisé de manière duale comme une structure passe-haut, ce pourquoi l'inductance $\Delta Lp = \Delta Ls$ (36) est remplacée par la capacité série $\Delta Cs$ (42), la capacité en pont $\Delta Cb$ (38) est remplacée par l'inductance en pont $\Delta Lm$ (41), et la capacité de masse $\Delta Cm$ (37) est remplacée par l'inductance de masse $\Delta Lm$ (40), et les grandeurs de la capacité série $\Delta Cs$ (42), de la capacité de masse $\Delta Cm$ (37) et de l'inductance de masse $\Delta Lm$ (40) sont choisies selon les éléments de structure passe-haut obtenus par transformation duale des éléments de structure passe-bas selon l'application des règles de formation de dualité, et les valeurs des composants discrets sont choisies de manière à ce que le découplage des portes de connexion de réseau (4a, 4b) soit établi à une fréquence f1 suffisamment supérieure à la fréquence limite fhp.

ZA=RA+j*XA          ZA=RA+j*XA

2a →          ← 2b

Z12=R12A+j*X12A

a)

b)

Fig. 1

EP 4 092 914 B1

Gegenseitige Impedanz Z12 = R12 + jX12

Ohm

Relativer Antennenabstand d/Lambda

Fig. 1

Real-und Imaginärteil d. Koppelimpedanz in Ohm

Übertragungsfaktor S2a2b u. Reflexionsfaktor S2a2a, S2b2b in dB

R12A

X12A

$S_{2a2b}$

S2a2a,S2b2b

Frequenz in MHz

Frequenz in MHz

a)

b)

Fig. 2

Fig. 3

Fig. 4

Fig. 5

EP 4 092 914 B1

Fig. 6

Fig. 7

a)

Verkopplung S2a2b der Antennen-Anschlusstore und S4a4b der Entkoppelnetzwerk- Anschlusstore in dB

S2a2b

S4a4b

Frequenz in MHz

a)

Reflexionsfaktoren an den Toren 2a,2b und 4a,4b in dB

S4a4a, S4b4b

S4a4a
S4b4b

Frequenz in MHz

b)

Fig. 8

EP 4 092 914 B1

Fig. 9

a)

b)

Fig. 10

EP 4 092 914 B1

Fig. 11

Fig. 12

Reflexionsfaktorebene

ZAn

f

ZAp

Lp, Cs; 24a,24b

RAp

Zp

$l/\lambda p = 1/4$

Z0

Zn

Lp, Cs; 24a,24b

$l/\lambda n = 1/4$

RAn

Imaginärteil

Realteil

Verkopplung S2a2b der Antennen-Anschlusstore und
S4a4b der Entkoppelnetzwerk- Anschlusstore in dB

S2a2b

S4a4b

Frequenz in MHz

a)

Verkopplung S2a2b der Antennen-Anschlusstore und
S4a4b der Entkoppelnetzwerk- Anschlusstore in dB

S2a2b

S4a4b

Frequenz in MHz

b)

Fig. 13

EP 4 092 914 B1

Reflexionsfaktoren an den Toren 2a,2b,4a,4b in dB

S2a2a
S2b2b

S4a4a
S4b4b

Frequenz in MHz

Reflexionsfaktoren an den Toren 2a,2b,4a,4b in dB

S2a2a
S2b2b

S4a4a
S4b4b

Frequenz in MHz

Anspruch 8

Fig. 14

Fig. 15

b)

25a
7b
7a
4a, Y0 = 1/Z0
αp, αn, ZLp,ZLn
4b, Y0 = 1/Z0
25a
7b
7a

a)

7a
7b
24a
4a, Y0 = 1/Z0
αp, αn, ZLp,ZLn
7a
7b
24b
4a, Y0 = 1/Z0

Fig. 16

Fig. 17a

Fig. 17b

a)

b)

c)

d)

e)

Fig. 18

EP 4 092 914 B1

a)

b)

Fig. 19

Fig. 20

Fig. 21

EP 4 092 914 B1

Fig. 22

Verkopplung der Netzwerk-Anschlusstore 4a, 4b bei Tiefentkopplung für 2 Frequenzen

Fig. 23

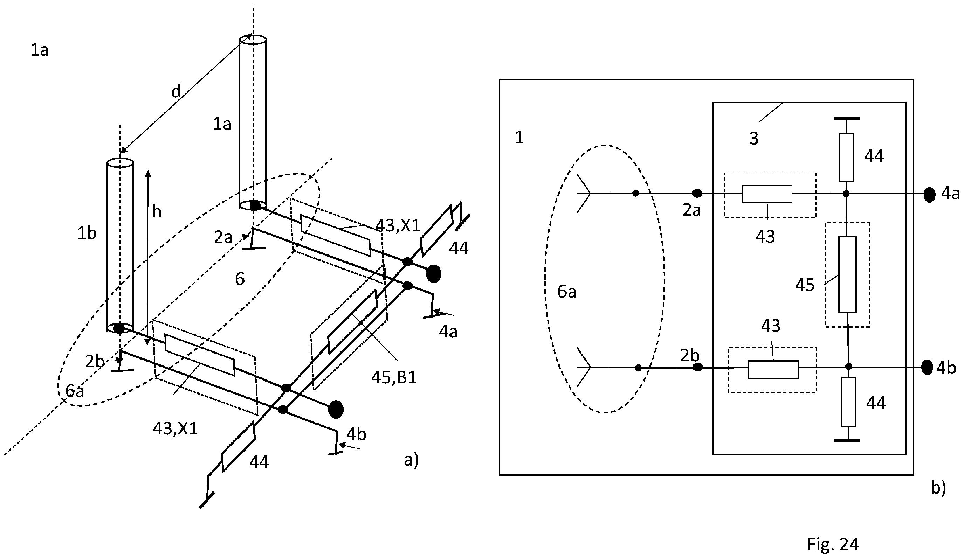

Fig. 24

EP 4 092 914 B1

Fig. 25

EP 4 092 914 B1

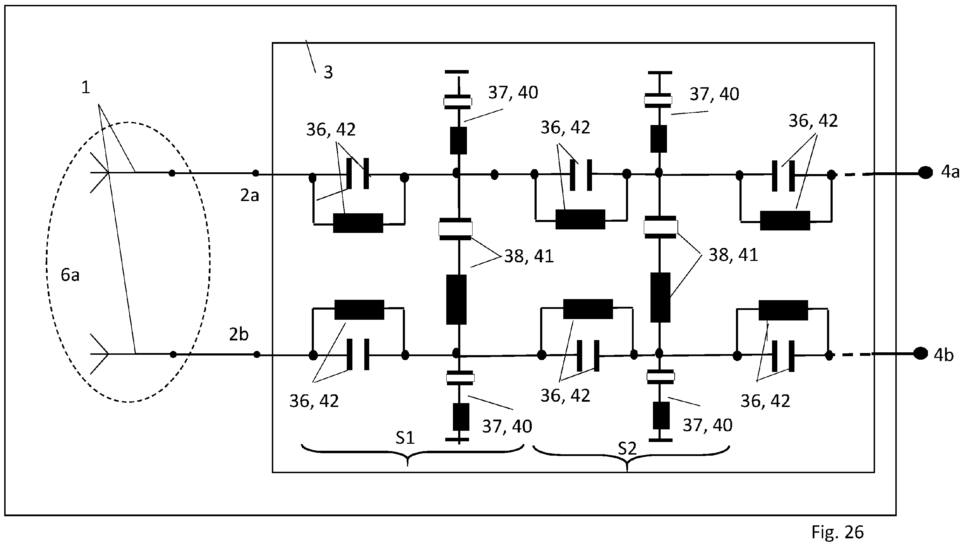

Fig. 26

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3734755 A1
- US 2009219213 A1
- US 2020343918 A1

**In der Beschreibung aufgeführte Nicht-Patentliteratur**

- A Simple Circuit for Decoupling of Two Dual-Frequency Antennas with Small Frequency Ratio. **OBORZHYTSKYY VALERIY et al.** 2019 IEEE 15TH INTERNATIONAL CONFERENCE ON THE EXPERIENCE OF DESIGNING AND APPLICATION OF CAD SYSTEMS (CADSM). IEEE, 26. Februar 2019, 45-48